# EUROPEAN PATENT APPLICATION

(11) **EP 4 790 603 A1**
(43) Date of publication of application: **12.08.2026**
(21) Application number: 23958357.8
(22) Date of filing: 30.11.2023
(51) Int. Cl.: G06N 20/00

(54) **CONTROL SYSTEM AND CONTROL METHOD**

(30) Priority: 09.11.2023 JP 2023191481
(71) Applicant: Mitsubishi Electric Corporation, Tokyo 100-8310 (JP)
(72) Inventor: MAEKAWA, Kiyoshi, Tokyo 100-8310 (JP); OTOMURA, Kotaro, Tokyo 100-8310 (JP); SUGAMA, Yasushi, Tokyo 100-8310 (JP); MIWA, Shotaro, Tokyo 100-8310 (JP); NAMMOTO, Takashi, Tokyo 100-8310 (JP)
(74) Representative: Pfenning, Meinig & Partner mbB
(86) International application number: PCT/JP2023/042906
(87) International publication number: WO 2025/099958

(57) **Abstract**

A control system (2000a) according to the present disclosure is a control system (2000a) for supporting work using a device, and includes a learning model unit (200) that outputs second information that is information for operating a target device (2) based on output data obtained by inputting input data based on first information indicating a demand regarding an operation of the target device (2) to a learned learning model.

## Description

### Field

The present disclosure relates to a control system and a control method.

### Background

In recent years, the use of artificial intelligence (AI) has been advanced. In particular, AI capable of generating various contents, which is called generative artificial intelligence (AI), is also beginning to spread, and it is expected that AI will be widely used. As a utilization destination of AI, not only home work but also work in various facilities such as buildings, factories, stations, schools, hospitals, and commercial facilities, and work in various places and scenes such as outdoors such as roads, outdoor facilities, the sky, or on the sea are considered.

For example, Patent Literature 1 describes a machining program generation device that generates a program for controlling a machine using a large-scale language model.

### Citation List

### Patent Literature

Patent Literature 1: Japanese Patent Application Laid-open No. 2021-060806

### Summary

### Technical Problem

In order to support work by a person or an object, it is considered that the learning model is responsible for some or all of the tasks included in the work, not only the generation of the control program of the device. Note that the "work by a person or an object" includes not only work on a real space performed by a person or a machine but also work on a data space such as information processing performed by a processor such as a central processing unit (CPU).

Examples of work with objects include, for example, the following.
·Work by various devices such as robots, machines, devices, and sensors
·Work using various types of mobility such as cars, trains, buses, flight vehicles, and ships

The work may include, for example, operations referred to as control, processing, machining, instructions, calculation, input, output, display, communication, testing, manufacturing, conversion, generation, measurement, irradiation, release, inhalation, heat dissipation, heating, cooling, recording, readout, shaping, driving, movement, transportation, flight, investigation, monitoring, measurement, extraction, and the like.

Examples of work by a person include the following.
·Work to be performed by a person against a person or another living thing
·Work performed by a person on various devices

The work may include, for example, work called conversation, viewing, confirmation, operation, monitoring, instruction, arbitration, interpretation, and the like.

Note that the above-described example is an example, and the work that is the support target of the present disclosure is not limited thereto.

In a case where some or all of the tasks included in the work by the person or the object are executed by the information processing device using any learning model, the validity of the output of the model may become a problem. In addition, validity of the input of the model that affects the output of the model may become a problem.

In addition, depending on the target device, there is a case where appropriate control cannot be performed unless the current situation is grasped. In such a case, how to perform situation recognition may be a problem. At this time, it may be necessary to recognize not only the current situation but also the situation with continuity including the past situation. For example, in a case where the next control is determined on the basis of the content of the control performed in the past, or the like, there is a case where accuracy of situation recognition becomes a problem in order to ensure continuity of control.

In addition, in a case where immediacy is required for control of the device, or the like, there is a case where a response time from giving an instruction to the learning model to obtaining a result becomes a problem.

In addition, the maintainability of the model may become a problem, for example, the model needs to be relearned each time the device is changed or added.

As described above, various problems are still scattered in the use of the learning model. Depending on the magnitude of the problem, even if it is attempted to improve the efficiency or performance of the work using the learning model, the efficiency or performance of the work may be degraded conversely.

These problems when using the learning model will become more conspicuous particularly as the work to be supported is more complicated and as the work to be supported is more advanced.

Therefore, an object of the present disclosure is to further improve efficiency or performance of work by a person or an object using a learning model.

### Solution to Problem

A control system according to the present disclosure is a control system for supporting work using a device, and includes a learning model unit to output second information that is information for operating the device, based on output data obtained by inputting input data based on first information indicating a demand regarding operation of the device to a learned learning model.

A control method according to the present disclosure is a control method for supporting work using a device, and includes, by a learning model unit, outputting second information that is information for operating the device based on output data obtained by inputting input data based on first information indicating a demand regarding operation of the device to a learned learning model.

### Advantageous Effects of Invention

According to the present disclosure, it is possible to further improve efficiency or performance of work by a person or an object using a learning model.

### Brief Description of Drawings

FIG. 1 is a configuration diagram illustrating an example of a control system according to the first embodiment.
FIG. 2 is an explanatory diagram illustrating an exemplary configuration of the learning model unit.
FIG. 3 is an explanatory diagram illustrating another exemplary configuration of the learning model unit.
FIG. 4 is an explanatory diagram illustrating another exemplary configuration of the learning model unit.
FIG. 5 is a configuration diagram illustrating another example of the information processing device as an operation environment of the control unit including the learning model unit.
FIG. 6 is an explanatory diagram illustrating an example of model learning in a model generation unit.
FIG. 7 is a flowchart illustrating an operation example of the control system according to the first embodiment.
FIG. 8 is a configuration diagram illustrating another example of a control system according to the first embodiment.
FIG. 9 is a diagram illustrating another exemplary configuration of the control system according to the first embodiment.
FIG. 10 is a configuration diagram illustrating another example of a control system according to the first embodiment.
FIG. 11 is a configuration diagram illustrating an example of a control system according to the second embodiment.
FIG. 12 is a configuration diagram illustrating another example of a control system according to the second embodiment.
FIG. 13 is a flowchart illustrating an operation example of the control system according to the second embodiment.
FIG. 14 is a configuration diagram illustrating an example of a control system according to the third embodiment.
FIG. 15 is a flowchart illustrating an operation example of the control system according to the third embodiment.
FIG. 16 is a configuration diagram illustrating another example of a control system according to the third embodiment.
FIG. 17 is a flowchart illustrating an operation example of a modification according to the third embodiment.
FIG. 18 is a configuration diagram illustrating another example of a control system according to the third embodiment.
FIG. 19 is a configuration diagram illustrating another example of a control system according to the third embodiment.
FIG. 20 is a configuration diagram illustrating another example of a control system according to the third embodiment.
FIG. 21 is a diagram illustrating another exemplary configuration of the control system according to the third embodiment.
FIG. 22 is a flowchart illustrating an operation example of a modification according to the third embodiment.
FIG. 23 is a configuration diagram illustrating an example of a control system according to the fourth embodiment.
FIG. 24 is a flowchart illustrating an operation example of the control system according to the fourth embodiment.
FIG. 25 is a diagram illustrating another exemplary configuration of the control system according to the fourth embodiment.
FIG. 26 is a flowchart illustrating an operation example of a modification according to the fourth embodiment.
FIG. 27 is a configuration diagram illustrating an example of a control system according to the fifth embodiment.
FIG. 28 is a flowchart illustrating an operation example of the control system according to the fifth embodiment.
FIG. 29 is a diagram illustrating another exemplary configuration of the control system according to the fifth embodiment.
FIG. 30 is a diagram illustrating another exemplary configuration of the control system according to the fifth embodiment.
FIG. 31 is a diagram illustrating another exemplary configuration of the control system according to the fifth embodiment.
FIG. 32 is a diagram illustrating another exemplary configuration of the control system according to the fifth embodiment.
FIG. 33 is a configuration diagram illustrating an example of a control system according to the sixth embodiment.
FIG. 34 is a configuration diagram illustrating an example of a control system according to the sixth embodiment having a function of generating a model.
FIG. 35 is a configuration diagram illustrating an example of the control system according to the sixth embodiment in a case where the device information is input at the time of learning.
FIG. 36 is a configuration diagram illustrating an example of a control system according to the sixth embodiment in a case where relearning is performed.
FIG. 37 is a configuration diagram illustrating an example of a control system according to the sixth embodiment including the learning device.
FIG. 38 is a flowchart illustrating an operation example of the control system according to the sixth embodiment.
FIG. 39 is a diagram illustrating an exemplary configuration of a computer system that implements the control system according to the sixth embodiment.
FIG. 40 is a diagram illustrating an outline of an autoencoder according to the sixth embodiment.

### Description of Embodiments

Hereinafter, in order to describe the present disclosure in more detail, embodiments for carrying out the present disclosure will be described with reference to the accompanying drawings. Hereinafter, identical elements are denoted by the same reference number, and the description thereof will be omitted.

### First Embodiment.

In the present embodiment, an example of supporting work related to code generation of a target device using a learning model will be described.

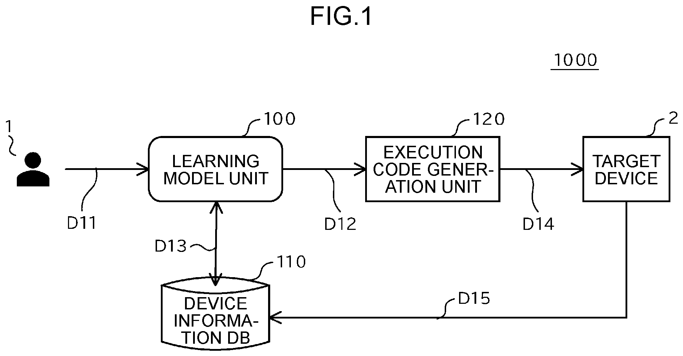

FIG. 1 is a configuration diagram illustrating an example of a control system 1000 according to the first embodiment. The control system 1000 illustrated in FIG. 1 is a control system for controlling a device using a learning model, and includes a learning model unit 100, a device information storage unit 110 (referred to as a device information DB in the drawing), and an execution code generation unit 120.

Note that, although a user 1 and a target device 2 are illustrated in FIG. 1, the control system 1000 may include the user 1 and the target device 2. In this case, the "user 1" may be replaced with the "user terminal 1". The same applies to other embodiments.

In response to input of input information D11, the learning model unit 100 outputs a control description D12. In response to input of the input information D11, the learning model unit 100 outputs the control description D12 on the basis of model information D102 to be described later.

In the present embodiment, the learning model unit 100 is a model and an operation environment thereof configured to output the control description D12 corresponding to the input information D11 in response to input of the input information D11. In addition, the learning model unit 100 may be a model and an operation environment thereof configured to, in response to input of the input information D11, generate and output the control description D12 on the basis of the input information D11, device information D13, and/or other information (model reference information D104 and the like to be described later) that can be referred to in the learning model unit 100.

In the present embodiment, the input information D11 includes information indicating control contents requested to the target device 2. The input information D11 may be, for example, a text, an image, sound, or a combination thereof indicating a control content for the target device 2. The input information D11 may be, for example, a text, an image, sound, or a combination thereof indicating a plurality of control contents for the target device 2. In addition, the input information D11 may include information indicating the control content performed continuously in time, and in that case, may be time-series data having a predetermined data structure including a text, an image, sound, or a combination thereof indicating the control content as described above. It is assumed that the control content is indicated on the assumption that the control content matches the input format of the model used by the learning model unit 100, but this is not the case when error processing, correction processing, or conversion processing is included in the preceding stage of the learning model unit 100.

Examples of how to indicate the control content in the input information D11 include a method of specifying the control to be performed on the target device 2 and then specifying the value of the parameter for performing the control or the state after the control. In that case, the input information D11 may include, for example, information specifying control and information indicating a value of a parameter for performing the control or a state after the control. The value of the parameter for performing control may include, for example, a value related to a type of control (ON/OFF or the like), an orientation, an amount, and time. Examples of the control content include "turning on function X" for the PLC (programmable logic controller, also referred to as sequencer)," moving the distal end to point A" for the robot arm, and "lowering the set temperature by one degree" for the air conditioner. In addition, examples of how to indicate the control content in the input information D11 include a method of using a document character string (docstring) describing a specification such as a function, a specification, or various types of information such as a specification, a design, an operation command, a control code, and a source code applied to other devices such as other models.

Note that, as a way of indicating the control contents in the input information D11, not only the method of explicitly indicating the control contents as described above but also, for example, a method of indicating the corresponding control contents by indicating the operation contents in a case where there is control performed by a certain operation. In addition, for example, there is also a method of implicitly indicating a behavior of the user 1 associated with specific control, an operation result of the target device 2, a similar control command to another model, or the like. In other words, the input information D11 can include not only information directly indicating the control content for the target device 2 but also information indirectly indicating the control content using the operation content corresponding to the control content, the speech and behavior of the user 1, the image of the target device 2, or the like. As an example, words such as "hot" from the user 1, or motions of the user 1 indicating it is hot, such as wiping sweat, rolling up sleeves, or fanning with a hand, can be used as the control contents related to the temperature control of the air conditioner. In this case, as the input information D11, information such as text, sound, or an image indicating the utterance of the user 1, or information such as an image (moving image) indicating motions of the user 1 can be used. As another example, as the control content related to the arm control of the robot device, information specifying a posture of the robot device after control, a destination point of a predetermined part, or information indicating an imitation operation of a robot operation by a person or another object (a simulator that performs a pseudo motion of the robot, also including objects on the screen) or an instruction operation to the robot (an operation instruction by a gesture such as pointing) can be used.

Here, the format of the input information D11 is not particularly limited. For example, the information may be text, image, sound, data written in a predetermined design language, control descriptions (including source code and information written in a predetermined programming platform language), information written in other platform languages, control commands (a control instruction, a control signal, a control code, and a controller command), or execution code. Note that these pieces of information may be appropriately combined. Note that, in the present disclosure, "text" without particular distinction may include data described in a predetermined design language that cannot be discriminated by a person, a control description (including a source code and information described in a predetermined programming platform language), information described in other platform languages, and data discriminated by a machine, such as a control command (a control instruction, a control signal, a control code, and a controller command) and an execution code, expressed in text, in addition to data expressed in natural language in text.

The control description D12 includes information regarding control described in a predetermined format discriminable by the execution code generation unit 120 in the subsequent stage. The control description D12 is, for example, a source code described in a predetermined programming language. In addition, the control description D12 may be, for example, a command group described in a format (platform language) handled by a predetermined programming platform. Here, the predetermined programming platform can include a no-code programming platform and a low-code programming platform.

The device information storage unit 110 stores the device information D13 that is information on the target device 2. The device information D13 may include, for example, information indicating a function, performance, structure, dimension, operation, and/or control method of the target device 2. In addition, the device information D13 may include, for example, information regarding a program used for controlling the target device 2. The device information D13 may be, for example, a manual or a handbook of the target device 2 converted into data. The conversion into data here includes conversion into text, conversion into image data, conversion into data by reading sound, and combinations thereof. The device information D13 is used, for example, as additional information for the learning model unit 100 to output the control description D12.

The device information D13 may include information indicating the state of the target device 2. The information indicating the state of the target device 2 may include not only the current state of the target device 2 but also information indicating the past state. For example, the device information D13 may include time-series data having a predetermined data structure indicating the state of the target device 2. The information indicating the state of the target device 2 may be, for example, information output from the target device 2 or information input by the user 1 or another device. The information indicating the state of the target device 2 can include various types of information (for example, error information, log information, notification information, and the like) output from the target device 2. Hereinafter, in the present embodiment, in particular, information indicating the state of the target device 2 may be referred to as state information D15.

In response to input of the control description D12, the execution code generation unit 120 generates and outputs an execution code D14 that is a code executable by the target device 2 on the basis of the control description D12. The execution code D14 may be, for example, a code group described in machine language. The execution code D14 includes, for example, information used when the target device 2 actually performs control. The execution code D14 may output the movement amount for each determined control cycle for each control cycle. The execution code D14 may be, for example, information related to control described in a format discriminable by the target device 2. The execution code generation unit 120 may be, for example, a compiler that converts the control description D12 into the execution code D14.

The execution code D14 output from the execution code generation unit 120 is input to the target device 2. As a result, the target device 2 operates according to the execution code D14 output from the execution code generation unit 120. The input of the execution code D14 to the target device 2 may be directly input from the execution code generation unit 120, or may be indirectly input via a communication network, another device (Server, various conversion devices, and the like), a human hand, or the like.

The target device 2 is not particularly limited. Note that it is assumed that the target device 2 is a device that can receive the execution code D14 and actually execute the code, but this is not the case when an interface that causes the target device 2 to read the execution code, such as a writing device, is included in relation to the target device 2.

The target device 2 is, for example, a PLC, a processing machine, a robot, a radar, a sensor, a camera, a projector, or a communication device. The target device 2 may be, for example, an air conditioner, a refrigerator, a television, a lighting device, or a washing machine. In addition, the target device 2 may be, for example, an elevator, mobility, a transport device, another machine, or a control device that controls such a machine. In addition, the target device 2 may be a control device that controls equipment that operates in a power generation/transformation/power storage plant, a water treatment plant, and the like, and other equipment. In addition, in a case where the control description D12 is an interpreted language and the target device 2 is a device that can receive the control description D12 and execute the control description as it is, the execution code generation unit 120 is omitted.

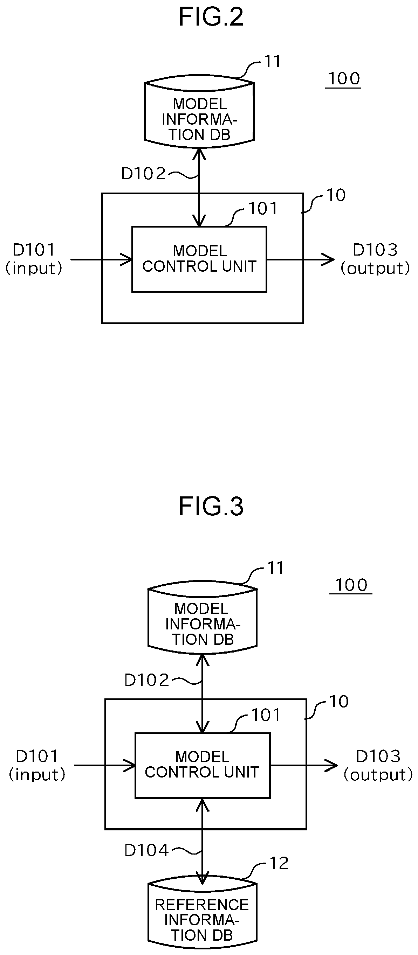

FIG. 2 is an explanatory diagram illustrating an exemplary configuration of the learning model unit 100. As illustrated in FIG. 2, the learning model unit 100 may include a model control unit 101 that operates on an information processing device 10 and a model information storage unit 11 (in the drawing, denoted by model information DB) that stores the model information D102. Here, the model information storage unit 11 may include a plurality of databases connected via a network.

The model information D102 includes information on a model. The model information D102 may include, for example, information indicating a correlation between model input data D101 and model output data D103 as information on a model. In addition, the model information D102 may include, for example, information indicating a candidate of the model output data D103 as information on a model. In addition, the model information D102 may further include, as information on a model, information indicating candidates of the model output data D103 and information indicating a relationship between the candidates. In addition, the model information D102 may include, for example, model parameters that are information defining the behavior of the learning model, such as a constraint condition, a weighting variable, and an evaluation function.

The model may be, for example, a model machine-learned by supervised learning, reinforcement learning, or unsupervised learning. The model may be, for example, a model obtained by executing learning according to a known algorithm/method such as deep learning, a genetic program, a functional logic program, or the like. In addition, the model may be, for example, a model called a neural network (NN) model, a convolutional neural network (CNN) model, a recurrent neural network (RNN), a variational autoencoder (VAE), generative adversarial networks (GAN), a diffusion model, a transformer model, a large language model (LLM), a visual language model (VLM), bidirectional encoder representations from transformers (BERT), generative pre-trained transformer (GPT), or contrastive language image pre-training (CLIP). In addition, the model may be a model described on a rule basis for obtaining an output result by referring to a predetermined table or making a determination on the basis of a predetermined condition. Note that the above-described models are not exclusive, and, for example, LLM, VLM, BERT, and GPT are included in the transformer model. In addition, for example, the transformer model is included in the NN model. In addition, the learning algorithm and the model may be a combination of a plurality of types. The model also includes what is called a multimodal model learned by combining a plurality of different types of data.

Upon receiving the model input data D101, the model control unit 101 outputs the model output data D103 corresponding to the model input data D101 on the basis of the model input data D101 and the model information D102. Upon receiving the model input data D101, the model control unit 101 outputs the model output data D103 corresponding to the model input data D101 using, for example, the model indicated by the model information D102.

The model control unit 101 is implemented by, for example, a CPU that operates according to a program included in the information processing device 10. Hereinafter, the learning model unit 100 may be referred to as an artificial intelligence unit. Here, the artificial intelligence unit refers to AI having intelligent functions such as inference and judgment, and an operation environment thereof. Therefore, the model control unit 101 may include AI having intelligent functions such as inference and judgment, and an operation environment thereof. The model control unit 101 may be, for example, AI including the learning model as described above and an operation environment thereof. The model control unit 101 may be an element (module) of a control unit 104 included in the information processing device 10.

In addition, as illustrated in FIG. 3, the learning model unit 100 may further include a reference information storage unit 12 (in the drawing, denoted by reference information DB12) that stores the model reference information D104. Here, the reference information storage unit 12 may include a plurality of databases connected via a network. The same applies to other storage units (for example, a device information storage unit or the like) described later.

The model reference information D104 is information that is referred to by the model control unit 101 to output the model output data. The model reference information D104 can include a history of model input data input in the past and/or a history of model output data output in the past. In addition, the model reference information D104 may include information in which a feature included in the past input is associated with a feature included in the output performed on the input. In addition, the model reference information D104 may include information on the evaluation for the result output in response to the past input.

In addition, the model reference information D104 may include information related to an expression or a concept included in the model input data D101. The model reference information D104 may include, for example, information in which a specific expression or concept that can be included in the model input data D101 is associated with another expression or concept related to the expression or concept. Here, another expression or concept related to a certain expression or concept can include an expression or concept that is more specific to a certain expression or concept, and another expression or concept evoked on the basis of a certain expression or concept. The model reference information D104 may include, for example, information in which a specific expression or concept that can be included in the model input data D101 is associated with an expression or concept related to the expression or concept. For example, the model reference information D104 may include, for example, information in which a specific expression or concept that can be included in the model input data D101 is associated with information related to the expression or concept. The model reference information D104 may include, for example, information in which search keys and values extracted from expressions or concepts that can be included in the model input data D101 are associated with each other. The model reference information D104 may include information for so-called grounding. In addition, the model reference information D104 may include a so-called knowledge graph that describes entities in the real world and relationships therebetween. In the knowledge graph, various pieces of information are systematically connected and represented by a graph structure.

In addition, the model reference information D104 may include information for so-called attention. For example, the model reference information D104 may include information indicating a correlation between an expression or concept that can be included in the model input data D101 and another expression or concept. In addition, the model reference information D104 may include a feature map having key information extracted from an expression or a concept that can be included in the model output data D103 associated with the expression or the concept that can be included in the model input data D101 as a feature. In addition, the model reference information D104 may include information in which a query extracted from an expression or a concept that can be included in the model input data D101 is associated with key information for search corresponding to the query.

In the example illustrated in FIG. 3, upon receiving the model input data D101, the model control unit 101 outputs model output data D103 on the basis of the model input data D101, the model information D102, and the model reference information D104.

Note that the learning model unit 100 can include a search engine for searching the model reference information D104 or an interface with the search engine instead of the reference information storage unit 12. In such a case, the search range of the search engine may be an external network or a specific network. Here, a database (for example, the device information DB or the like) included in the control system of the present disclosure can be used as one of an external network or a specific network.

The term "learning model" may refer to a computer algorithm or learned information itself that performs some sort of output on the basis of the learned information with respect to the input information. However, when the term "learning model" is used under the operation environment, it often refers to an actual program for operating such a computer algorithm and the operation environment thereof. In the present disclosure, the latter is adopted, and a model that actually operates on the basis of information or the like stored in the model information D102 is referred to as a "learning model" in order to be distinguished from a simple algorithm or a learned information group. The control system according to the present disclosure includes a learning model unit (in particular, the model control unit 101) corresponding to such a learning model. Therefore, hereinafter, in the description of the control system, the term "learning model" refers to the learning model unit or the model control unit 101 in particular in the learning model unit.

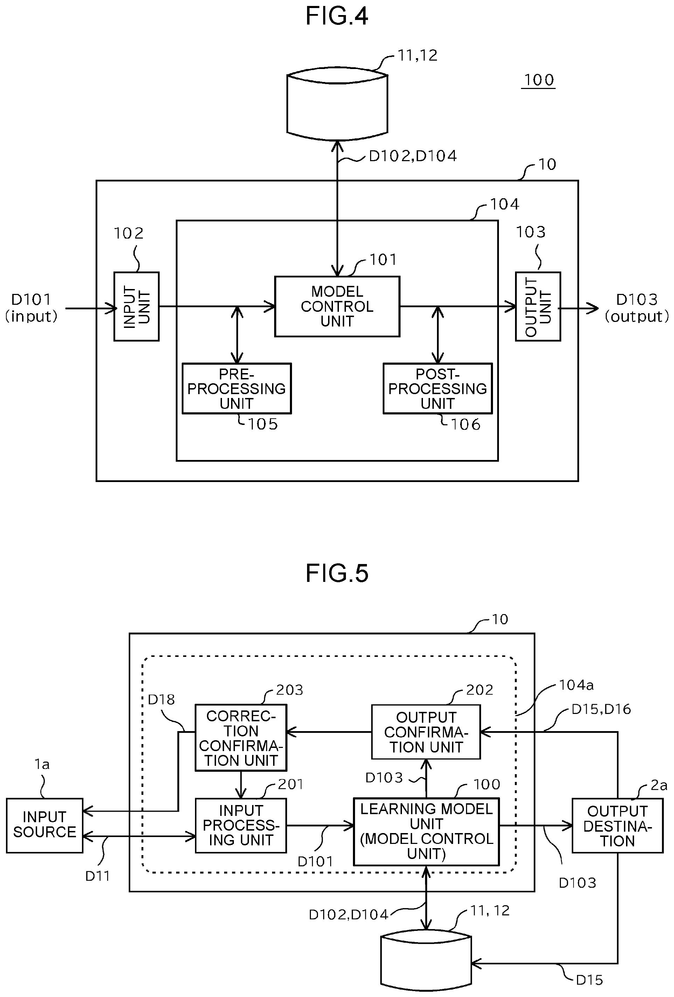

FIG. 4 is an explanatory diagram illustrating another exemplary configuration of the learning model unit 100. As illustrated in FIG. 4, the learning model unit 100 may include an input unit 102, an output unit 103, and a control unit 104.

The input unit 102 receives the model input data D101. The input unit 102 may receive the model input data D101 input by the user 1 or the like. The input unit 102 may receive the model input data D101 constituting the time-series data. At this time, the input unit 102 may sequentially receive the model input data D101 constituting the time-series data, or may receive the model input data D101 buffered to some extent. The input unit 102 may receive the model input data D101 input from a plurality of input sources. At this time, the input unit 102 may receive the model input data D101 to which the information of the input source (for example, a user identifier, attribute information of the user, and the like) is attached, the input unit 102 may determine the input source, attach the information of the input source to the model input data D101, and then receive the model input data D101, or may receive the model input data D101 without doing anything. The input unit 102 is implemented by, for example, various input devices (for example, a pointing device, a keyboard, a sound input device, an image input device, a data reading device, a data input device corresponding to various communication interfaces, and the like) included in the information processing device 10. Note that the input unit 102 may be implemented by an external device of the information processing device 10. In that case, the information processing device 10 only needs to include an interface with the input unit 102.

The output unit 103 outputs the object generated by the control unit 104. Here, the object includes the model output data D103 or data generated from the model output data D103. In addition, in a case where the object generated by the control unit 104 includes information to a plurality of output destinations, the output unit 103 may output the object to the plurality of output destinations. At that time, the output unit 103 may output the same data to a plurality of output destinations, or may output different data for each output destination. The output unit 103 is implemented by, for example, various output devices (for example, a display device, an audio output device, an image output device, a data writing device, a data output device corresponding to various communication interfaces, and the like) included in the information processing device 10. Note that the output unit 103 may be implemented by an external device of the information processing device 10. In that case, the information processing device 10 only needs to include an interface with the output unit 103.

The control unit 104 operates on the information processing device 10 and includes a pre-processing unit 105 and a post-processing unit 106 in addition to the above-described model control unit 101.

The pre-processing unit 105 performs processing for increasing the accuracy of the object generated by the control unit 104. For example, the pre-processing unit 105 may add, change, or delete an element, or convert data (including processing) with respect to the model input data D101.

For example, when the input unit 102 receives the model input data D101, the pre-processing unit 105 may change an element (including addition and deletion) or convert data (including processing) with respect to the model input data D101. Changing an element or converting data (including processing) includes not only changing a data format but also changing an expression or a concept represented by the data. Data changed by the pre-processing unit 105 is input to the model control unit 101 in the subsequent stage as the model input data D101. The processing performed by the pre-processing unit 105 includes prompt shaping to the model control unit 101.

For example, the pre-processing unit 105 may perform processing of decomposing the model input data D101 into predetermined unit data. In addition, the pre-processing unit 105 may perform processing of integrating a plurality of pieces of model input data D101, for example. Furthermore, the pre-processing unit 105 may decompose the model input data D101 into predetermined unit data and then change the element or convert the data, or may integrate a plurality of pieces of model input data D101 and then change the element or convert the data.

For example, in a case where there is a problem in the object generated by the control unit 104 (particularly, the model control unit 101), the post-processing unit 106 corrects the object. For example, the post-processing unit 106 may determine whether there is a problem in the object using the above-described knowledge graph. For example, the similarity between the relationship indicated by the knowledge graph, the relationship between the expression or concept included in the model input data and the expression or concept included in the model output data, and/or the relationship between the expressions or concepts included in the model output data may be compared, and it may be determined that there is a problem in the object in a case where the relationship is away from the relationship indicated by the knowledge graph by a predetermined distance or more.

Note that the components other than the model control unit 101 among the above-described components are not essential, and the presence or absence of mounting can be appropriately selected.

Furthermore, the model information D102 and other information used by the learning model may be prepared in advance, or may be acquired via a communication network as necessary.

FIG. 5 is a configuration diagram illustrating another example of the information processing device 10 as an operation environment of the control unit 104 and the like including the learning model unit 100. The information processing device 10 illustrated in FIG. 5 may include a control unit 104a including the learning model unit 100 (particularly, the model control unit 101), an input processing unit 201, an output confirmation unit 202, and a correction confirmation unit 203.

The input processing unit 201 receives the input information D11 from the input source 1a such as the user 1. In addition, the input processing unit 201 outputs the received input information D11 to the learning model unit 100 as the model input data D101.

At that time, for example, the input processing unit 201 may output, as the model input data D101, data obtained by changing an element or converting data of the input information D11. For example, the input processing unit 201 may remove noise from the input information D11. In addition, for example, in a case where qualitative information is included in the input information D11, the input processing unit 201 may convert the information into quantitative information. In addition, for example, in a case where quantitative information is included in the input information D11, the input processing unit 201 may correct the amount according to a device that is a target of the request of the input information D11 or an operation environment thereof. In addition, the input processing unit 201 may change, for example, so-called grounding processing, that is, the expression or concept indicated by the input information D11 to a more specific expression or concept.

In addition, in a case where the input information D11 includes unclear or uncertain information, the input processing unit 201 may return an inquiry to the input source. As the inquiry, the input processing unit 201 may output, for example, a message for confirming the input content, a message for suggesting a correction proposal of the input information D11, a message for requesting reinput of the input information D11 having a different state or expression, or the like. In addition, the correction proposal of the input information D11 may be generated by the correction confirmation unit 203 to be described later. Hereinafter, information indicating correction, addition, and cancellation of the content with respect to the input/output data of the learning model after the input/output may be referred to as supplementary information D18. The correction proposal is an example of the supplementary information D18.

The output confirmation unit 202 performs a simulation that simulates the control and state of the target device 2 on the basis of the model output data D103 output from the learning model unit 100. The output confirmation unit 202 may perform the simulation after converting the model output data D103 into control information matching a predetermined simulator (not illustrated) capable of simulating the control and state of the target device 2. The output confirmation unit 202 may have a simulator function. When performing the simulation, the output confirmation unit 202 may use information acquired from an output destination 2a of the model output data D103. Here, the output destination 2a includes an output destination of information generated from the model output data D103. The information acquired from the output destination 2a may include, for example, state information D15 and/or feedback information D16 to be described later.

The output confirmation unit 202 may confirm, for example, the state of the target device 2, the state of the system including the target device 2, and/or the state of the workpiece of the target device 2. In addition, the output confirmation unit 202 may generate and display an intermediate product that can be understood by a person with respect to the model output data D103 or the information generated based on the model output data D103 before performing the operation confirmation. Examples of the intermediate product include a source code for the control program and an operation image of the controller of the target device 2 for an operation command to the target device 2. In addition, the output confirmation unit 202 may display the result of the simulation together with the reliability index of the learning model.

The following is an example of the reliability index of the learning model. For example, at the time of preliminary learning or the like, an evaluation network in which a result of evaluation by a person is accumulated every time there is an input to the learning model and the input and the evaluation result are learned may be provided, and at the time of using the learning model, the input of the learning model may also be input to the above-described evaluation network and the output result may be used as the reliability index.

Furthermore, for example, a learning device that clusters the output of the learning model at the time of preliminary learning or the like may be provided, and the output of the learning model may also be input to the above-described learning device at the time of using the learning model, and a result of the clustering may be used as the reliability index.

Furthermore, for example, at the time of preliminary learning or the like, an evaluation network in which a result obtained by a person evaluating a result every time there is an input to the learning model is accumulated and a feature of an input having a high evaluation result is learned may be provided, and at the time of using the learning model, the input of the learning model may also be input to the above-described evaluation network, and the similarity between the feature that is the output result and the feature of the learning result may be used as the reliability index.

Furthermore, for example, at the time of preliminary learning or the like, a learning device that accumulates a result obtained by a person evaluating a result every time there is an input to the learning model and clusters an input of a learning model having a high evaluation result may be included, and at the time of using the learning model, the input of the learning model may also be input to the learning device described above and the result of the clustering may be used as the reliability index.

The correction confirmation unit 203 uses the result of the simulation performed by the output confirmation unit 202 to determine the validity of the model output data D103 and/or the model input data D101. For example, the correction confirmation unit 203 may compare the state of the target device 2 indicated by the simulation result with the state of the target device 2 specified by the input information D11, the model output data D103, and/or the model input data D101, and determine whether the correct control is performed, thereby determining the validity of the model output data D103 and/or the model input data D101. The correction confirmation unit 203 may determine that the correct control is performed when the state of the target device 2 indicated by the simulation result matches the state of the target device 2 specified by the model output data D103 and/or the model input data D101. The state of the target device 2 to be compared here is not limited to one.

In addition, the correction confirmation unit 203 may determine the validity of the model output data D103 and/or the model input data D101 by checking, for example, whether the state or the control locus of the target device 2 indicated by the simulation result matches the control indicated by the input information D11 or whether the control locus does not include contents prohibited in advance.

In addition, the correction confirmation unit 203 may determine the validity of the model output data D103 and/or the model input data D101 by presenting the simulation result to the input source 1a of the input information D11 and asking for an answer as to whether or not desired control is performed.

When determining that the model output data D103 and/or the model input data D101 are/is not correct, the correction confirmation unit 203 may correct the model input data D101. In addition, instead of correcting the model input data D101, the correction confirmation unit 203 may generate the supplementary information D18 for the input information D11 and output the supplementary information D18 to the input source 1a.

For example, the control system 1000 may have a configuration illustrated in any one of FIGS. 1 to 5 as an operation environment of the learning model unit 100. Similarly to the learning model unit 100, even in that case, a part or all of the configuration may be an internal configuration or an external configuration of the control system 1000.

Note that the above-described configuration of the learning model unit 100 and its periphery is merely an example, and not all the constituent elements are essential configurations, and it is sufficient to appropriately select the presence or absence of implementation according to a desired function.

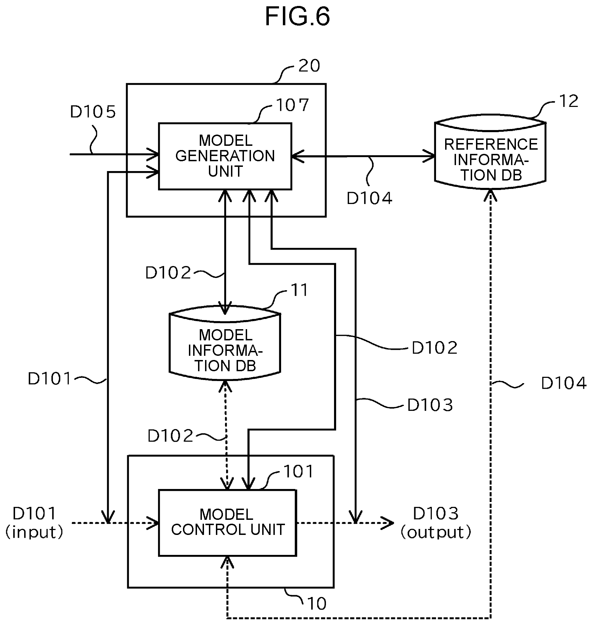

FIG. 6 is an explanatory diagram illustrating an example of model learning. As illustrated in FIG. 6, the model information D102 may be generated, for example, by a model generation unit 107 performing machine learning using model learning data D105.

The model generation unit 107 is a processing unit that generates or updates the model information D102 on the basis of the input model learning data D105 according to a predetermined algorithm. The model generation unit 107 is implemented by, for example, a CPU that operates according to a program included in the information processing device 20. Here, the algorithm followed by the model generation unit 107 may be a machine learning algorithm corresponding to the learning model, for example, supervised learning, reinforcement learning, or unsupervised learning, or may be deep learning, a genetic program, a functional logic program, or other known algorithms.

Furthermore, the model generation unit 107 may generate or update the model information D102 for the input model learning data D105 further on the basis of the model reference information D104. In addition, the model generation unit 107 may generate or update the model information D102 for the input model learning data D105 further on the basis of the model output data D103 from the model control unit 101.

The model learning data D105 is not particularly limited. For example, in a case where supervised learning is used as a learning algorithm, the model learning data D105 may include a candidate of the model input data D101 that can be input and a candidate of the model output data D103 corresponding thereto. In addition, the model learning data D105 may include model input data D101 actually input and/or model output data D103 actually output. The feedback control can be performed by appropriately using the actual model input data D101 and/or the model output data D103. Furthermore, the model learning data D105 may include information acquired from a device or a processing unit included in a system in which the learning model actually operates.

The model information D102 generated or updated by the model generation unit 107 is stored in the model information storage unit 11 and provided to the model control unit 101. Alternatively, the model generation unit 107 can directly output the model information D102 to the model control unit 101.

The model generation unit 107 may generate the model information D102 by using the input model learning data D105 by preliminary learning, for example, before the model control unit 101 uses the model information D102, and store the model information D102 in the model information storage unit 11.

The update of the model information D102 by the model generation unit 107 may be processing called Fine-Tuning (or, FineTune).

Note that the model generation unit 107 may be included in the control system 1000 or may be included in a system different from the control system 1000.

In addition, in FIG. 1, the learning model unit 100, the device information storage unit 110, and the device information D13 are illustrated separately, but the device information storage unit 110 and the device information D13 may be a part of the learning model unit 100. That is, the learning model unit 100 may include the device information storage unit 110 and the device information D13. For example, the learning model unit 100 may include the device information storage unit 110 as one of reference information storage units 12 to be described later. In addition, the device information D13 may be used in the model learning phase in which the model used by the learning model unit 100 is learned so that the device information D13 is incorporated in the model in advance. In this case, the device information storage unit 110 may be omitted.

In addition, a part or all of the learning model unit 100 may be an internal configuration of the control system 1000 or an external configuration of the control system 1000. In the case of an external configuration of the control system 1000, the control system 1000 may include an interface capable of exchanging information with an external system including a part or all of the learning model unit 100 instead of the part or all of the learning model unit. For example, the control system 1000 may provide as an external configuration the model information storage unit 11 called a core of the learning model. Furthermore, for example, the control system 1000 may provide as an external configuration a model information storage unit 11 called a core of the learning model and a model control unit 101 responsible for an algorithm of the model.

Hereinafter, in the control system 1000, in order to distinguish between the model control unit 101 responsible for the algorithm of the learning model and a portion that performs processing of throwing a request to such a model control unit 101 to obtain a response, a portion that performs the latter processing may be referred to as a "model processing unit". More specifically, the model processing unit corresponds to a portion other than the model control unit 101 in the information processing device 10, the control unit 104, or the control unit 104a described above. Note that, for example, in a case where the model control unit 101 exists in the internal environment, the model processing unit may be implemented by an operating system (OS) that calls a learning model application and a prompt application (and a control unit that is an operation environment thereof) operating on the information processing device 10. Note that, for example, in a case where the model control unit 101 exists in an external environment, the model processing unit may be implemented by a browser and a client application (and a control unit that is an operation environment thereof) operating on the information processing device 10.

Note that the learning model and the configuration of the information processing device as an operation environment thereof described above, and the relationship between the learning model and the control system including the learning model are similar in other embodiments.

In the present embodiment, the input information D11 corresponds to the model input data D101. The control description D12 corresponds to the model output data D103. For example, the learning model unit 100 (in particular, the model control unit 101) may be configured to output the control description D12 corresponding to the input information D11 on the basis of the model information D102 and the model reference information D104 as necessary when receiving the input information D11.

Furthermore, in such a case, the model generation unit 107 provided corresponding to the learning model unit 100 may perform machine learning using, for example, the model learning data D105 including candidates of the input information D11 that can be input to the model control unit 101, and generate or update the model information D102. Furthermore, the model generation unit 107 may generate or update the model information D102, for example, by performing machine learning using the model learning data D105 including a candidate of the input information D11 that can be input to the model control unit 101 and a candidate of the control description D12 corresponding thereto.

In the present embodiment, the learning model unit 100 may be, for example, a language learning model such as LLM that inputs a natural language and obtains an output result and an operation environment thereof. Furthermore, the learning model unit 100 may be, for example, an image learning model such as a VLM that inputs an image and obtains an output result and an operation environment thereof. Furthermore, the learning model unit 100 may be, for example, a multimodal model that inputs a natural language and an image and obtains an output result and an operation environment thereof. In this case, the input information D11 may be input in text data, image data, a combination of text data and image data, or a data format (sound data, a moving image which is a combination of sound data and image data, and the like) that can be converted into the text data, image data, or a combination of text data and image data. Note that the learning model used in the present embodiment is not limited to the above-described model.

In the present embodiment, the input information D11 received by the control system 1000 can be referred to as information on a request (here, the control contents requested to the target device 2 are described) in a work environment, here, an environment in which the target device 2 operates. Therefore, the input information D11 received by the control system 1000 can be regarded as an example of the first information indicating the request in the work environment. In addition, the control description D12 and the execution code D14 can be regarded as information used for the work (work related to control to the target device 2) corresponding to such input information D11. Hereinafter, the control description D12 output to a predetermined output destination from the operation environment of the learning model to which the model input data based on the input information D11 is input may be referred to as second information.

Here, in the relationship between the input information D11 and the model input data, the model input data based on the input information D11 may include the input information D11 itself, a format obtained by converting the input information D11 into a format that matches the input of the learning model, and a supplement of the input information D11. In the relationship between the model output data and the second information, the second information based on the model output data may include the model output data itself obtained by converting the model output data into a format that matches the input of the output destination and the model output data supplemented. The same applies to the relationship between the input/output information and the model input/output data in other embodiments.

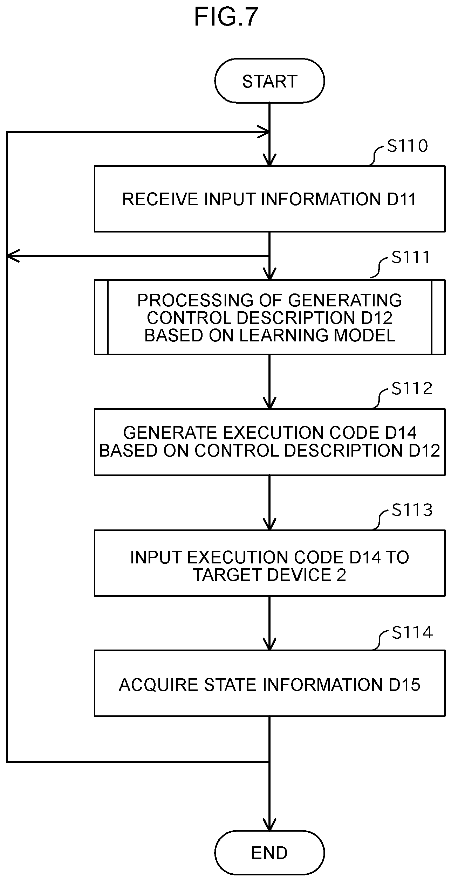

Next, an operation of the control system 1000 of the present embodiment will be described. FIG. 7 is a flowchart illustrating an operation example of the control system 1000.

In the example illustrated in FIG. 7, first, the control system 1000 receives the input information D11 (step S110). For example, the input unit 102 or the input processing unit 201 described above may receive the input information D11. The received input information D11 is input to the learning model unit 100 as the model input data D101.

In step S110, the control system 1000 may receive a plurality of pieces of input information D11. Furthermore, the control system 1000 may receive the input information D11 that further meets the request of the user 1 while interactively inputting and outputting information related to the input information D11 with the user 1, that is, repeatedly inputting and outputting information to and from the user 1.

Next, the control system 1000 performs generation processing of the control description D12 using the learning model unit 100 (step S111). In step S111, the learning model unit 100 generates and outputs the control description D12 corresponding to the input information D11 that has been input. For example, the learning model unit 100 (more specifically, the model control unit 101) outputs the control description D12 corresponding to the input information D11 on the basis of the model reference information D104 including the model information D102 and the input information D11 that has been input, and the device information D13 as necessary. For example, the learning model unit 100 may generate the control description D12 of text data from the input information D11 that has been input using a learning model capable of generating text data.

In step S111, the learning model unit 100 (more specifically, the pre-processing unit 105 or the input processing unit 201) may further add, change, or delete an element or convert data (including processing) to the input information D11 that has been input in order to increase the accuracy of the control description D12 before the processing of the model control unit 101. Furthermore, in step S111, the learning model unit 100 (more specifically, post-processing unit 106) may further determine whether there is a problem in the control description D12 after the processing of the model control unit 101, and perform processing of correcting the control description D12 in a case where it is determined that there is a problem.

The control description D12 output from the learning model unit 100 is input to the execution code generation unit 120. In response to input of the control description D12, the execution code generation unit 120 generates the execution code D14 on the basis of the input control description D12 (step S112).

Next, the execution code D14 generated by the execution code generation unit 120 is input to the target device 2 (step S113). As described above, the input of the execution code D14 to the target device 2 may be directly input from the control system 1000 (more specifically, the execution code generation unit 120), or may be indirectly input via a communication network, another device (server, various conversion devices, and the like), or a human hand.

As a result, the target device 2 operates according to the input execution code D14.

If there is a change in the state of the target device 2 due to control of the target device 2 or the like as a result of outputting the execution code D14, the control system 1000 may acquire the state information D15 (step S114). The acquired state information D15 is stored in the device information storage unit 110 as part of the device information D13, for example. For example, the control system 1000 may update the device information D13 stored in the device information storage unit 110 using the acquired state information D15. Furthermore, for example, the control system 1000 may output the acquired state information D15 to the user 1, the learning model unit 100, or another device (not illustrated) as information indicating a control result. Note that, in a case where the control system 1000 does not use the state information D15, the processing of step S114 can be omitted.

The control system 1000 may repeat the processing of steps S110 to S114 a plurality of times (for example, until the desired control for the target device 2 is completed).

Note that the control system 1000 may output the control description D12 to the operation terminal or the like of the user 1 such that the user 1 confirms the content and then subsequent processing (code generation in the execution code generation unit 120 or the like) is executed by the operation of the user 1.

The state information D15 input to the learning model unit 100 is used for additional learning of the learning model unit 100, for example. For example, the learning model unit 100 may update the model information D102 and/or the model reference information D104 on the basis of the input state information D15.

As described above, according to the present embodiment, since the execution code D14 can be generated from the input information D11 input from the user 1 without the user 1 creating the control description D12, it is possible to improve the efficiency of the work of controlling the target device 2.

Furthermore, in the present embodiment, since the input information D11 may be text, an image, sound, or a combination thereof explicitly or implicitly indicating the control content for the target device 2, it is possible to improve the efficiency of the work of controlling the target device 2 while further reducing the trouble of inputting the input information D11.

In addition, according to the present embodiment, since the control description D12 can be generated from the input information D11 using the learning model, the control description D12 corresponding to the input information D11 can be generated even if the user 1 does not know information for controlling the target device 2 such as detailed specifications of the target device 2 and specifications of the control description D12, and thus, it is possible to improve performance of work of controlling the target device 2. Here, the performance enhancement of the work of controlling the target device 2 includes high accuracy of control of the target device 2.

In addition, in the present embodiment, the state information D15 acquired after controlling the target device 2 on the basis of the input information D11 can be used for generation of the next control description D12 and the like, and thus, it is possible to further improve performance of work of controlling the target device 2.

Although only one target device 2 is illustrated in the above example, a plurality of target devices 2 may be controlled by the control system 1000. In such a case, for example, information by which the target device 2 is discriminable may be included in the input information D11, an input side (input unit 102, pre-processing unit 105, and input processing unit 201) to the learning model unit 100 may perform processing of discriminating the target device 2 on the basis of the input information D11, or the learning model unit 100 may output control contents in which the target device 2 is discriminated as a result of learning.

### Modification 1-1.

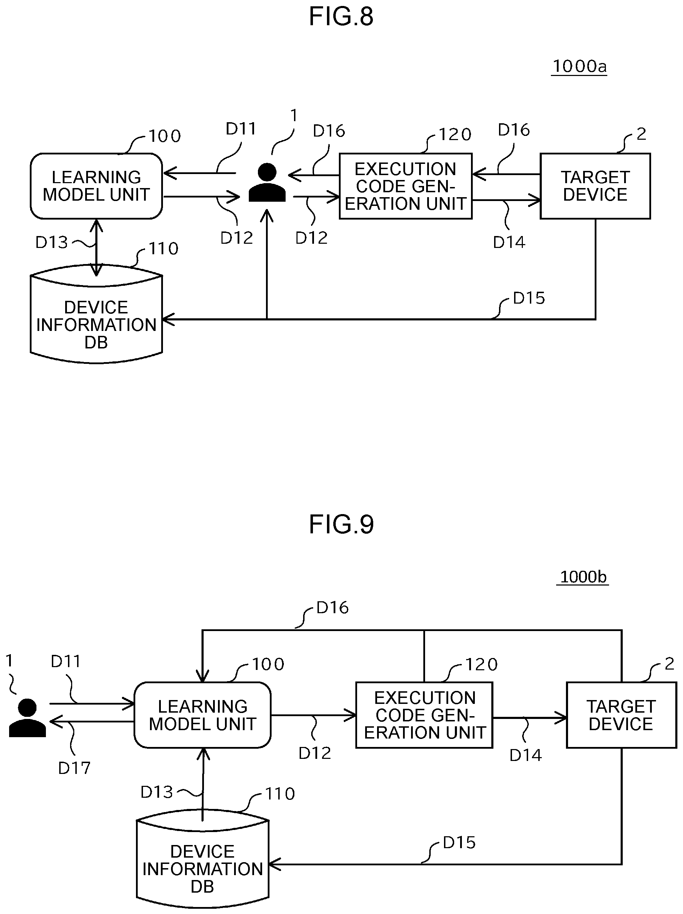

Next, a modification of the control system 1000 will be described. FIG. 8 is a configuration diagram illustrating an example of a control system 1000a which is a modification of the control system 1000 according to the present embodiment. Note that the same elements as those of the control system 1000 are denoted by the same reference signs, and description thereof is omitted.

In the control system 1000a illustrated in FIG. 8, the output from the learning model unit 100 is input to the execution code generation unit 120 in the subsequent stage after being confirmed by the user 1.

In the present embodiment, the user 1 can confirm the control description D12 output from the learning model unit 100 and input the input information D11 on the basis of the confirmation result. In addition, the user 1 may confirm the feedback information D16 from the execution code generation unit 120 and/or the target device 2 in addition to the control description D12 output from the learning model unit 100, and input the input information D11 on the basis of the confirmation result. At this time, the user 1 may input the input information D11 indicating correction, addition, and cancellation of the already input content in addition to the input information D11 of the new content. At this time, the input information D11 can include a command to the learning model unit 100. For example, the user 1 may input, as the input information D11, a command for removing a defect included in the input information D11 or a defect included in the output control description D12 together with the feedback information D16. Here, the command for removing the defect includes an input for searching for a cause of the defect and a method for solving the defect.

The feedback information D16 may include a response to a request returned from the processing unit when the control is requested from the learning model unit 100 to the processing unit at the subsequent stage. Furthermore, the feedback information D16 may include information obtained from a processing unit after the learning model unit 100 requests the processing unit at a subsequent stage for control. For example, when the control description D12 is input to the execution code generation unit 120 to request the execution code generation unit to generate the control description D12, the feedback information D16 may include a response to the request returned from the execution code generation unit 120. In addition, the feedback information D16 may include a response to a request, which is returned from the target device 2 when the execution code D14 is input to the target device 2 to request the target device 2 to execute the code. The feedback information D16 may include the state information D15. The feedback information D16 may be directly output to the user 1 or may be output to the user 1 via an output device (not illustrated) included in the execution code generation unit 120 or the control system 1000.

Furthermore, the feedback information D16 can include information for determining whether or not control requested from the learning model unit 100 to a processing unit at a subsequent stage is correctly executed in the processing unit. The information is not limited to information directly obtained from the processing unit. For example, the information may be information obtained from another person, device, network, or AI (none of which is illustrated). The feedback information D16 can include, for example, analysis information for determining whether the execution code D14 can correctly execute the intended control, such as execution time or control trajectory information. For example, the user 1 can instruct the learning model unit 100 to control the timing of the flow in the control description D12, adjust the lead time, or the like on the basis of such information included in the feedback information D16.

Furthermore, for example, the user 1 may exchange a plurality of times with the learning model unit 100 using the feedback information D16 and determine the validity (presence or absence of a problem) of the output control description D12 each time. When the user 1 determines that there is no problem in the control description D12, the user 1 may output the control description D12 to the execution code generation unit 120.

The feedback information D16 can be acquired, for example, in step S114 described above.

Note that, although FIG. 8 illustrates an example in which the user 1 inputs the control description D12 to the execution code generation unit 120, the input of the control description D12 to the execution code generation unit 120 can also be performed by the learning model unit 100 that has received an instruction from the user 1.

In the present example, the control description D12 may include, for example, a description corresponding to a low code or a no code.

The exchange of information between the user 1 and the learning model unit 100 in the present example may be performed, for example, via a terminal included in the user 1 or via a user interface (for example, the input unit 102) included in the information processing device 10 in which the learning model unit 100 operates.

Furthermore, the input information D11 in the present example may be updated not by the user 1 but on the control system 1000a side (for example, the correction confirmation unit 203 or the like).

Furthermore, the feedback information D16 may be input to the learning model unit 100. The feedback information D16 input to the learning model unit 100 is used for additional learning of the learning model unit 100, for example. The learning model unit 100 may update the model information D102 and/or the model reference information D104 on the basis of the input feedback information D16.

Other points may be similar to other control systems according to the present embodiment.

As described above, in the present modification, the user 1 can correct the input information D11 while confirming the control description D12 output from the learning model unit 100 and exchanging additional instructions, bug consultation, and the like with the learning model unit 100, and thus, it is possible to increase the accuracy of the control description D12 to be output. As a result, it is possible to improve the efficiency and performance of the work of controlling the target device 2.

### Modification 1-2.

Next, a second modification of the control system 1000 will be described. FIG. 9 is a configuration diagram illustrating an example of a control system 1000b which is a modification of the control system 1000. Note that the same elements as those of the control system 1000 and the control system 1000a are denoted by the same reference signs, and description thereof is omitted.

The control system 1000b illustrated in FIG. 9 is different in that the learning model unit 100 returns an inquiry D17 to the user 1. Examples of the inquiry D17 include an inquiry for reasking unclear or uncertain input information D11, an inquiry for a solution, and an inquiry for requesting reinput to a state or expression that has been changed. As a reinquiry of the unclear or uncertain input information D11, the learning model unit 100 may output an inquiry D17 for requesting input of more specific information to the user 1 together with presentation of the reference portion. In addition, the learning model unit 100 may output an inquiry D17 to give a solution candidate as an option to the user 1 together with the presentation of the reference point as an inquiry about the solution. Furthermore, the learning model unit 100 may output an inquiry D17 asking whether or not a solution is correct to the user 1 together with information of a solution that is most likely to be correct together with presentation of a reference point as an inquiry asking for a solution. Furthermore, the learning model unit 100 may generate an intermediate control description that is an intermediate control description that is easily understood by a person once, and output an inquiry D17 asking whether or not the generated intermediate control description is correct to the user 1 together with the generated intermediate control description.

The output of the inquiry D17 may be performed, for example, after the above-described step S110.

Upon receiving an answer to the inquiry D17 from the user 1, the learning model unit 100 may update the input information D11 or confirm interpretation (meaning) of the input information D11.

The processing of the learning model unit 100 described above in the present example can also be implemented as, for example, a part of the function of the input unit 102 or the pre-processing unit 105 of the learning model unit 100 or the input processing unit 201 (not illustrated) included in the information processing device 10.

As described above, in the present modification, the inquiry D17 is output to the user 1 with respect to the input information D11 that has been input, and the update or interpretation of the input information D11 is determined on the basis of the answer, so that the uncertainty of the input information D11 can be resolved. As a result, the accuracy of the output control description D12 can be improved, and furthermore, the efficiency and performance of the work of controlling the target device 2 can be improved.

### Modification 1-3.

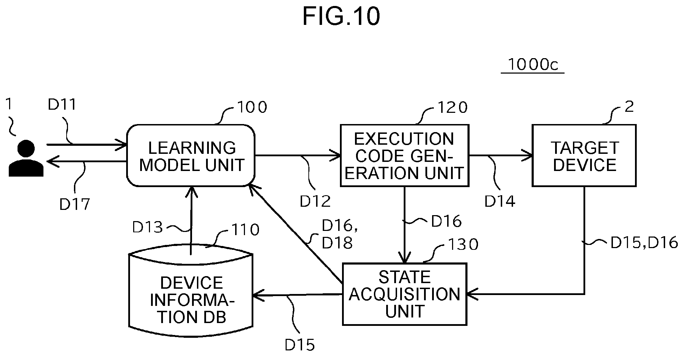

Next, a third modification of the control system 1000 will be described. FIG. 10 is a configuration diagram illustrating an example of a control system 1000c which is a modification of the control system 1000. Note that the same elements as those of the control systems 1000, 1000a, and 1000b are denoted by the same reference signs, and description thereof is omitted.

The control system 1000c illustrated in FIG. 10 further includes a state acquisition unit 130. The state acquisition unit 130 acquires the feedback information D16 indicating the processing result or the state information D15 indicating the state of the device after the processing from the processing destination of the control description D12 output from the learning model unit 100 and the execution code D14 generated therefrom. Here, the feedback information D16 or the state information D15 can include information for determining whether the execution code D14 has correctly executed the target control, such as execution time or control trajectory information.

For example, the state acquisition unit 130 may input the acquired information to the learning model unit 100. In addition, the state acquisition unit 130 may update the device information D13 on the basis of the acquired information, for example. Furthermore, for example, the state acquisition unit 130 may generate information that supplements (including addition, modification, cancellation) the input information D11 on the basis of the acquired information and input the generated information to the learning model unit 100 as the supplementary information D18. Furthermore, for example, the state acquisition unit 130 may generate information that supplements (including addition, modification, cancellation) the control description D12 on the basis of the acquired information and input the generated information to the learning model unit 100 as the supplementary information D18.

For example, the state acquisition unit 130 may generate a control command having a new content or a command indicating addition, correction, or cancellation of an already input content indicated by the input information D11 as the supplementary information D18 and input the generated command to the learning model unit 100. In addition, for example, the state acquisition unit 130 may input, together with the acquired information, a command for removing a defect included in the input information D11 or a defect included in the output control description D12 to the learning model unit 100 as the supplementary information D18.

For example, the state acquisition unit 130 may determine whether or not the acquired information is information indicating normal processing or a normal state in the processing destination, and otherwise input, together with the acquired information, supplementary information D18 indicating correction, addition, or cancellation of the content indicated by the input information D11 that has already been input, to the learning model unit 100.

For example, the learning model unit 100 may update the model information D102 and/or the model reference information D104 on the basis of the input information (state information D15, feedback information D16, supplementary information D18, and the like).

The generation of the supplementary information D18 may be performed in step S115 described above, for example. Furthermore, the output destination of the supplementary information D18 may include other than the learning model unit 100. For example, the control system 1000 may output the supplementary information D18 generated by the state acquisition unit 130 to the user 1 or another device (not illustrated).

In addition, the state acquisition unit 130 may acquire an operation result by a simulator (not illustrated) of the target device 2 or an operation result in the debug mode of the target device 2 without actually operating the target device 2. The debug mode of the target device 2 refers to a mode in which the execution code is executed on the control board of the target device 2, but actual device control is not performed, and only the internal state is updated, and is also referred to as an idle operation mode. By using the debug mode, the execution code D14 can be safely tried in a state close to actual control on the target device 2.

As a method for determining the validity of the control description D12 output from the learning model unit 100 and the execution code D14 generated from the control description D12 without actually operating the target device 2 without being limited to the present modification, the execution code generation unit 120 may be connected to switch between the target device 2 and the simulator as an output destination of the execution code D14. The simulator includes a simulator that operates an icon of the target device 2 in the augmented reality space. In addition, when outputting the execution code D14 to the target device 2, the execution code generation unit 120 may add information instructing execution in the normal mode or execution in the debug mode.

The processing of the state acquisition unit 130 in the present example can also be implemented as some functions of, for example, the input unit 102, the pre-processing unit 105, and the post-processing unit 106 of the learning model unit 100, or the input processing unit 201, the output confirmation unit 202, and the correction confirmation unit 203 (all not illustrated) included in the information processing device 10.

Other points may be similar to other control systems according to the present embodiment.

As described above, in the present modification, with respect to the input information D11 that has been input, the state acquisition unit 130 acquires the feedback information D16 indicating the processing result or the state information D15 indicating the state of the device after the processing from the target device 2 or the execution code generation unit 120 serving as the output destination of the model output data D103 and/or the information generated on the basis of the model output data D103, and appropriately issues the supplementary information D18 to the learning model unit 100 on the basis of the acquired information. As a result, it is possible to improve the accuracy of the control description D12, and eventually, it is possible to improve the efficiency and performance of the work of controlling the target device 2.

Furthermore, in the present modification, for example, a person and a machine (state acquisition unit 130) cooperate with each other, and the accuracy of input to the learning model unit 100 can be improved, which can also contribute to reduction of the work load of the user 1.

### Second Embodiment.

Next, the present second embodiment will be described. In the present embodiment, an example of supporting work related to control of a target device using a learning model will be described.

Hereinafter, for example, it is considered to control various control devices such as a PLC, a processing machine, a robot, a sensor, a conveyance device, and other machine control devices in a factory. Skilled workers may be familiar with a wide variety of control devices and complex control methods, but other workers may need to control the control devices due to rearrangement or the like. In addition, when a new control device (including version upgrade) is introduced, it is necessary to notify all the workers of a control method corresponding to the new control device, and if the control method is not sufficiently known, it may lead to a mistake.

In such a case, it is preferable to reliably perform desired control without knowing a specific control method, for example, a control instruction, a control signal, a control code, a command to a controller corresponding to the control device, or the like to be performed on the control device, because this leads to improvement in work efficiency and performance.

Note that the scene of controlling the device is not limited to the inside of the factory, and the utilization scene of the present embodiment is not limited to the inside of the factory.

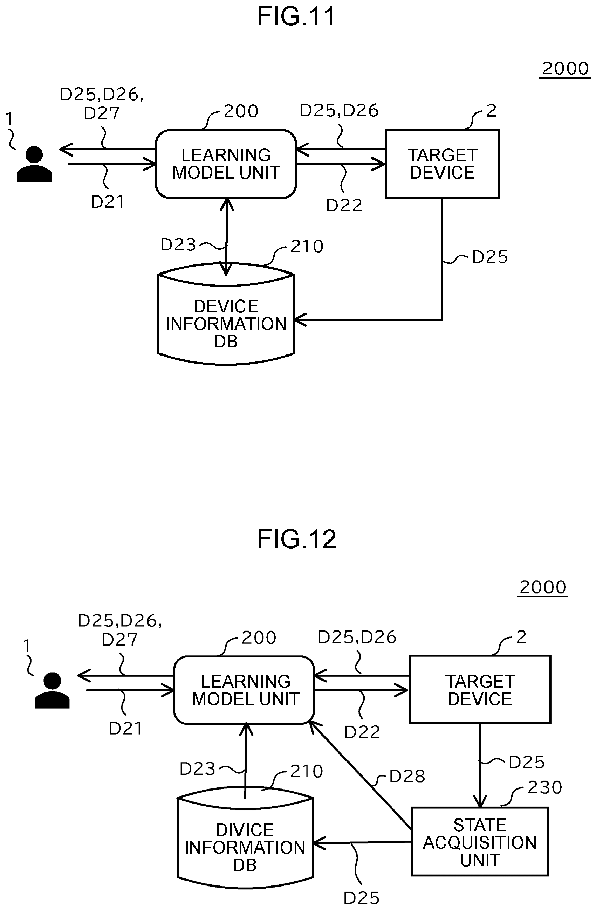

FIG. 11 is a configuration diagram illustrating an example of a control system 2000 according to the second embodiment. The control system 2000 illustrated in FIG. 11 is a control system for controlling a device using a learning model, and includes a learning model unit 200 and a device information storage unit 210 (referred to as a device information DB in the drawing).

In response to input of input information D21, the learning model unit 200 outputs a control command D22. In response to input of the input information D21, for example, the learning model unit 200 outputs the control command D22 on the basis of model information D102. The configuration of the learning model unit 200 may be basically similar to that of the learning model unit 100 in the first embodiment.

In the present embodiment, the learning model unit 200 is a model and an operation environment thereof configured to output the control command D22 corresponding to the input information D21 in response to input of the input information D21. In addition, the learning model unit 200 may be a model and an operation environment thereof configured to, in response to input of the input information D21, generate and output the control command D22 on the basis of the input information D21, device information D23, and other information that can be referred to in the learning model unit 200.

In the present embodiment, the input information D21 includes information indicating control contents for the target device 2. The input information D21 may be, for example, a text, an image, sound, or a combination thereof indicating a control content for the target device 2. The input information D21 may be, for example, a text, an image, sound, or a combination thereof indicating a plurality of control contents for the target device 2. In addition, the input information D21 may include information indicating the control content performed continuously in time, and in that case, may be time-series data having a predetermined data structure including a text, an image, sound, or a combination thereof indicating the control content as described above. It is assumed that the control content is indicated on the assumption that the control content matches the input format of the model used by the learning model unit 200, but this is not the case when error processing, correction processing, or conversion processing is included in the preceding stage of the learning model unit 200.

The way of indicating the control contents in the input information D21 may be, for example, similar to the first embodiment. For example, after specifying the control to be performed on the target device 2, a value of a parameter for performing the control or a state after the control may be designated. In that case, the input information D21 may include, for example, information specifying control and information indicating a value of a parameter for performing the control or a state after the control. In addition, the input information D21 can include not only information directly indicating the control content for the target device 2 but also information indirectly indicating the control content using the operation content corresponding to the control content, the speech and behavior of the user 1, the image of the target device 2, a similar control command in another model, or the like.

The control command D22 includes information related to control of the target device 2 indicated in a predetermined format in which the target device 2 or an interface requesting control from the target device 2 is discriminable. The control command D22 may include information indicating a control request to the target device 2. The control command D22 is, for example, a control instruction, a control signal, or a control code for the target device 2. In addition, the control command D22 may be, for example, a command described in a format handled by a predetermined controller corresponding to the target device 2.

The device information storage unit 210 stores the device information D23 that is information on the target device 2. Handling of the device information storage unit 210 and the device information D23 is basically similar to that of the device information storage unit 110 and the device information D13 in the first embodiment. Note that the device information D23 in the present embodiment may include, for example, information used for controlling the target device 2. The device information D23 is used, for example, as additional information for the learning model unit 200 to output the control command D22. Hereinafter, in the present embodiment, in particular, information indicating the state of the target device 2 may be referred to as state information D25.

In the present embodiment, the learning model unit 200 may be, for example, a language learning model such as LLM that inputs a natural language and obtains an output result and an operation environment thereof. Furthermore, the learning model unit 200 may be, for example, an image learning model such as a VLM that inputs an image and obtains an output result and an operation environment thereof. Furthermore, the learning model unit 200 may be, for example, a multimodal model that inputs a natural language and an image and obtains an output result and an operation environment thereof. In this case, the input information D21 may be input in text data, image data, a combination of text data and image data, or a data format (sound data, a moving image which is a combination of sound data and image data, and the like) that can be converted into the text data, image data, or a combination of text data and image data. Note that the learning model used in the present embodiment is not limited to the above-described model.

In the present embodiment, in order to simplify the description, there is a case where the components provided corresponding to the learning model unit 200 are described using the reference numbers of the components provided corresponding to the learning model unit 100 as they are, but it should be noted that they are provided only corresponding to the learning model unit 200. The same applies to other embodiments.

In the present embodiment, the input information D21 corresponds to the model input data D101. The control command D22 corresponds to the model output data D103. For example, the learning model unit 200 (in particular, the model control unit 101) may be configured to output the control command D22 corresponding to the input information D21 on the basis of the model information D102 and the model reference information D104 as necessary when receiving the input information D21.

Furthermore, in such a case, the model generation unit 107 provided corresponding to the learning model unit 200 may perform machine learning using, for example, the model learning data D105 including candidates of the input information D21 that can be input to the model control unit 101, and generate or update the model information D102. Furthermore, the model generation unit 107 may generate or update the model information D102, for example, by performing machine learning using the model learning data D105 including a candidate of the input information D21 that can be input to the model control unit 101 and a candidate of the control command D22 corresponding thereto.

Reference number D26 denotes feedback information indicating a control result in the target device 2. Also in the present embodiment, the state information D25 and/or the feedback information D26 may be acquired from the output destination of the model output data D103 and/or the information generated based thereon. For example, the control system 2000 may output the acquired state information D25 and/or feedback information D26 to the user 1, the learning model unit 200, or another device (not illustrated) as information indicating a control result. Furthermore, the control system 2000 can generate the supplementary information D28 for the input/output data of the learning model unit 200 on the basis of the acquired state information D25 and/or feedback information D26, and issue the supplementary information to the user 1, the learning model unit 200, or another device (not illustrated). In addition, the control system 2000 may be configured to return an inquiry D27 to the user 1 when the input information D21 includes unclear or uncertain information. The handling of the inquiry D27 is similar to that of the inquiry D17 of the first embodiment.

FIG. 12 is a configuration diagram illustrating another example of the control system 2000. As illustrated in FIG. 12, the control system 2000 may further include a state acquisition unit 230 that acquires the state information D25 and/or the feedback information D26 and issues the supplementary information D28. The state acquisition unit 230 is similar to the state acquisition unit 130 of the first embodiment.

Also in the present embodiment, the target device 2 is not particularly limited. Although it is assumed that the target device 2 is a device that can actually be controlled by receiving the control command D22, the present invention is not limited thereto when a conversion device that converts various signals such as a controller or a converter is included in relation to the target device 2. In this case, the conversion device only needs to receive the control command D22 to control the target device 2.

In the present embodiment, the input information D21 received by the control system 2000 can be referred to as information on a request (here, the control contents requested to the target device 2 are described) in a work environment, here, an environment in which the target device 2 operates. Therefore, the input information D21 received by the control system 2000 can be regarded as an example of the first information indicating the request in the work environment. In addition, the control command D22 can be regarded as information used for the work (work related to control to the target device 2) corresponding to such input information D21. Hereinafter, the control command D22 output to a predetermined output destination from the operation environment of the learning model to which the model input data based on the input information D21 is input may be referred to as second information.

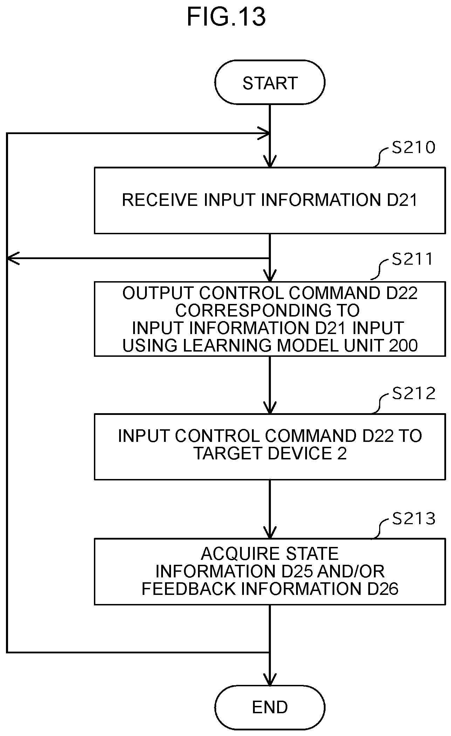

Next, an operation of the control system 2000 of the present embodiment will be described. FIG. 13 is a flowchart illustrating an operation example of the control system 2000.

In the example illustrated in FIG. 13, first, the control system 2000 receives the input information D21 (step S210). For example, the input unit 102 or the input processing unit 201 described above may receive the input information D21. The received input information D21 is input to the learning model unit 200 as the model input data D101.

Next, the control system 2000 performs generation processing of the control command D22 using the learning model unit 200 (step S211). In step S211, the learning model unit 200 (more specifically, the model control unit 101) outputs the control command D22 corresponding to the input information D21 that has been input on the basis of the model reference information D104 including the model information D102 and the input information D21, and the device information D23 as necessary.

In step S211, the learning model unit 200 may generate the control command D22 of binary data from the input information D21 that has been input, for example, using a learning model capable of generating binary data. Furthermore, the learning model unit 200 may generate the control command D22 of text data from the input information D21 that has been input, using, for example, a learning model capable of generating text data. Furthermore, the learning model unit 200 may generate the control command D22 of image data from the input information D21 that has been input, using, for example, a learning model capable of generating image data. Furthermore, the learning model unit 200 may generate the control command D22 of sound data from the input information D21 that has been input, using, for example, a learning model capable of generating sound data.

In step S211, the pre-processing unit 105 and/or the post-processing unit 106 of the learning model unit 200 may further perform the above-described processing.

The control command D22 output from the learning model unit 200 is input to, for example, the target device 2 (step S212). The input of the control command D22 to the target device 2 may be directly input from the control system 2000 (more specifically, the learning model unit 200 or the information processing device 10 serving as an operation environment thereof), or may be indirectly input via a communication network or another device (server, various conversion devices, and the like).

As a result, the target device 2 operates according to the input control command D22.

When there is a change in the state of the target device 2 due to control of the target device 2 or the like as a result of outputting the control command D22, and there is feedback from the target device 2, the control system 2000 may acquire the state information D25 and the feedback information D26 (step S213). Note that the processing in step S213 is not essential and may be omitted as appropriate.

The control system 2000 may repeat the processing of steps S210 to S213 a plurality of times (for example, until the desired control for the target device 2 is completed).

As described above, according to the present embodiment, even if the user 1 does not know a specific control method for the target device 2, the control command D22 can be generated from the input information D21 input from the user 1, and the target device 2 can be controlled on the basis of the generated control command D22. Therefore, it is possible to improve efficiency and sophistication of work related to control of the target device 2.

Furthermore, according to the present embodiment, the device can be controlled to an appropriate state even from ambiguous information.

### Third Embodiment.

Next, the present third embodiment will be described. In the present embodiment, an example of supporting work related to operation of a target device using a learning model will be described.

Hereinafter, for example, it is considered to operate various devices such as an air conditioner, a refrigerator, a television, a lighting, a washing machine, a projector, various sensors, and a communication device in a home or a building. In recent years, even these devices for consumers have advanced functions to be provided, and control has become complicated. Although the controller such as the operation screen and the remote controller is devised so that the complicated control can be easily performed, it is still difficult to memorize all the operations, and there is a case where the desired function cannot be easily reached although the desired function is provided.

In addition, despite the same type of functions, there are many cases where function names provided by models are different, there are differences in detailed functions, or there are differences in control methods, and in a scene where different models are introduced by replacement or the like, it is necessary to memorize these differences from the beginning, which is complicated.

In addition, some devices automatically perform control to an appropriate state by memorizing a past operation history, grasping an operation environment, or the like. However, there is a case where it is difficult to perform accurate control in a scene where a plurality of people gather in a case where an appropriate state varies depending on a person, or in a scene where an appropriate state varies depending on a change in physical condition or the like even for one person.

In such a case, even if the operator does not know a specific operation method or the operator does not know an appropriate state, it is preferable to easily perform the operation for setting the state to a desired state because the work efficiency and the performance are improved.

Note that the scene of operating the device is not limited to the home or building, and the utilization scene of the present embodiment is not limited to the home or building.

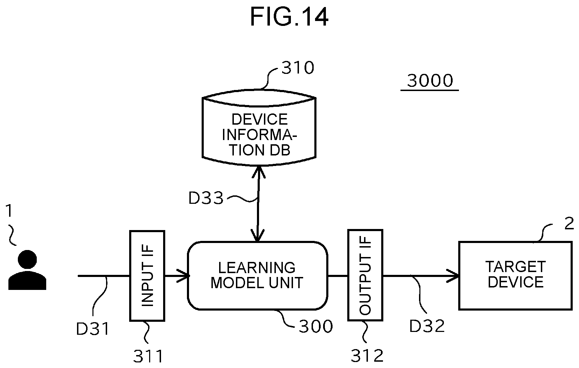

FIG. 14 is a configuration diagram illustrating an example of a control system 3000 according to the third embodiment. A control system 3000 illustrated in FIG. 14 is a control system for operating a device using a learning model, and includes a learning model unit 300, a device information storage unit 310 (referred to as a device information DB in the drawing), an input interface 311 (referred to as an input IF in the drawing), and an output interface 312 (referred to as an output IF in the drawing).

In response to input of input information D31, the learning model unit 300 outputs an operation command D32. In response to input of the input information D31, for example, the learning model unit 300 outputs the operation command D32 on the basis of model information D102. The configuration of the learning model unit 300 may be basically similar to that of the learning model unit 100 in the first embodiment.

In the present embodiment, the learning model unit 300 is a model and an operation environment thereof configured to output the operation command D32 corresponding to the input information D31 in response to input of the input information D31. Furthermore, the learning model unit 300 may be a model and an operation environment thereof configured to generate and output the operation command D32 on the basis of the input information D31, the device information D33, and other information that can be referred to in the learning model unit 300 in response to input of the input information D31.

In the present embodiment, the input information D31 includes information indicating operation contents requested to the target device 2. The input information D31 may be, for example, a text, an image, sound, or a combination thereof indicating an operation content for the target device 2. The input information D31 may be, for example, a text, an image, sound, or a combination thereof indicating a plurality of operation contents for the target device 2. In addition, the input information D31 may include information indicating the content of operation performed continuously in time, and in that case, may be time-series data having a predetermined data structure including a text, an image, sound, or a combination thereof indicating the operation content as described above. It is assumed that the operation content is indicated on the assumption that the operation content matches the input format of the model used by the learning model unit 300, but this is not the case when error processing, correction processing, or conversion processing is included in the preceding stage of the learning model unit 300.

As an example of how to indicate the operation content in the input information D31, an operation to be performed on the target device 2 may be specified, and then a value of a parameter for performing the operation or a state after the operation may be specified. In that case, the input information D31 may include, for example, information specifying operation and information indicating a value of a parameter for performing the operation or a state after the operation. The value of the parameter for performing the operation may include, for example, a value related to the type (ON/OFF or the like), orientation, amount, and time of the operation. In addition, the input information D31 can include not only information directly indicating the operation content for the target device 2 but also information indirectly indicating the operation content using the control content corresponding to the operation content, the speech and behavior of the user 1, the image of the target device 2, a similar operation command in another model, or the like.

The operation command D32 includes information related to the operation of the target device 2 indicated in a predetermined format in which the target device 2 or an interface (including a person) requesting the control from the target device 2 is discriminable. The operation command D32 may include information indicating an operation request or a control request to the target device 2. The operation command D32 is, for example, an operation command, an operation signal, an operation code, a control instruction, a control signal, or a control code for the target device 2. In addition, the operation command D32 may be, for example, a command described in a format handled by a predetermined controller corresponding to the target device 2. The operation command D32 can be said to be a concept obtained by adding information regarding the operation to the above-described control command D22. For example, when the interface is a person, that is, when control is requested to the target device 2 via the person, the operation command D32 may be information indicating an operation method of the target device 2 indicated in a format that is discriminable by the person.

The device information storage unit 310 stores the device information D33 that is information on the target device 2. Handling of the device information storage unit 310 and the device information D33 is basically similar to that of the device information storage unit 110 and the device information D13 in the first embodiment. Note that the device information D33 in the present embodiment may include, for example, information used for operating the target device 2. The device information D33 can include, for example, information indicating a procedure of an operation actually performed on the target device 2 for the operation content. Furthermore, the device information D33 can include, for example, a command, a signal, a code, and the like issued to the target device 2. The device information D33 is used, for example, as additional information for the learning model unit 300 to output the operation command D32. Hereinafter, in the present embodiment, in particular, information indicating the state of the target device 2 may be referred to as state information D35.

The input interface 311 is an interface that receives input information D31 from the user 1 and inputs the input information D31 to the learning model unit 300. The input interface 311 may be, for example, an interface that converts the input information D31 input from the user 1 into data that matches the input of the learning model unit 300 and outputs the data. Note that the input interface 311 may be provided as an example of the input unit 102 described above, for example.

The output interface 312 is an interface that receives the operation command D32 from the learning model unit 300 and outputs the operation command D32 to a predetermined output destination. Note that the output interface 312 may be provided, for example, as an example of the output unit 103 described above. The output interface 312 may be, for example, an interface that converts the operation command D32 output from the learning model unit 300 into data matching a predetermined output destination and outputs the data. In the present embodiment, the output destination of the output interface 312 can include the target device 2, a controller 4 (not illustrated), a predetermined display 7 (not illustrated), and the operation terminal of the user 1 (not illustrated).

In the present embodiment, the learning model unit 300 may be, for example, a language learning model such as LLM that inputs a natural language and obtains an output result and an operation environment thereof. Furthermore, the learning model unit 300 may be, for example, an image learning model such as a VLM that inputs an image and obtains an output result and an operation environment thereof. Furthermore, the learning model unit 300 may be, for example, a multimodal model that inputs a natural language and an image and obtains an output result and an operation environment thereof. In this case, the input information D31 may be input in text data, image data, a combination of text data and image data, or a data format (sound data, a moving image which is a combination of sound data and image data, and the like) that can be converted into the text data, image data, or a combination of text data and image data. Note that the learning model used in the present embodiment is not limited to the above-described model.

In the present embodiment, the input information D31 corresponds to the model input data D101. The operation command D32 corresponds to the model output data D103. For example, the learning model unit 300 (in particular, the model control unit 101) may be configured to output the operation command D32 corresponding to the input information D31 on the basis of the model information D102 and the model reference information D104 as necessary when receiving the input information D31.

Furthermore, in such a case, the model generation unit 107 provided corresponding to the learning model unit 300 may perform machine learning using, for example, the model learning data D105 including candidates of the input information D31 that can be input to the model control unit 101, and generate or update the model information D102. Furthermore, the model generation unit 107 may generate or update the model information D102, for example, by performing machine learning using the model learning data D105 including a candidate of the input information D31 that can be input to the model control unit 101 and a candidate of the operation command D32 corresponding thereto.

Although not illustrated, also in the present embodiment, the state information D35 and/or the feedback information D36 may be acquired from the output destination of the model output data D103 of the learning model unit 300 and/or the information generated based thereon. For example, the control system 3000 may output the acquired state information D35 and/or feedback information D36 to the user 1, the learning model unit 300, or another device (not illustrated) as information indicating a response result. In addition, the control system 3000 may be configured to return an inquiry D37 to the user 1 when the input information D31 includes unclear or uncertain information. Furthermore, the control system 3000 can generate the supplementary information D38 for the input/output data of the learning model unit 300 on the basis of the acquired state information D35 and/or feedback information D36, and issue the supplementary information to the user 1, the learning model unit 300, or another device (not illustrated). Handling of the state information D35, the feedback information D36, the inquiry D37, and the supplementary information D38 may be basically similar to that in the first embodiment.

In addition, the control system 3000 may further include a state acquisition unit 330 (not illustrated) that acquires the state information D35 and/or the feedback information D36 and issues the supplementary information D38 as necessary. The state acquisition unit 330 is similar to the state acquisition unit 130 of the first embodiment.

Also in the present embodiment, the target device 2 is not particularly limited. It is assumed that the target device 2 is a device capable of receiving the operation command D32 and performing control corresponding to the operation content indicated by the operation command D32, but the present invention is not limited thereto when the controller 4, a conversion device that converts various signals such as a converter, or an operator is included in relation to the target device 2. In this case, the conversion device or the operator only needs to receive the operation command D32 and operate the target device 2.

In the present embodiment, the input information D31 received by the control system 3000 can be referred to as information on a request (here, the operation contents requested to the target device are described) in a work environment, here, an environment in which the target device 2 operates. Therefore, the input information D31 received by the control system 3000 can be regarded as an example of the first information indicating the request in the work environment. In addition, the operation command D32 can be regarded as information used for the work (work related to operation to the target device 2) corresponding to such input information D31. Hereinafter, the operation command D32 output to a predetermined output destination from the operation environment of the learning model to which the model input data based on the input information D31 is input may be referred to as second information.

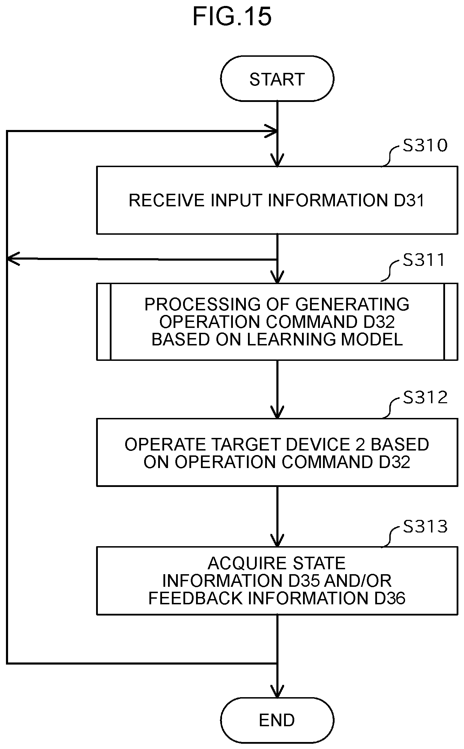

Next, an operation of the control system 3000 of the present embodiment will be described. FIG. 15 is a flowchart illustrating an operation example of the control system 3000.

In the example illustrated in FIG. 15, first, the input interface 311 of the control system 3000 receives the input information D31 (step S310). The received input information D31 is input to the learning model unit 300 as the model input data D101.

Next, the control system 3000 performs generation processing of the operation command D32 using the learning model unit 300 (step S311). In step S311, the learning model unit 300 (more specifically, the model control unit 101) generates and outputs the operation command D32 corresponding to the input information D31 that has been input on the basis of the model reference information D104 including the model information D102 and the input information D31, and the device information D33 as necessary.

In step S311, the learning model unit 300 may generate the operation command D32 of binary data from the input information D31 that has been input, for example, using a learning model capable of generating binary data. Furthermore, the learning model unit 300 may generate the operation command D32 of text data from the input information D31 that has been input, using, for example, a learning model capable of generating text data. Furthermore, the learning model unit 300 may generate the operation command D32 of image data from the input information D31 that has been input, using, for example, a learning model capable of generating image data. Furthermore, the learning model unit 300 may generate the operation command D32 of sound data from the input information D31 that has been input, using, for example, a learning model capable of generating sound data.

In step S311, the pre-processing unit 105 and/or the post-processing unit 106 of the learning model unit 300 may further perform the above-described processing.

The operation command D32 output from the learning model unit 300 is output to a predetermined output destination via the output interface 312, for example. Here, the predetermined output destination may be the target device 2, the controller 4, the predetermined display 7, or an operation terminal (not illustrated) of the user 1. In response to input of the operation command D32 to a predetermined output destination, the target device 2 is operated according to the input operation command D32 (step S312).

For example, the output interface 312 may output the operation command D32 toward the target device 2. In this case, the target device 2 that has received the operation command D32 (for example, an operation command, an operation signal, an operation code, a control instruction, a control signal, a control code, or the like) may execute actual control in accordance with the operation command D32. The output interface 312 may output the operation command D32 to the controller 4 corresponding to the target device 2. In this case, the controller 4 that has received the operation command D32 (indirect control information for the target device 2, such as a command, an operation command, an operation signal, and an operation code for the controller 4, for example) may operate the target device 2 in accordance with the operation command D32. The controller 4 may operate the target device 2 by outputting direct control information such as a control code to the target device 2 based on the received control information indicated by the operation command D32. Here, the controller 4 may be, for example, an operation panel provided in the target device 2 or a remote controller corresponding to the target device 2 directly operated by the user 1. The controller 4 includes a controller unique to the target device 2 and a general-purpose controller. In addition, the output interface 312 may output the operation command D32 toward the operation terminal of the user 1 or a predetermined display. In this case, the operation terminal or the display of the user 1 that has received the operation command D32 (for example, information indicating an operation method, and the like) displays the operation command D32. Then, the user 1 may operate the target device 2 or the controller 4 with reference to the displayed operation command D32.

The input of the operation command D32 to the output destination may be directly input from the control system 3000 (more specifically, the learning model unit 300 or the information processing device 10 serving as an operation environment thereof), or may be indirectly input via a communication network or another device (server, various conversion devices, and the like).

As a result, the target device 2 operates in accordance with the operation command D32.

When there is a change in the state of the target device 2 due to operation of the target device 2 or the like as a result of outputting the operation command D32, and there is feedback from the target device 2, the control system 3000 may acquire the state information D35 and the feedback information D36 (step S313). Note that the processing in step S313 is not essential and may be omitted as appropriate.

The control system 3000 may repeat the processing of steps S310 to S313 a plurality of times (for example, until the desired operation for the target device 2 is completed).

As described above, according to the present embodiment, even if the user 1 does not know a specific operation method for the target device 2, the operation command D32 can be generated from the input information D31 input from the user 1, and the target device 2 can be operated on the basis of the generated operation command D32. Therefore, it is possible to improve efficiency and sophistication of work related to operation of the target device 2.

Furthermore, according to the present embodiment, the device can be operated to an appropriate state even from ambiguous information. Furthermore, according to the present embodiment, the device can be operated to an appropriate state without depending on the device and without learning an operation method of the device.

### Modification 3-1.

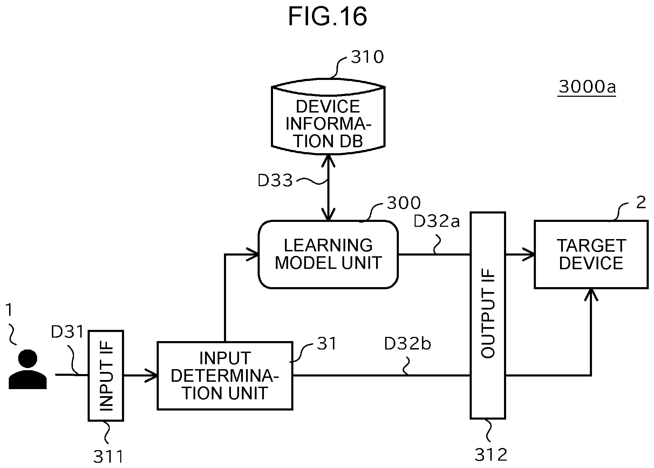

Next, a modification of the control system 3000 will be described. FIG. 16 is a configuration diagram illustrating an example of a control system 3000a which is a modification of the control system 3000 according to the present embodiment. Note that the same elements as those of the control system 3000 are denoted by the same reference signs, and description thereof is omitted.

The control system 3000a illustrated in FIG. 16 further includes an input determination unit 31. Upon receiving the input information D31, the input determination unit 31 is a means that analyzes the input information D31 and switches the control destination for the input information D31. In the present modification, the input determination unit 31 switches the control destination for the input information D31 between the learning model unit 300 and the output interface 312.

The input determination unit 31 may switch the control destination for the input information D31 depending on, for example, whether or not the input information D31 matches the instruction rule of the operation on the target device 2. When the input information D31 matches the instruction rule of the operation on the target device 2, the input determination unit 31 may directly input the input information D31 to the output interface 312. On the other hand, when the input information D31 does not match the instruction rule of the operation on the target device 2, the input determination unit 31 may input the input information D31 to the learning model unit 300.

Whether or not to match the instruction rule of the operation may be determined using, for example, a model described on a rule basis. Here, the input determination unit 31 may be a learning model relatively lightweight with respect to the learning model unit 300.

Hereinafter, in order to distinguish the information input in the output interface 312, the operation command D32 output from the learning model unit 300 may be referred to as an operation command D32a, and the input information D31 output to the output interface 312 may be referred to as an operation command D32b.

In the present example, the output interface 312 may be any interface that receives the operation command D32a or the operation command D32b and outputs the operation command to a predetermined output destination.

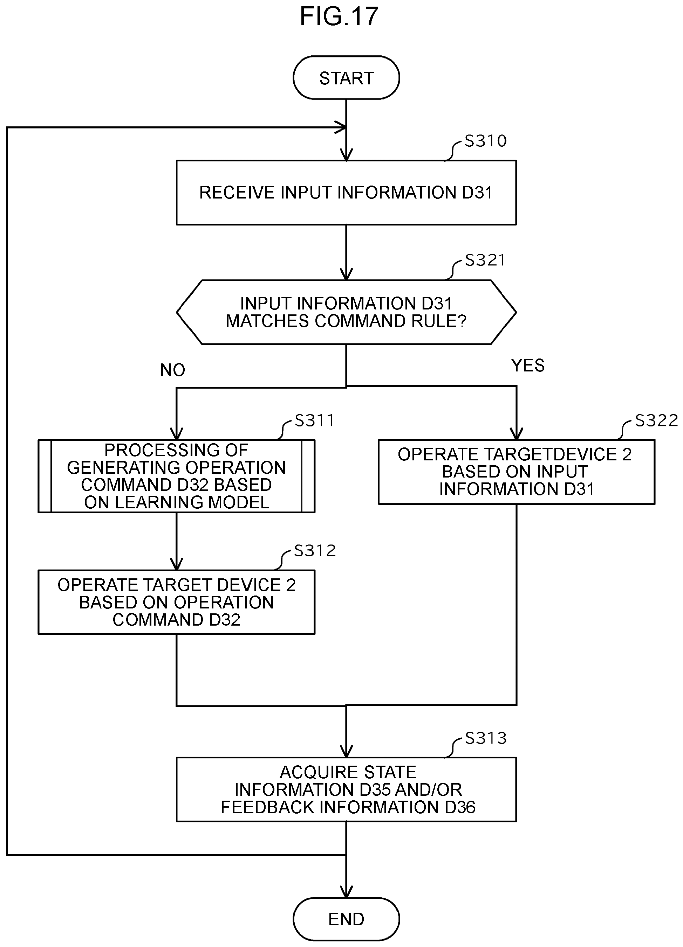

Next, an operation of the control system 3000a of the present modification will be described. FIG. 17 is a flowchart illustrating an operation example of the control system 3000a.

In the example illustrated in FIG. 17, first, the input interface 311 of the control system 3000a receives the input information D31 (step S310). The received input information D31 is input to the input determination unit 31.

Next, the input determination unit 31 determines whether the input information D31 matches the instruction rule of the operation on the target device 2 (step S321). Here, when it is determined that the input information D31 matches the instruction rule of the operation on the target device 2 (Yes in step S 321), the input information D31 is input to the output interface 312 (the process proceeds to step S 322). On the other hand, when it is determined that the input information D31 does not match the instruction rule of the operation on the target device 2 (No in step S 321), the input information D31 is input to the learning model unit 300 (the process proceeds to step S 311).

The processing in steps S311 to S313 is similar to that in the example illustrated in FIG. 15.

In step S322, the output interface 312 outputs the input information D31 to a predetermined output destination as the operation command D32b. As a result, the target device 2 operates in accordance with the operation command D32b.

Other points may be similar to other control systems according to the present embodiment.

As described above, according to the present modification, when the input from the user 1 matches the instruction rule of the operation on the target device 2, the target device 2 can be operated according to the input, and when the input does not match, the target device 2 can be operated using the learning model. Therefore, it is possible to further improve the efficiency of work related to the operation of the target device 2.

### Modification 3-2.

Next, another modification of the control system 3000 will be described. In the present modification, an operation command including arbitration of a plurality of inputs is generated using a learning model.

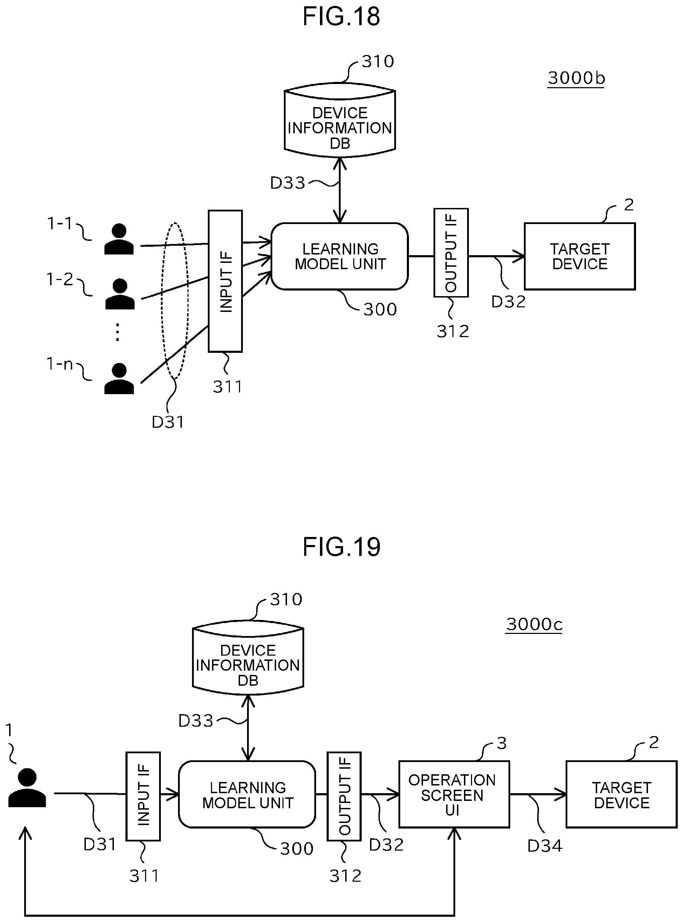

FIG. 18 is a configuration diagram illustrating an example of a control system 3000b which is a modification of the control system 3000 according to the present embodiment. Note that the same elements as those of the control system 3000 are denoted by the same reference signs, and description thereof is omitted.

In the control system 3000b illustrated in FIG. 18, the input interface 311 receives the input information D31 from the plurality of users 1.

The input interface 311 receives the input information D31 from the plurality of users 1 and inputs the input information D31 to the learning model unit 300. At this time, the input interface 311 may receive the input information D31 to which the information of the user 1 who is the input source is attached, or the input interface 311 may determine the user 1 who is the input source, attach the information of the input source, and then receive the input information D31, or may receive the input information D31 without doing anything.

The learning model unit 300 may be a model and an operation environment thereof configured to output the operation command D32 corresponding to the input information D31 group in response to input of the input information D31 group received by the input interface 311. The learning model unit 300 may be a model and an operation environment thereof configured to generate and output the operation command D32 on the basis of the input information D31 group, the device information D33, and other information that can be referred to in the learning model unit 300 in response to input of the input information D31 group.

For example, the learning model unit 300 may perform processing of extracting a suitable solution on the language space (more specifically, on a feature vector space having language space information) by using a language learning model such as LLM that inputs a natural language and obtains an output result, thereby generating and outputting the operation command D32 that is a compromise for different operation contents indicated by the input information D31 group. At this time, the learning model unit 300 may refer to the history of the input information D31 for each user 1 as the input source and/or the history of the operation command D32 for each user 1 as the input source.

Other points may be similar to other control systems according to the present embodiment.

As described above, according to the present modification, even in a case where information regarding different operation contents is input from a plurality of users, it is possible to generate a more appropriate operation command D32 in which these contents are arbitrated using the learning model unit 300, and thus, it is possible to further enhance the functionality of work related to the operation of the target device 2.

### Modification 3-3.

Next, another modification of the control system 3000 will be described. In the present modification, the operation screen user interface is generated using the learning model.

FIG. 19 is a configuration diagram illustrating an example of a control system 3000c which is a modification of the control system 3000 according to the present embodiment. Note that the same elements as those of the control system 3000 are denoted by the same reference signs, and description thereof is omitted.

The control system 3000c illustrated in FIG. 19 further includes an operation screen user interface 3 (in the drawing, denoted by operation screen UI). In addition, the learning model unit 300 generates an operation screen for actually operating the target device 2 with the operation content corresponding to the input information D31 as the operation command D32.

The operation screen generated by the learning model unit 300 may be, for example, a screen application programming interface (API) having a function of receiving an operation input from the user together with the description of the operation content and outputting a control command D34 such as a control code according to the received operation input. Here, the output of the control code and the like according to the operation input also includes an aspect in which a plurality of control commands D34 are sequentially output according to one operation input. In addition, the operation screen may be a screen API including operation explanation, operation input reception, and control command output corresponding to two or more different operation contents. For example, the learning model unit 300 may extract operation information indicating two or more different operation contents as the operation command D32 corresponding to the input information D31, and generate a screen API including operation input reception and control command output corresponding to each operation information.

Furthermore, the operation screen generated by the learning model unit 300 may be one in which the display mode of the existing operation screen is changed such that the operation portion corresponding to the corresponding operation content is displayed in a highlighted manner, the operation function is displayed in a restricted manner, and the position and form (shape, size, color, etc.) of the UI component on the screen are changed and displayed.

The operation screen user interface 3 is an interface that displays an operation screen for the target device 2 and receives an input related to a user operation on the operation screen. The operation screen user interface 3 may be implemented by, for example, a controller including a touch panel display, an operation button, and a display unit. Furthermore, the operation screen user interface 3 may be implemented by a display device such as a display that cooperates with an operation input device such as a mouse.

In addition, the output interface 312 in the present modification outputs the operation command D32 (operation screen) output from the learning model unit 300 to the operation screen user interface 3.

Furthermore, in the present modification, the learning model unit 300 may have a function of interactively confirming an expected operation of the user 1. In such a case, for example, when receiving information requesting reacquisition of the operation command D32 after presenting the operation screen as the operation command D32, the learning model unit 300 may change a part of the input information, a part of the model parameters, or a reference destination of the reference information, and then reacquire the operation command D32.

As described above, in the present modification, since the operation screen on which the treatment (construction of the screen API, change of the display mode, or the like) has been performed so that the desired operation can be easily or intelligibly performed can be generated using the learning model unit 300, it is possible to further improve the efficiency of the work related to the operation of the target device 2. In addition, according to the present modification, since the user 1 can perform an actual operation while confirming the description of the operation command generated by the learning model unit 300 and the like, the operation can be performed without any mistake.

### Modification 3-4.

Next, another modification of the control system 3000 will be described. In the present modification, the learning model further uses the environment information to generate the operation command.

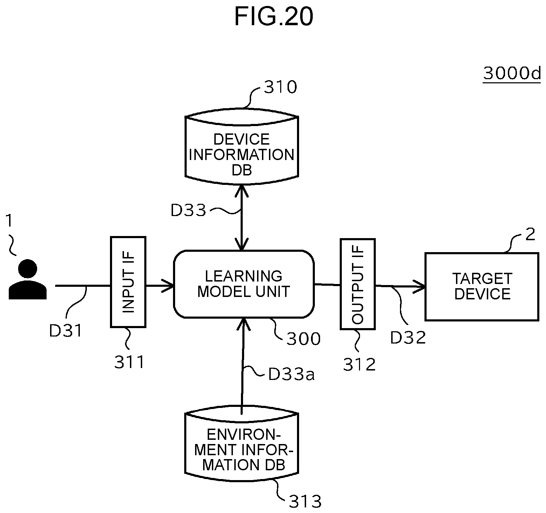

FIG. 20 is a configuration diagram illustrating an example of a control system 3000d which is a modification of the control system 3000 according to the present embodiment. Note that the same elements as those of the control system 3000 are denoted by the same reference signs, and description thereof is omitted.

The control system 3000d illustrated in FIG. 20 further includes an environment information storage unit 313 (in the drawing, denoted by environment information DB).

The environment information storage unit 313 stores environment information D33a that is information on the environment of the operation destination of the target device 2. The environment information D33a may include information on a space in which the target device 2 operates. In the present modification, information on an object or a person existing in a space in which the target device 2 is operated and the user 1 who is an operator of the target device 2 are also included in the environment. Therefore, the environment information D33a may include information regarding the object, the person, or the user 1.

The environment information D33a may include, for example, information such as an attribute, a temperature, a position, a posture, and a heartbeat of a person as information regarding the person. Furthermore, the environment information D33a may include, for example, information such as location, temperature, humidity, and brightness of the space as information regarding the space. Furthermore, in a case where such information regarding a space or a person changes, the environment information D33a may hold information indicating the transition. Here, the information indicating the transition is also referred to as time series data or history information. The environment information D33a may be configured as a part of the model reference information D104 of the learning model, for example.

The environment information D33a may be acquired by, for example, a sensor (not illustrated) or the like.

For example, the learning model unit 300 may be a model and an operation environment thereof configured to generate and output the operation command D32 on the basis of the input information D31, the device information D33, the environment information D33a, and other information that can be referred to in the learning model unit 300 in response to input of the input information D31.

As described above, according to the present modification, since the learning model can generate the operation command D32 using the environment information D33a related to the space in which the target device 2 is operated, it is possible to further enhance the function of the work related to the operation of the target device 2.

### Modification 3-5.

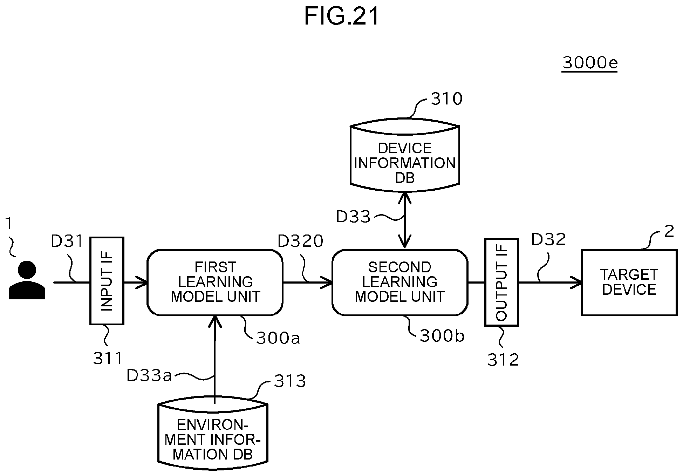

Next, another modification of the control system 3000 will be described. In the present modification, an operation command is generated by combining two learning models. FIG. 21 is a configuration diagram illustrating an example of a control system 3000e which is a modification of the control system 3000 according to the present embodiment. Note that the same elements as those of the control system 3000 are denoted by the same reference signs, and description thereof is omitted.

A control system 3000e illustrated in FIG. 21 includes a learning model unit 300a as a first learning model unit 300 and a learning model unit 300b as a second learning model unit 300 instead of the learning model unit 300 illustrated in FIG. 20.

In response to input of the input information D31, the learning model unit 300a outputs the operation information D320. The learning model unit 300a may be a model and an operation environment thereof configured to generate and output the operation information D320 on the basis of at least the input information D31 and the environment information D33a in response to input of the input information D31.

Here, the operation information D320 includes information regarding the operation of the target device 2 indicated in a predetermined format discriminable by the learning model unit 330b in the subsequent stage. Here, the operation information D320 may be information obtained by supplementing (Including addition, modification, cancellation) the operation content indicated by the input information D31 according to the environment information D33a. The operation information D320 may be information in which the operation content indicated by the input information D31 or the expression thereof is changed in accordance with the situation of the space in which the target device 2 is driven. The learning model unit 300a may be a model that mainly grounds the input information D31.

For example, even if the desired operation is the same, it is conceivable that a difference occurs in the language expression or a difference occurs in recognition for events depending on the environment in which the target device 2 is driven. For example, the operation content indicated by the input information D31 may be different depending on a dialect or a habit of wording, use of an in-house term or a household word, a difference in perception such as heat/cold, or the like.

The learning model unit 300a serves to absorb, for example, such differences in language expression and/or differences in recognition for events and modify them to more generalized or more specific content. The learning model unit 300a may be a local learning model that obtains an output result on the basis of local information such as limitation of a reference destination database.

The operation information D320 generated by the learning model unit 300a is input to the learning model unit 300b.

The learning model unit 300b may be basically similar to the learning model unit 300 described above. However, instead of the input information D31, the operation information D320 generated by the learning model unit 300a is input.

In response to input of the operation information D320, the learning model unit 300b outputs an operation command D32. The learning model unit 300b may be a model and an operation environment thereof configured to generate and output the operation command D32 on the basis of the operation information D320, the device information D33, and other information that can be referred to in the learning model unit 300b in response to input of the operation information D320. The learning model unit 300b may be a global learning model that obtains an output result on the basis of global information such as being freely accessible to an external network.

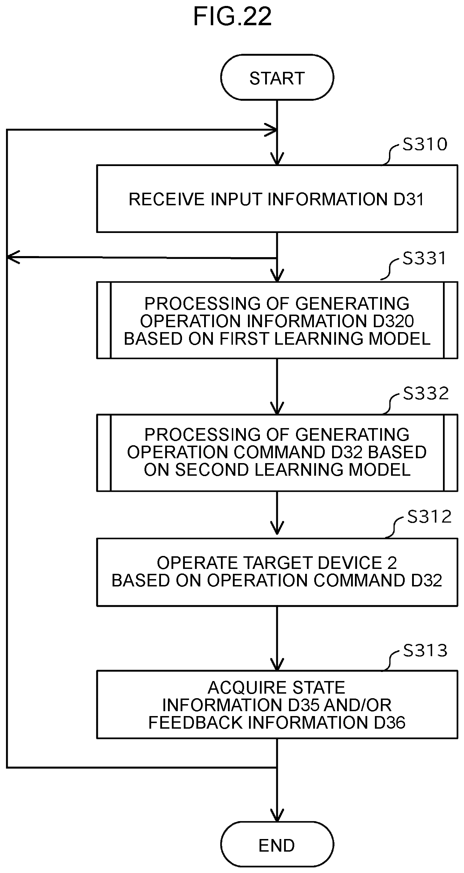

FIG. 22 is a flowchart illustrating an operation example of the present modification. In the example illustrated in FIG. 22, when the input interface 311 of the control system 3000e receives the input information D31 in step S310, the input information D31 is input to the learning model unit 300a.

Next, the control system 3000e performs generation processing of the operation information D320 using the learning model unit 300a (step S331). In step S331, the learning model unit 300a (more specifically, the model control unit 101) generates and outputs the operation information D320 corresponding to the input information D31 that has been input on the basis of the model reference information D104 including the model information D102 and the input information D31, and the environment information D33a as necessary. The operation information D320 output from the learning model unit 300a is input to the learning model unit 300b.

Next, the control system 3000e performs generation processing of the operation command D32 using the learning model unit 300b (step S332). In step S332, the learning model unit 300b (more specifically, the model control unit 101) generates and outputs the operation command D32 corresponding to the operation information D320 on the basis of the model reference information D104 including the model information D102 and the input operation information D320, and the device information D33 as necessary.

Subsequent processing may be similar to that in other control systems according to the present embodiment.

As described above, according to the present modification, the operation command D32 can be generated after the input information D31 input from the user 1 is changed to more generalized or embodied contents by absorbing the difference in language expression and/or the difference in recognition for the event, and thus, it is possible to further enhance the functionality of the work related to the operation of the target device 2.

Note that, also in the configuration described in Modification 3-4, the learning model unit 300 can generate the operation command D32 in which differences in language expression and/or differences in recognition for events are leveled on the basis of the environment information D33a, the device information D33, the model reference information D104 including the past operation history, and the like. However, according to the present modification, since the role of the learning model can be clearly divided into absorption of a difference in expression and conversion into an operation command, the learning model can be made to learn in a specialized manner, and a compact design such as suppression of the scale of learning can be made.

### Fourth Embodiment.

Next, the present fourth embodiment will be described. In the present embodiment, an example of assisting a work related to monitoring of a certain work situation using a learning model will be described.

For example, it is considered to monitor an anomaly of a factory automation (FA) system including a control device such as a robot or a PLC in a factory. For example, in a case where there is a clear installation error in the target workpiece of the control device, an existing monitoring algorithm based on a rule or the like can cope with the installation error. However, a case where an anomaly is found in a subsequent process due to a slight installation error may be considered. In such a case, for example, even if analysis or the like is performed using anomaly detection as a trigger, it is difficult to accurately grasp the situation and acquire the improvement method.

In the present embodiment, by supporting work related to monitoring of a work environment in which such cases can be assumed to occur that an occurrence situation does not match an existing rule and it is difficult to investigate a cause, such as a case where a relatively small defect spreads to cause a large abnormality, efficiency and performance of the monitoring work are improved.

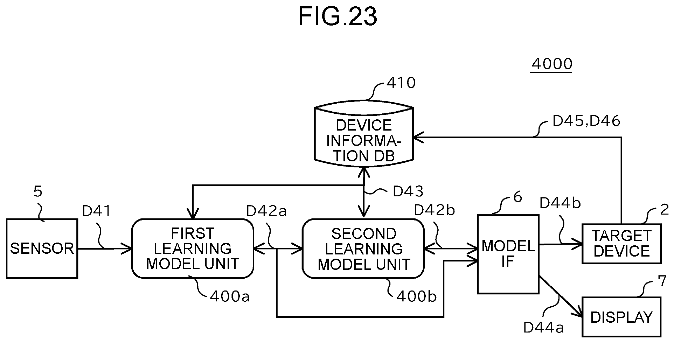

FIG. 23 is a configuration diagram illustrating an example of a control system 4000 according to the fourth embodiment. A control system 4000 illustrated in FIG. 23 is a control system for monitoring a specific work situation using a learning model, and includes a sensor 5, a learning model unit 400a, a learning model unit 400b, a device information storage unit 410 (referred to as a device information DB in the drawing), a model interface 6 (referred to as a model IF in the drawing), and a display 7.

The sensor 5 acquires data indicating the situation of the work to be monitored. Hereinafter, data acquired by the sensor 5 is referred to as sensor data. The sensor data may be, for example, image data obtained by capturing a state of work to be monitored. Furthermore, the sensor data may be, for example, sound data obtained by recording a state of work to be monitored. Furthermore, the sensor data may be, for example, measurement data obtained by measuring a state such as a position of a person or an object performing a work to be monitored.

It is assumed that the acquisition of the sensor data by the sensor 5 is always performed, but may be performed on the basis of, for example, a trigger given by a person or another monitoring system. The sensor data acquired by the sensor 5 is input to the learning model unit 400a as input information D41. Furthermore, the sensor data itself serving as the input information D41 may be given from a person or another monitoring system. In such a case, the sensor 5 can be omitted.

In response to input of the input information D41, the learning model unit 400a outputs an analysis result D42a. For example, in response to input of the input information D41, the learning model unit 400a outputs the analysis result D42a on the basis of the model information D102. The configuration of the learning model unit 400a may be basically similar to that of the learning model unit 100 in the first embodiment.

In the present embodiment, the learning model unit 400a is a model and an operation environment thereof configured to output the analysis result D42a corresponding to the input information D41 in response to input of the input information D41. In addition, the learning model unit 400a may be, for example, a model and an operation environment thereof configured to, in response to input of the input information D41, generate and output the analysis result D42a on the basis of the input information D41, device information D43, and other information (model reference information D104 and the like) that can be referred to in the learning model unit 400a. Here, the learning model unit 400a may refer to and use information regarding the work of the monitoring target as the model reference information D104. The information regarding the work to be monitored may be, for example, information indicating a position, a person, an object, a procedure, a condition, and the like to perform the work. For example, the learning model unit 400a may use, as the model reference information D104, data of a manual in which conditions, installation environments, operation procedures, and the like of devices used for work are described.

In the present embodiment, the input information D41 includes information indicating the situation of the work to be monitored. Here, the work to be monitored includes one or more works by a person or a device. The input information D41 may be, for example, a measurement value, an image, sound, or a combination thereof indicating a situation of work to be monitored. The input information D41 may be, for example, a measurement value, an image, sound, or a combination thereof indicating a situation of a plurality of works to be monitored. Furthermore, the input information D41 may include information indicating a situation of work that is performed continuously in time, and in that case, may be time-series data having a predetermined data structure including a measurement value, an image, sound, or a combination thereof indicating the situation as described above. It is assumed that the work situation is indicated on the assumption that the work situation matches the input format of the model used by the learning model unit 400a, but this is not the case when error processing, correction processing, or conversion processing is included in the preceding stage of the learning model unit 400a.

The analysis result D42a includes information indicating a situation analysis result obtained by analyzing the work situation indicated by the input information D41. The information indicating the situation analysis result may be information indicating an object (environment) present and/or an event occurring in the work situation indicated by the input information D41. The information indicating the situation analysis result can be regarded as information indicating the interpretation of the work situation indicated by the input information D41. The analysis result D42a may be, for example, a text indicating interpretation of the work situation indicated by the input information D41. Furthermore, the analysis result D42a may be, for example, a text that focuses on a portion different from the situation at the normal time in the work situation indicated by the input information D41 and indicates the interpretation of the portion. Note that the format of the analysis result D42a may be other than text. The format of the analysis result D42a is not particularly limited as long as it is described in a predetermined format that is discriminable by the learning model unit 400b in the subsequent stage, and may be, for example, a text, an image, sound, or a combination thereof.

Examples of interpretation of the work situation include expressing an object present in the work situation by using an attribute of the object, expressing an event that has occurred in the work situation in a predetermined syntax form such as 5W1H or 7W1H, or further summarizing such a concrete expression. In addition, the work performed in the work situation is decomposed into a plurality of viewpoints and interpreted to be expressed for each viewpoint, and in a case where the work performed in the work situation includes a plurality of small works or steps, the target work is decomposed into small work units or step units and described for each small work or step. It can be said that the analysis result D42a is obtained by further adding expression in a predetermined format to the embodying, subdivision, and/or singular point extraction for the work situation indicated by the input information D11. As described above, in the analysis result D42a, the work situation is easily understood and expressed in an organized state.

In response to input of the analysis result D42a, the learning model unit 400b outputs the analysis result D42b. For example, in response to input of the analysis result D42a, the learning model unit 400b outputs the analysis result D42b on the basis of the model information D102. The configuration of the learning model unit 400b may be basically similar to that of the learning model unit 100 in the first embodiment.

In the present embodiment, the learning model unit 400b is a model and an operation environment thereof configured to output the analysis result D42b corresponding to the analysis result D42a in response to input of the analysis result D42a. In addition, the learning model unit 400b may be a model and an operation environment thereof configured to, in response to input of the analysis result D42a, generate and output the analysis result D42b on the basis of the analysis result D42a, device information D43, and/or other information (model reference information D104 and the like) that can be referred to in the learning model unit 400b.

The analysis result D42b includes information indicating a work situation improvement method derived from the work situation analysis result by the learning model unit 400a. The information indicating the method for improving the work situation may be information indicating a recovery method for normally recovering an abnormal state, or may be information indicating a method for solving a problem in a case where some problem occurs in an environment (work environment) in which work to be monitored is being performed, such as a case where a person is in trouble or a case where a device is stopped.

The information indicating the improvement method may be, for example, a text, an image, or a sound indicating the method, or may be a control command (for example, an instruction, a control signal, a control code, and the like) for a device (target device 2) to which the method is to be implemented, a procedure manual describing the method, a sequence diagram, a source code, an execution code, or a controller command for causing a controller to execute the method. The information indicating the improvement method may be text indicating the method, an image, sound, data described in a predetermined design language, a control description (including source code and information described in a predetermined programming platform language), information described in another platform language, a control command (a control instruction, a control signal, a control code, and a controller command), an execution code, and a combination of two or more elements thereof. Examples of the predetermined design language include, but are not limited to, Unified Modeling Language (UML).

Hereinafter, the learning model unit 400a may be referred to as a first learning model unit 400, and the analysis result D42a may be referred to as a first analysis result D42. Hereinafter, the learning model unit 400b may be referred to as a second learning model unit 400, and the analysis result D42b may be referred to as a second analysis result D42.

As already described, the analysis result D42a includes information indicating a situation analysis result of the work situation indicated by the input information D41. Therefore, the learning model unit 400b may be a model and an operation environment thereof configured to output the analysis result D42b corresponding to the situation analysis result indicated by the analysis result D42a. Here, in a case where the information indicating the situation analysis result is a text that explains the work situation indicated by the input information D41, the learning model unit 400b may be a model configured to output the analysis result D42b corresponding to the text that explains the work situation and an operation environment thereof.

Handling of the device information storage unit 410 and the device information D43 is basically similar to that of the device information storage unit 110 and the device information D13 in the first embodiment. In the present embodiment, the device information storage unit 410 stores, as the target device 2, the device information D43 that is information on a device involved in a work to be monitored. Here, the devices related to work include devices required for deriving the situation analysis and the improvement method widely described above. More specifically, not only a device used for the work but also a device that affects a person or a device that performs the work are included. The device that affects the person or device performing the work may more specifically be a device that causes a change directly or indirectly to the person or device performing the work. Examples thereof include a device directly used for the work (including various machines such as a processing machine and a conveyance machine, and tools such as a work table and a tool), a device that controls a device directly used for the work (power supply, relay, switch, controller, etc.), and a device that brings about a change in a working environment (lighting equipment, air conditioning equipment, vacuum cleaner, cleaner, and the like).

The device information D43 is used, for example, as additional information for the learning model unit 400a and/or the learning model unit 400b to output the model output data D103 (analysis result D42a, analysis result D42b). Hereinafter, in the present embodiment, in particular, information indicating the state of the target device 2 may be referred to as state information D45.

In the present embodiment, the learning model unit 400a may be an image learning model such as a VLM that inputs an image and obtains an output result and an operation environment thereof. In addition, the learning model unit 400a may be, for example, a multimodal model that inputs a natural language and an image and obtains an output result and an operation environment thereof. In addition, the learning model unit 400b may be, for example, a language learning model such as LLM that inputs a natural language and obtains an output result and an operation environment thereof. In this case, the input information D41 may be input in text data, image data, a combination of text data and image data, or a data format (sound data, a moving image which is a combination of sound data and image data, and the like) that can be converted into the text data, image data, or a combination of text data and image data. Note that the learning model used in the present embodiment is not limited to the above-described model.

The model interface 6 is an interface that outputs model output data (analysis result D42a and analysis result D42b) to a predetermined output destination when the model output data is received from the learning model unit 400a and the learning model unit 400b. The model interface 6 may be, for example, an interface that converts model output data output from the learning model unit 400a and the learning model unit 400b into data matching a predetermined output destination and outputs the data. The model interface 6 may be provided, for example, as an example of the output unit 103 described above. In the present embodiment, output destinations of the model interface 6 include the target device 2 and the display 7.

For example, the model interface 6 may output the result information D44a indicating the situation analysis result included in the analysis result D42a and the improvement method included in the analysis result D42b to the display 7, and output the result information D44b indicating the improvement method included in the analysis result D42b to the target device 2. At this time, the model interface 6 may extract some data from the analysis result D42a and/or the analysis result D42b, convert the data into a data format matching the output destination, and output the data as the result information D44a and the result information D44b.

In the example illustrated in FIG. 23, the target device 2 and the display 7 are illustrated as the output destinations of the model interface 6, but the output destinations of the model output data are not limited to the above. For example, when the information indicating the control on the target device 2 is included in the method for improving the situation indicated by the model output data to be output, the model interface 6 can output the model output data or the information indicating the method to a conversion device (not illustrated) that converts the model output data or the information into information that can be received by the target device 2, for example, in addition to directly outputting the model output data or the information indicating the method to the target device 2 as the implementation destination of the method. The conversion device may be, for example, the control system 1000 of the first embodiment that converts input information into a control description or an execution code that is discriminable by the target device 2.

In addition, the model interface 6 itself may have a function of a conversion device. For example, the model interface 6 may have a function of not only controlling the output of the model output data but also converting the improvement method output by the learning model unit 400b into a code executable by an interpreter and controlling the device on the basis of the converted code or the output of the code. In addition, the model interface 6 may have a function of controlling a processing flow such as immediately executing a process with a high degree of urgency when the improvement method includes the process with a high degree of urgency. In addition, the model interface 6 may have a function of transmitting a prompt input through the display of the display 7, such as an answer to the proposal of the method displayed on the display 7, to the learning model unit 400b.

In addition, the model interface 6 may have the functions of the output confirmation unit 202 and the correction confirmation unit 203 described above. For example, the model interface 6 may determine the urgency of the analyzed situation, and in a case where it is determined that the urgency is not high, the model interface 6 may check the validity of the improvement method using an inquiry to the supervisor or a simulator, and if the improvement method is not valid, transmit the fact to the learning model unit 400b to urge the output of the improvement method again. At that time, the model interface 6 may issue the supplementary information D48 to the model input data of the target learning model unit.

In the present embodiment, the input information D41 corresponds to the model input data D101 of the learning model unit 400a. In addition, the analysis result D42a corresponds to the model output data D103 of the learning model unit 400a. In addition, the analysis result D42a corresponds to the model input data D101 of the learning model unit 400b. In addition, the analysis result D42b corresponds to the model output data D103 of the learning model unit 400b. For example, the learning model unit 400a (in particular, the model control unit 101) may be configured to output the analysis result D42a corresponding to the input information D41 on the basis of the model information D102 and the model reference information D104 as necessary when receiving the input information D41. In addition, the learning model unit 400b (in particular, the model control unit 101) may be configured to output the analysis result D42b corresponding to the analysis result D42a on the basis of the model information D102 and the model reference information D104 as necessary when receiving the analysis result D42a.

Furthermore, in such a case, the model generation unit 107 provided corresponding to the learning model unit 400a may generate or update the model information D102 by performing machine learning using, for example, the model learning data D105 including the candidates of the input information D41 that can be input to the model control unit 101, or may generate or update the model information D102 by performing machine learning using the model learning data D105 including the candidates of the input information D41 that can be input to the model control unit 101 and the candidates of the analysis result D42a corresponding thereto. The model generation unit 107 provided corresponding to the learning model unit 400b may generate or update the model information D102 by performing machine learning using, for example, the model learning data D105 including the candidates of the analysis result D42a that can be input to the model control unit 101, or may generate or update the model information D102 by performing machine learning using the model learning data D105 including the candidates of the analysis result D42a that can be input to the model control unit 101 and the candidates of the analysis result D42b corresponding thereto.

Although not illustrated, also in the present embodiment, the state information D45 and/or the feedback information D46 may be acquired from the output destination of the model output data D103 of the learning model unit 400a and the learning model unit 400b and/or the information generated based thereon. For example, the control system 4000 may output the acquired state information D45 and/or feedback information D46 to the user, the learning model unit 400a, the learning model unit 400b, or another device (not illustrated) as information indicating a control result. In addition, the control system 4000 may be configured to return an inquiry D47 to the user when the input information D41 includes unclear or uncertain information. Furthermore, the control system 4000 can generate the supplementary information D48 for the input/output data of the learning model unit 400a and the learning model unit 400b on the basis of the acquired state information D45 and/or feedback information D46, and issue the supplementary information to the user, the learning model unit 400a, the learning model unit 400b, or another device (not illustrated). Handling of the state information D45, the feedback information D46, the inquiry D47, and the supplementary information D48 may be basically similar to that in the first embodiment. Here, the information may be output to the user via, for example, the display 7 or an input/output interface included in the information processing device 10 (not illustrated).

In addition, the control system 4000 may further include a state acquisition unit 430 (not illustrated) that acquires the state information D45 and/or the feedback information D46 and issues the supplementary information D48 as necessary. The state acquisition unit 430 is similar to the state acquisition unit 130 of the first embodiment.

Also in the present embodiment, the target device 2 is not particularly limited. It is assumed that the target device 2 is a device that can actually be controlled by receiving the analysis result D42b, but this is not the case when the conversion device described above is included in relation to the target device 2.

In the present embodiment, the input information D41 received by the control system 4000 can be referred to as information regarding a situation (here, the situation in the environment in which the monitoring work is performed) in the work environment. Therefore, the input information D41 received by the control system 4000 can be regarded as an example of the first information indicating the situation in the work environment. In addition, the analysis result D42a and the analysis result D42b can be regarded as information used for the work (monitoring work) corresponding to such input information D41. Hereinafter, the analysis result D42a and/or the analysis result D42b output to a predetermined output destination from the operation environment of the learning model to which the model input data based on the input information D41 is input may be referred to as second information.

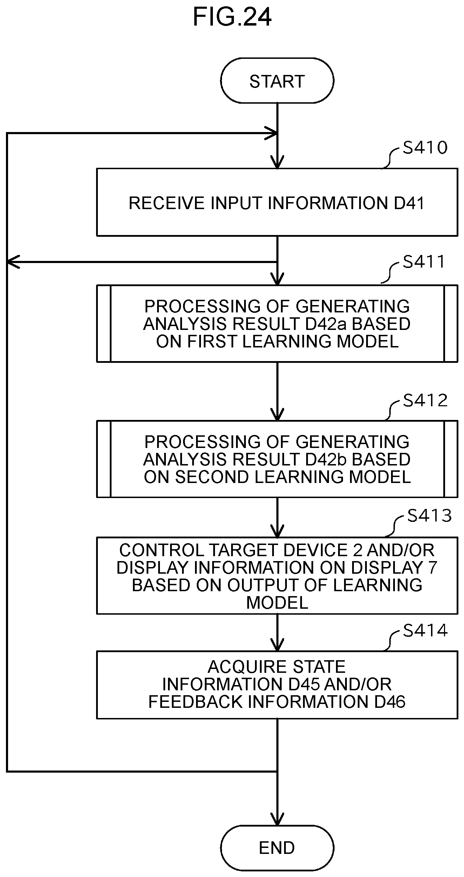

Next, an operation of the control system 4000 of the present embodiment will be described. FIG. 24 is a flowchart illustrating an operation example of the control system 4000.

In the example illustrated in FIG. 24, first, the control system 4000 receives the input information D41 (step S410). For example, the input unit 102 or the input processing unit 201 described above may receive the input information D41. The received input information D41 is input to the learning model unit 400a as the model input data D101.

Next, the control system 4000 performs generation processing of the analysis result D42a using the learning model unit 400a (step S411). In step S411, the learning model unit 400a (more specifically, the model control unit 101) outputs the analysis result D42a corresponding to the input information D41 that has been input on the basis of the model reference information D104 including the model information D102 and the input information D41, and the device information D43 as necessary. For example, the learning model unit 400a may generate the analysis result D42a of text data from the input information D41 that has been input using a learning model capable of generating text data.

In step S411, the pre-processing unit 105 and/or the post-processing unit 106 of the learning model unit 400a may further perform the above-described processing.

The analysis result D42a output from the learning model unit 400a is input to the learning model unit 400b. In addition, the analysis result D42a output from the learning model unit 400a is input to the learning model unit 400b and the model interface 6. The analysis result D42a output from the learning model unit 400a may be input to the model interface 6 via the learning model unit 400b. In this case, the learning model unit 400b may output the model output data D103 including the analysis result D42a and the analysis result D42b.

Next, the control system 4000 performs generation processing of the analysis result D42b using the learning model unit 400b (step S412). In step S412, the learning model unit 400b (more specifically, the model control unit 101) outputs the analysis result D42b corresponding to the analysis result D42a that has been input on the basis of the model reference information D104 including the model information D102 and the analysis result D42a, and the device information D43 as necessary. For example, the learning model unit 400b may generate the analysis result D42b of binary data from the analysis result D42a that has been input using a learning model capable of generating text data. In addition, the learning model unit 400b may generate the analysis result D42b of text data and binary data from the input analysis result D42a using, for example, a learning model capable of generating text data and binary data.

In step S412, the pre-processing unit 105 and/or the post-processing unit 106 of the learning model unit 400b may further perform the above-described processing.

The analysis result D42b output from the learning model unit 400b is input to, for example, the model interface 6.

The model interface 6 controls the target device 2 and/or causes the display 7 to display information based on the analysis results by the learning model unit 400a and the learning model unit 400b (step S413). In step S413, for example, the model interface 6 outputs information based on the analysis result D42a and the analysis result D42b to a predetermined output destination. For example, on the basis of the analysis result D42a and the analysis result D42b, the model interface 6 outputs result information D44a indicating the situation analysis result and the improvement method to the display 7, and outputs result information D44b indicating the improvement method based on the analysis result D42b to the target device 2.

The result information D44a may indicate a situation occurring in the work environment and an improvement method by, for example, a character and a sound. Furthermore, the result information D44b may indicate an improvement method by, for example, a character or a control signal.

As a result, the display 7 displays the situation analysis result indicated by the analysis result D42a and the improvement method indicated by the analysis result D42b on the basis of the result information D44a, and the target device 2 performs the improvement method indicated by the analysis result D42b on the basis of the result information D44b. Information input to the display 7 and the target device 2 may be directly input from the control system 4000 (more specifically, the model interface 6), or may be indirectly input via a communication network, another device (server, various conversion devices, and the like), or a human hand.

The control system 4000 may acquire the state information D45 and the feedback information D46 in a case where there is a change in the state of the target device 2 due to control of the target device 2 or the like and there is feedback from the output destination (step S414). Note that the processing in step S414 is not essential and may be omitted as appropriate.

The control system 4000 may repeat the processing of steps S410 to S414 a plurality of times (for example, until a desired state is obtained in a target work environment).

As described above, according to the present embodiment, since the grasping of the situation and the acquisition of the improvement method are performed in two stages using different learning models, the accuracy of the final product can be improved, and as a result, the efficiency of the work related to the monitoring of the work situation can be improved.

For example, in a scene where a situation is grasped, it is important to widely detect an abnormal state in a work environment such as "something abnormal has occurred". On the other hand, in a scene of acquiring an improvement method, specific information such as "the machine is stopped, the position of the workpiece is moved to point A, the state of the machine is returned to state B, and the machine is restarted" is important.

In a case where such information to be extracted, that is, the degree of abstraction of the intended information is different, if learning and extraction are performed together with one learning model, there is a concern that the accuracy of the output result is degraded. In particular, in acquisition of an improvement method, presentation of a specific method is required on the basis of knowledge and information of a work environment. In such a case, it is possible to more reliably improve the output accuracy by dividing the learning model and giving appropriate domain knowledge (environment information).

In addition, in a case where a solution for different tasks such as grasping of a situation and acquisition of an improvement method is to be obtained by one learning model, it is conceivable that the problem of hallucination becomes remarkable. This is because there is a possibility that a function of adjusting the solution of the other task (grasping of the situation) so that the solution of one task (acquisition of the improvement method) looks likely implicitly works in the model algorithm. According to the present embodiment, an effect is also produced on such a problem of hallucination. That is, by dividing the learning model in correspondence with two tasks of grasping the situation and acquiring the improvement method, it is possible to suppress the modal entering each learning model, and as a result, it is possible to suppress the magnitude of the hallucination, and thus, it is possible to improve the accuracy of the final product.

Furthermore, in the present embodiment, since the analysis result D42a and the analysis result D42b, which are the output results of the learning model unit 400a and the learning model unit 400b, can be displayed in language on the display 7, it is possible to reduce hallucination and implement a method for more reliably improving the situation by a person confirming the contents thereof.

Note that the control system 4000 of the present embodiment can be applied not only to the monitoring of the control system of the device in the factory described above but also to, for example, the monitoring of the distribution target in the distribution system.

### Modification 4-1.

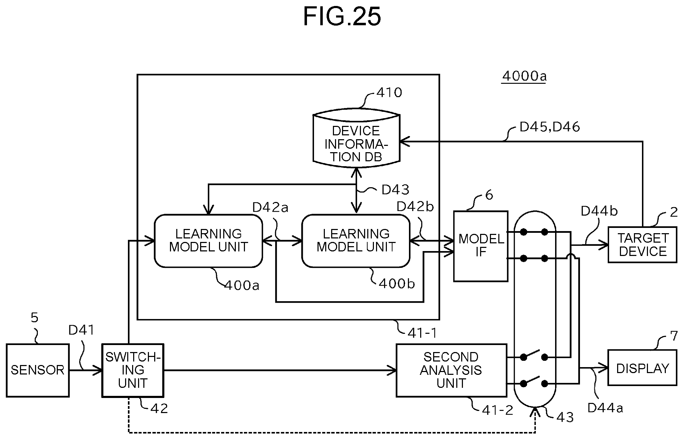

Next, a modification of the control system 4000 will be described. FIG. 25 is a configuration diagram illustrating an example of a control system 4000a which is a modification of the control system 4000 according to the present embodiment. Note that the same elements as those of the control system 4000 are denoted by the same reference signs, and description thereof is omitted.

The control system 4000a illustrated in FIG. 25 is different from the control system 4000 in that two analysis means for analyzing and improving the situation by different methods are provided, and the analysis means to be appropriately used is switched according to the generated situation.

The control system 4000a illustrated in FIG. 25 includes a portion for analyzing a situation and acquiring an improvement method using the learning model unit 400a and the learning model unit 400b described above as a first analysis unit 41-1, and further includes a second analysis unit 41-2, a switching unit 42, and an output changeover switch 43.

The second analysis unit 41-2 is not particularly limited as long as it is a means that analyzes the situation and acquires an improvement method for the input information D41 by a method different from that of the first analysis unit 41-1. As an example, the second analysis unit 41-2 may be a means for analyzing a situation and acquiring an improvement method on a rule basis. For example, in response to input of the input information D41, the second analysis unit 41-2 may determine whether or not the input information D41 matches a predetermined anomaly pattern, and when the input information D41 matches any anomaly pattern, may acquire an improvement method according to the anomaly pattern. The second analysis unit 41-2 outputs an analysis result D42c including at least a situation improvement method.

The analysis result D42c may include, for example, information corresponding to the above-described result information D44a and information corresponding to the result information D44b. In the present modification, the analysis result D42c includes at least result information D44b indicating the improvement method obtained by the second analysis unit 41-2.

In the present modification, the second analysis unit 41-2 may be implemented as an internal execution module, for example, by being mounted on a PLC, an information processing device, or the like disposed in a work environment.

The switching unit 42 is a means that switches the control destination for the input information D41 according to a predetermined condition. In the present modification, the switching unit 42 switches the control destination for the input information D41 between the first analysis unit 41-1 and the second analysis unit 41-2. For example, the switching unit 42 may switch the control destination for the input information D41 depending on whether the input information D41 matches an existing rule. At this time, the switching unit 42 may switch the control destination by switching the output destination of the input information D41 to the second analysis unit 41-2 in a case where the input information D41 matches the existing rule, and by switching the output destination of the input information D41 to the first analysis unit 41-1 in a case where the input information D41 does not match the existing rule.

For example, the switching unit 42 may switch the control destination of the input information D41 according to an instruction from the supervisor. Furthermore, the switching unit 42 may switch the control destination with respect to the input information D41 according to, for example, time, work content, presence or absence of a supervisor, or the like. Furthermore, the switching unit 42 may switch the control destination with respect to the input information D41 depending on, for example, whether or not an anomaly has occurred in the work environment. Here, the presence or absence of occurrence of anomaly in the work environment may be determined, for example, by whether or not an anomaly signal has occurred. For example, at the time of anomaly, the switching unit 42 may switch the control destination for the input information D41 to the first analysis unit 41-1. Furthermore, the switching unit 42 may switch the control destination for the input information D41, for example, according to the degree of anomaly or the degree of urgency occurring in the work environment.

In addition, the switching unit 42 may control the output changeover switch 43 that switches the connection path (circuit, communication path, or the like) connecting the output of the first analysis unit 41-1 or the output of the second analysis unit 41-2, and the target device 2 and the display 7, which are the output destinations of the analysis result, according to the switching of the control destination with respect to the input information D41.

For example, when the control destination of the input information D41 is switched to the first analysis unit 41-1, the switching unit 42 may control the output changeover switch 43 to turn on the connection path connecting the output of the first analysis unit 41-1 and the target device 2 and the display 7 and turn off the connection path connecting the output of the second analysis unit 41-2 and the target device 2 and the display 7. Similarly, for example, when the control destination for the input information D41 is switched to the second analysis unit 41-2, the switching unit 42 may control the output changeover switch 43 to turn on the connection path connecting the output of the second analysis unit 41-2 and the target device 2 and the display 7 and turn off the connection path connecting the output of the first analysis unit 41-1 and the target device 2 and the display 7.

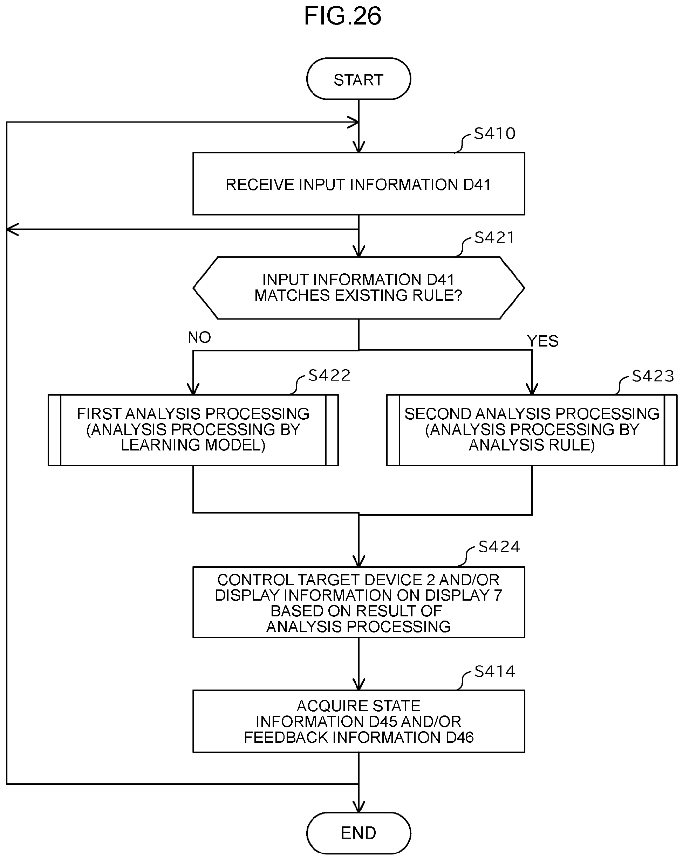

FIG. 26 is a flowchart illustrating an operation example of the present modification. In the example illustrated in FIG. 26, when the control system 4000a receives the input information D41 in step S410, the switching unit 42 switches the control destination for the input information D41 according to a predetermined condition (step S421). In the example illustrated in FIG. 26, the switching unit 42 determines whether or not the input information D41 matches the existing rule, and when it is determined that the input information D41 does not match the existing rule (No in step S 421), the process proceeds to the first analysis processing (step S422). On the other hand, when it is determined that the input information D41 matches the existing rule (Yes in step S 421), the process proceeds to the second analysis processing (step S423).

In the first analysis processing in step S422, the learning model unit 400a and the learning model unit 400b as the first analysis unit 41-1 analyze the situation and acquire the improvement method. The learning model unit 400a and the learning model unit 400b output the analysis result D42a including the analysis result of the situation and the analysis result D42b including the improvement method of the situation as results of the first analysis processing.

In the second analysis processing of step S423, the second analysis unit 41-2 analyzes the situation and acquires the improvement method according to the existing rule. For example, the second analysis unit 41-2 outputs an analysis result D42c including at least a situation improvement method as a result of the first analysis processing.

When the result of the analysis processing by the first analysis unit 41-1 or the second analysis unit 41-2 is output, the target device 2 is controlled and/or information is displayed on the display 7 on the basis of the result of any analysis processing according to the state of the output changeover switch 43 (step S424).

In this example, in a situation where the first analysis unit 41-1 performs analysis processing, the connection path that connects the output of the first analysis unit 41-1 and the target device 2 and the display 7 is turned on. In this case, the model interface 6 may output, for example, result information D44a indicating the situation analysis result and the improvement method to the display 7 on the basis of the analysis result D42a and the analysis result D42b, and output result information D44b indicating the improvement method on the basis of the analysis result D42b to the target device 2. On the other hand, in a situation where the second analysis unit 41-2 performs analysis processing, the connection path that connects the output of the second analysis unit 41-2 and the target device 2 and the display 7 is turned on. In that case, on the basis of the analysis result D42c output from the second analysis unit 41-2, the result information D44a indicating the situation analysis result and the improvement method may be output to the display 7, and/or the result information D44b indicating the improvement method may be output to the target device 2.

The display 7 may display the result information D44b in a form that can be confirmed by the worker, for example. In this case, the worker may refer to the result information D44b displayed on the display 7, check the improvement method indicated by the result information D44b, and perform the work according to the method. In addition, the worker may confirm the improvement method indicated by the result information D44b and determine the validity thereof. At this time, when the improvement method indicated by the result information D44b is invalid, the worker may prompt the learning model unit 400b to acquire another improvement method (reacquire model output data). For example, when receiving information requesting reacquisition of the model output data, the learning model unit 400b may change a part of the input information, a part of the model parameters, or a reference destination of the reference information, and then reacquire the model output data.

Subsequent processing may be similar to that in other control systems according to the present embodiment.

As described above, the present modification includes a plurality of analysis units that analyze the situation and acquire the improvement method by different methods, and is configured to switch between the analysis units according to the situation. Therefore, it is possible to perform control more suitable for the situation. For example, for a problem whose cause is clear, the second analysis unit with a high processing load can immediately analyze the situation and present and execute an improvement method, and for a problem whose cause is not clear, the first analysis unit using the learning model can analyze a complicated situation and present and execute a better improvement method.

Note that, in the example described above, an example has been described in which the first analysis unit 41-1 analyzes the situation and acquires the improvement method using two learning models; however, the configuration of the first analysis unit 41-1 is not limited to the example described above. For example, in a case where analysis of the situation is unnecessary, the learning model unit 400a can be omitted. Furthermore, in a case where acquisition of an improvement method is unnecessary, the learning model unit 400b can be omitted. In addition, analysis of the situation and acquisition of the improvement method can be performed by one learning model unit.

For example, in a case where the first analysis unit 41-1 includes the learning model unit 400b that acquires the situation improvement method on the basis of the input information D41, the switching unit 42 may switch the control destination for the input information D41 to the first analysis unit 41-1 at the time of anomaly. In that case, in response to input of the input information D41, the learning model unit 400b of the first analysis unit 41-1 may be configured to output information indicating an improvement method corresponding to the anomaly occurrence situation indicated by the input information D41. At this time, the learning model unit 400b may refer to the device information storage unit 410 accessible by the control system and output information indicating an improvement method corresponding to the situation.

### Fifth Embodiment.

Next, the present fifth embodiment will be described. In the present embodiment, an example will be described in which a response work of returning a response to information transmission from a user in a call center, a product site, or the like is supported using a learning model. Here, the information transmission from the user may include an inquiry or an opinion regarding a certain service, information, event, or object.

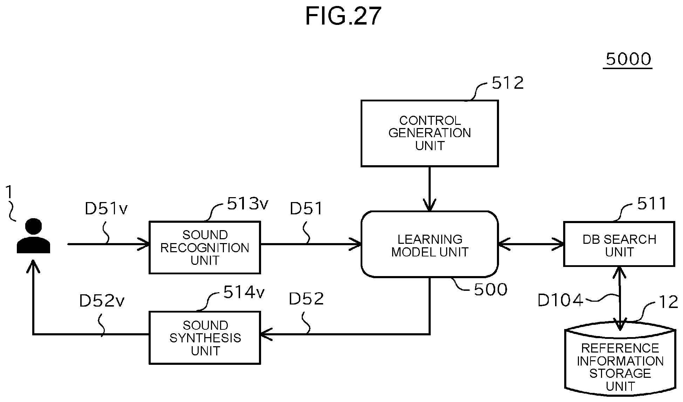

FIG. 27 is a configuration diagram illustrating an example of a control system 5000 according to the fifth embodiment. A control system 5000 illustrated in FIG. 27 includes a learning model unit 500, a reference information storage unit 12 (denoted by reference information DB in the drawing), a database search unit 511 (denoted by DB search unit in the drawing), a control generation unit 512, a sound recognition unit 513v, and a sound synthesis unit 514v. Here, the reference information storage unit 12, the database search unit 511, and the control generation unit 512 may be provided as a part of the learning model unit 500.

In response to input of the input information D51, the learning model unit 500 outputs response information D52 indicating response contents. For example, in response to input of the input information D51, the learning model unit 500 outputs the response information D52 on the basis of the model information D102. The configuration of the learning model unit 500 may be basically similar to that of the learning model unit 100 in the first embodiment.

In the present embodiment, the learning model unit 500 is a model and an operation environment thereof configured to output the response information D52 corresponding to the input information D51 in response to input of the input information D51. In addition, the learning model unit 500 may be a model and an operation environment thereof configured to, in response to input of the input information D51, generate and output the response information D52 on the basis of the input information D51 and other information that can be referred to in the learning model unit 500.

In the present embodiment, the input information D51 includes information indicating contents transmitted from the user 1 and the like. The input information D51 may include information indicating contents for which a reaction is required in the work environment. The input information D51 may be, for example, a text, an image, sound, or a combination thereof indicating an inquiry or an opinion regarding a certain service, information, event, or object. The input information D51 may be, for example, text, an image, sound, or a combination thereof indicating a plurality of inquiries or opinions regarding a certain service, information, event, or object. Furthermore, the input information D51 may include information indicating temporally continuous transmitted content, and in that case, may be time-series data having a predetermined data structure including text, an image, sound, or a combination thereof indicating the transmitted content as described above. It is assumed that the transmitted content is indicated on the assumption that the transmitted content matches the input format of the model used by the learning model unit 500, but this is not the case when error processing, correction processing, or conversion processing is included in the preceding stage of the learning model unit 500.

The response information D52 includes information indicating a response to the transmitted content included in the input information D51. The response information D52 may be, for example, information indicating a response to an inquiry or an opinion regarding a service, information, event, or object indicated by the transmitted content included in the input information D51.

The reference information storage unit 12 stores the model reference information D104 to be referred to by the model control unit 101 of the learning model unit 500 to output the response information D52. The model reference information D104 includes, for example, information related to a service, information, an event, or an object that can be included in the input information D51. Here, the reference information storage unit 12 may particularly store information regarding a specific service, information, event, or object as the model reference information D104. The model reference information D104 may include, for example, a response manual converted into data. Furthermore, the model reference information D104 may include, for example, the input information D51 input in the past or a history of transmitted contents included therein. At this time, the reference information storage unit 12 may store, as the model reference information D104, the input information D51 input in the past or history information indicating the transmitted content included in the input information D51 together with the information (for example, a user identifier, attribute information of the user, and the like) of the user 1 who is the transmission source. Hereinafter, in the present embodiment, in particular, information indicating the state of the user 1 who is the transmission source may be referred to as state information D55.

The database search unit 511 is a search engine for the reference information storage unit 12 and other databases. In response to a request from the model control unit 101 of the learning model unit 500, the database search unit 511 searches a database to which the database search unit 511 is connected in an accessible manner and outputs a search result. At this time, the database search unit 511 may restrict the access destination database.

The control generation unit 512 is an interface for setting preconditions when the learning model unit 500 (in particular, the model control unit 101) generates model output data. The control generation unit 512 may be, for example, an interface used for recognizing information to be controlled by the learning model unit 500 and/or setting an output tendency. Here, the control target information is information indicating a target on which control in the model control unit 101 is focused. For example, the model control unit 101 may be configured to generate the model output data D103 from the model input data D101 on the basis of the control target information indicated by the control generation unit 512. For example, the control generation unit 512 may cause part of the model input data input by the user to be recognized as the control target information, cause the information generated by the model control unit 101 to be recognized as the control target information, or cause the information generated by the model control unit 101 and corrected by another control unit to be recognized as the control target information. The tendency setting of the control target information and/or the output may be designated by the user, may be designated by an external processing unit, or may be designated by the control generation unit 512 according to a predetermined algorithm.

In a case where the input information D51v in a sound format is included in the input from the user 1, the sound recognition unit 513v recognizes the sound indicated by the input information D51v, converts the sound into a format matching the data format of the learning model unit 500, and outputs the sound. For example, the sound recognition unit 513v may convert the input information D51v in a sound format into the input information D51 in a text format.

The sound synthesis unit 514v converts the content indicated by the response information D52 into a sound format and outputs the sound format. For example, in a case where the response information D52 output from the learning model unit 500 includes a data format other than sound, the sound synthesis unit 514v converts the content of the portion indicated by the response information D52 into a sound format and outputs the sound format. For example, in a case where the response information D52 has a data structure including designation of a data format, the sound synthesis unit 514v may convert a data element for which a sound format is designated in the designation into a sound format and output the data element. For example, the sound synthesis unit 514v may convert the response information D52 in a text format into the response information D52v in a sound format.

Note that, in the above-described example, an example is illustrated in which the data in the sound format is used for input/output with the user 1, but the data format used for input/output with the user 1 is not limited to the sound format. In that case, instead of the sound recognition unit 513v and the sound synthesis unit 514v, a processing unit that converts the data format used for the input from the user 1 into the data format used for the input of the learning model unit 500 and a processing unit that converts the data format used for the output from the learning model unit 500 into the data format used for the input of the user 1 may be provided.

Furthermore, in a case where the learning model unit 500 can accept a data format used for input from the user 1, the sound recognition unit 513v can be omitted. Furthermore, in a case where the user 1 can accept the data format used for the output from the learning model unit 500, the sound synthesis unit 514v can be omitted.

In the present embodiment, the input information D51 corresponds to the model input data D101. The response information D52 corresponds to the model output data D103. For example, when receiving the input information D51, the learning model unit 500 (in particular, the model control unit 101) may be configured to output the response information D52 corresponding to the input information D51 on the basis of the model information D102 and the model reference information D104 as necessary.

Furthermore, in such a case, the model generation unit 107 provided corresponding to the learning model unit 500 may perform machine learning using, for example, the model learning data D105 including candidates of the input information D51 that can be input to the model control unit 101, and generate or update the model information D102. Furthermore, the model generation unit 107 may generate or update the model information D102, for example, by performing machine learning using the model learning data D105 including a candidate of the input information D51 that can be input to the model control unit 101 and a candidate of the response information D52 corresponding thereto.

Although not illustrated, also in the present embodiment, the state information D55 and/or the feedback information D56 may be acquired from output destinations of the model output data D103 of the learning model unit 500 and/or information generated based thereon. For example, the control system 5000 may output the acquired state information D55 and/or feedback information D56 to a predetermined supervisor, the learning model unit 500, or another device (not illustrated) as information indicating a response result. In addition, the control system 5000 may be configured to return an inquiry D57 to the user 1 when the input information D51 includes unclear or uncertain information. Furthermore, the control system 5000 can generate the supplementary information D58 for the input/output data of the learning model unit 500 on the basis of the acquired state information D55 and/or feedback information D56, and issue the supplementary information to the user 1, a predetermined supervisor, the learning model unit 500, or another device (not illustrated). Handling of the state information D55, the feedback information D56, the inquiry D57, and the supplementary information D58 may be basically similar to that in the first embodiment.

In addition, the control system 5000 may further include a state acquisition unit 530 (not illustrated) that acquires the state information D55 and/or the feedback information D56 and issues the supplementary information D58 as necessary. The state acquisition unit 530 is similar to the state acquisition unit 130 of the first embodiment.

In the present embodiment, the input information D51 received by the control system 5000 can be referred to as information regarding a request (Here, the transmitted content requesting a response such as a response in an environment where a response operation is performed in response to the inquiry) in the work environment. Therefore, the input information D51 received by the control system 5000 can be regarded as an example of the first information indicating the request in the work environment. In addition, the response information D52 can be regarded as information used for the work (response work) corresponding to such input information D51. Hereinafter, the response information D52 output to a predetermined output destination from the operation environment of the learning model to which the model input data based on the input information D51 is input may be referred to as second information.

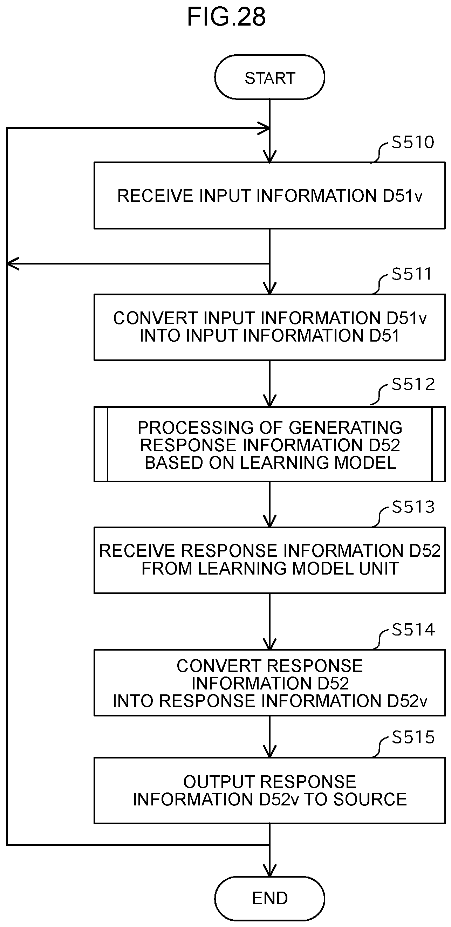

Next, an operation of the control system 5000 of the present embodiment will be described. FIG. 28 is a flowchart illustrating an operation example of the control system 5000.

In the example illustrated in FIG. 28, first, the control system 5000 receives the input information D51v (step S510). For example, the input unit 102 or the input processing unit 201 described above may receive the input information D51v. The received input information D51v is input to the sound recognition unit 513v.

Upon receiving the input information D51v, the sound recognition unit 513v recognizes sound included in the input information D51v and converts the sound into the input information D51 that matches the data format of the input of the learning model unit 500 (step S511). The converted input information D51 is input to the learning model unit 500 as model input data D101.

Note that, in a case where the sound recognition unit 513v is omitted, the received input information D51v may be input to the learning model unit 500 as the model input data D101.

Next, the control system 5000 performs generation processing of the response information D52 using the learning model unit 500 (step S512). In step S512, the learning model unit 500 (more specifically, the model control unit 101) outputs the response information D52 corresponding to the input information D51 on the basis of the model information D102 and the input information D51 that has been input, and the model reference information D104 as necessary.

In step S512, the pre-processing unit 105 and/or the post-processing unit 106 of the learning model unit 500 may further perform the above-described processing.

The response information D52 output from the learning model unit 500 is input to, for example, the sound synthesis unit 514v (step S513). The input of the response information D52 to the sound synthesis unit 514v may be directly input from the control system 5000 (more specifically, the learning model unit 500 or the information processing device 10 or the like as an operation environment thereof), or may be indirectly input via a communication network, another device (server, various conversion devices, and the like), or a human hand.

Next, the sound synthesis unit 514v converts the input response information D52 into the response information D52v in a sound format and outputs the response information (step S514). For example, the sound synthesis unit 514v may generate the response information D52v by synthesizing a sound uttering the response content indicated by the response information D52 in a data format other than sound. The response information D52v is output toward the user 1 who is the source of the input information D51v (step S515).

Note that, in a case where the sound synthesis unit 514v is omitted, the response information D52 output from the learning model unit 500 may be output toward the user 1 who is the source of the input information D51v.

As described above, in the present embodiment, it is possible to dynamically generate the response information D52 using the learning model unit 500 and return the response information D52 to the user who is the transmission source without preparing the operator or a site or the like in which contents to respond to the transmitted information from the user 1 in advance. Therefore, it is possible to improve the efficiency and performance of the response work.

### Modification 5-1.

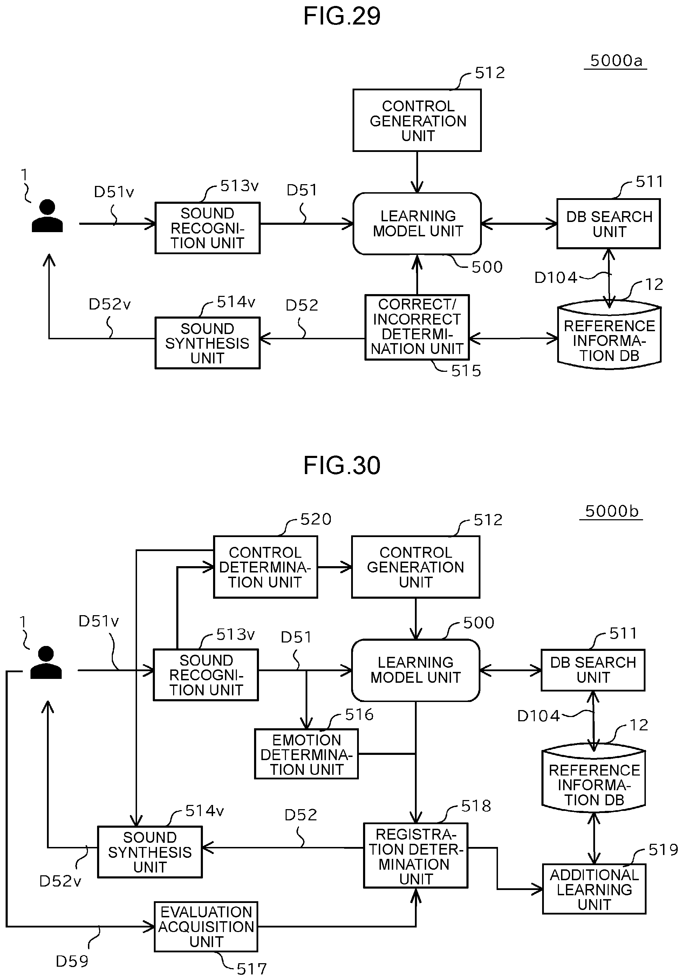

Next, a modification of the control system 5000 will be described. FIG. 29 is a configuration diagram illustrating an example of a control system 5000a which is a modification of the control system 5000 according to the present embodiment. Note that the same elements as those of the control system 5000 are denoted by the same reference signs, and description thereof is omitted.

The control system 5000a illustrated in FIG. 29 is different from the control system 5000 in that a correct/incorrect determination unit 515 is provided.

The correct/incorrect determination unit 515 determines whether the content indicated by the response information D52 which is the output from the learning model unit 500 is correct. For example, the correct/incorrect determination unit 515 may output the response information D52 to the user 1 or update the content of the reference information storage unit 12 only in a case where it is determined that the content indicated by the response information D52 is correct.

In addition, for example, when determining that the content indicated by the response information D52 is not correct, the correct/incorrect determination unit 515 may prompt the learning model unit 500 to acquire another piece of the response information D52 (reacquire model output data). The correct/incorrect determination unit 515 may be provided, for example, as an example of the post-processing unit 106 described above.

Other points may be similar to other control systems according to the present embodiment.

As described above, according to the present modification, it is determined whether or not the content indicated by the response information, which is the output from the learning model unit 500, is correct, and the presence or absence of output to the user, reacquisition of the response information, and update of the reference information are performed on the basis of the result, so that it is possible to further improve the performance of the response work.

### Modification 5-2.

Next, a second modification of the control system 5000 will be described. FIG. 30 is a configuration diagram illustrating an example of a control system 5000b which is a modification of the control system 5000 according to the present embodiment. Note that the same elements as those of the control system 5000 and the control system 5000a are denoted by the same reference signs, and description thereof is omitted.

As illustrated in FIG. 30, the control system 5000b may further include an emotion determination unit 516.

The emotion determination unit 516 determines the emotion of the user 1 who is the transmission source by using the input information D51 and other information. Furthermore, the emotion determination unit 516 may determine the emotion of the user 1 after the response information D52 from the learning model unit 500 is output toward the user 1.

The emotion of the user 1 determined by the emotion determination unit 516 may be input to the learning model unit 500 as the state information D55 included in the model reference information D104, or may be recorded as a history together with input/output data of the model in the reference information storage unit 12.

As a method of recording in the reference information storage unit 12, for example, the control system 5000b may further include the registration determination unit 518, and the registration determination unit 518 may determine whether or not to record in the reference information storage unit 12 on the basis of the determination result of the emotion of the user 1 by the emotion determination unit 516.

For example, if the determined emotion of the user 1 is positive, the registration determination unit 518 may cause the reference information storage unit 12 to record input/output data of the model as history information as a good case. At this time, in a case where there is a determination result of the emotion of the user 1 before the response information D52 is output from the learning model unit 500, the registration determination unit 518 may cause the reference information storage unit 12 to record input/output data of the model including the emotion information before and after the response as the history information.

Furthermore, for example, in a case where the determined environment of the user 1 is negative, the registration determination unit 518 may cause the reference information storage unit 12 to record input/output data of the model as history information as a defect case. At this time, in a case where there is a determination result of the emotion of the user 1 before the response information D52 is output from the learning model unit 500, the registration determination unit 518 may cause the reference information storage unit 12 to record input/output data of the model including the emotion information before and after the response as the history information.

In addition, the control system 5000b may further include an additional learning unit 519, and when updating the content of the reference information storage unit 12, the model reference information D104 stored in the reference information storage unit 12 and other information referred to by the model control unit 101 may be reconstructed (additional learning) on the basis of the update information.

Furthermore, the control system 5000b may include an evaluation acquisition unit 517 instead of the emotion determination unit 516 or in addition to the emotion determination unit 516.

The evaluation acquisition unit 517 inquires of the user 1 about the evaluation of the response information D52, and acquires the evaluation information D59 as a response thereto. The evaluation information D59 can be used, for example, for update of information referred to by the model, additional learning, and the like, similarly to the emotion of the user 1 described above.

The control system 5000b may further include a control determination unit 520.

The control determination unit 520 designates the control target information and/or designates the tendency setting of the output to the control generation unit 512 on the basis of a sound recognition result for the input information from the user 1, an emotion determination result, and/or an evaluation result of the response information D52, an instruction from an operator (not illustrated), or the like. Here, the sound recognition result for the input information from the user 1 can include information such as an attribute, an emotion, a region, a language, presence or absence of past use, and a use frequency of the user 1. Furthermore, the control determination unit 520 may set the synthesized sound in the sound synthesis unit 514v on the basis of a sound recognition result for the input information from the user 1, an emotion determination result, and/or an evaluation result of the response information D52, an instruction from an operator (not illustrated), or the like.

For example, as an example of the output tendency setting, the control determination unit 520 can specify a difficulty level of explanation in response, a way of speaking (way of speaking or tone), a language, a level of grammar, politeness, a standing position of a speaker, a destination of the speech, and the like. The gender, way of speaking, tone, and the like of the synthesized sound can be designated. Furthermore, for example, the control determination unit 520 can designate gender, how to speak, language, a level of grammar, politeness, and the like of the synthesized sound as an example of setting the synthesized sound. The control determination unit 520 may perform these settings on the basis of, for example, a predetermined setting rule.

Note that the elements of the control system 5000b illustrated in FIG. 30 can be appropriately selected according to a desired function.

Other points may be similar to other control systems according to the present embodiment.

As described above, according to the present modification, since the control determination unit 520 designates the control target information and/or designates the output tendency setting on the basis of the information or the like that can be acquired from the control system 5000b, it is possible to generate the response information that easily meets the request of the transmission source. Therefore, it is possible to further improve the performance of the response work to the user.

### Modification 5-3.

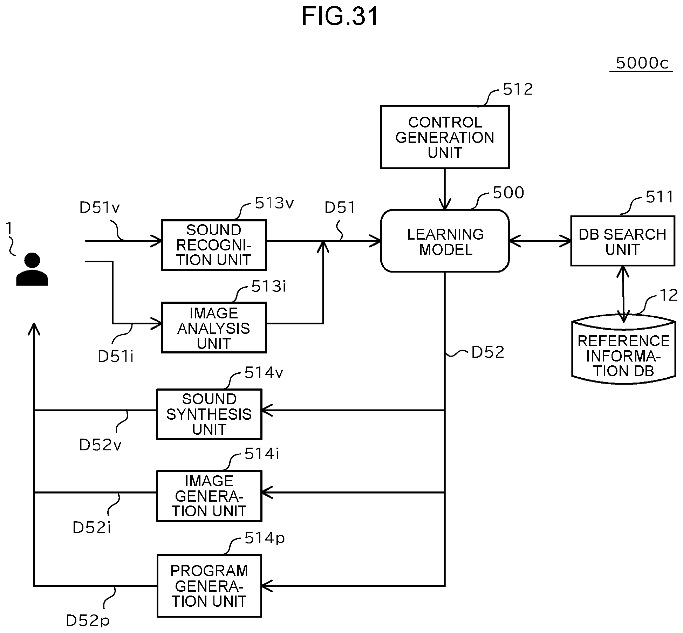

Next, a third modification of the control system 5000 will be described. FIG. 31 is a configuration diagram illustrating an example of a control system 5000c which is a modification of the control system 5000 according to the present embodiment. Note that the same elements as those of the control system 5000, the control system 5000a, and the control system 5000b are denoted by the same reference numerals, and description thereof is omitted.

As illustrated in FIG. 31, the control system 5000c may further include an image analysis unit 513i, an image generation unit 514i, and a program generation unit 514p.

In a case where the input information D51i in an image format is included in the input from the user 1, the image analysis unit 513i analyzes the image indicated by the input information D51i, converts the image into a format that matches the data format of the learning model unit 500, and outputs the image. For example, the image analysis unit 513i may convert the input information D51i in an image format into the input information D51 in a text format.

For example, in a case where an input from the user 1 includes an image obtained by capturing an operation screen of a product possessed by the user 1, the image analysis unit 513i may analyze the image, identify which operation screen of which product is, and in what operation state, convert the image into a text describing the operation screen, and output the text. Furthermore, for example, in a case where an image obtained by capturing a certain buying site browsed by the user 1 is included in the input from the user 1, the image analysis unit 513i may analyze the image, specify which operation screen of which site it is, and in which operation state it is, convert the image into a text describing the operation screen, and output the text.

The image generation unit 514i generates and outputs an image on the basis of the response information D52. For example, in a case where the response information D52 output from the learning model unit 500 includes a data format other than the image, the image generation unit 514i may generate and output an image indicating the content of the portion indicated by the response information D52. For example, in a case where the response information D52 has a data structure including designation of a data format, the image generation unit 514i may convert a data element of which an image format is designated in the designation into an image format and output the image format. The image generation unit 514i may generate the response information D52i in an image format on the basis of the response information D52 in a text format, for example. For example, the image generation unit 514i may perform synthesis processing of adding the content indicated by the response information D52 in text format to the image included in the input information D51 as an annotation. Furthermore, on the basis of the response information D52 in a text format, the image generation unit 514i may perform processing of highlighting a part of the image included in the input information D51. The image generation unit 514i may generate an image from the input information (the response information D52 and the input information D51 as necessary) using the learning model.

The program generation unit 514p converts the content indicated by the response information D52 into a data format of a predetermined program and outputs the data format. For example, when the response information D52 output from the learning model unit 500 includes a data format other than the data format of the predetermined program, the program generation unit 514p converts the content of the portion indicated by the response information D52 into the data format of the predetermined program and outputs the data format. For example, in a case where the response information D52 has a data structure including designation of a data format, the program generation unit 514p may convert a data element for which a data format of a predetermined program is designated in the designation into a data format of a predetermined program and output the data element. For example, the program generation unit 514p may convert the response information D52 in a text format into the response information D52p in a data format of a predetermined program. The program generation unit 514p may generate a predetermined program from the input information using the learning model.

The image analysis processing by the image analysis unit 513i is performed, for example, in step S511 described above. Furthermore, the image generation processing by the image generation unit 514i and the program generation processing by the program generation unit 514p are performed, for example, in step S514 described above.

Other points may be similar to other control systems according to the present embodiment.

As described above, according to the present modification, since an inquiry and a response can be made not only by sound but also by sound and image, for example, it is possible to more effectively respond to an inquiry or the like on the operation screen. In addition, according to the present modification, since the program can be provided to the transmission source as the response information in addition to the sound and the image, it is possible to more effectively respond to an inquiry such as defect handling.

### Modification 5-4.

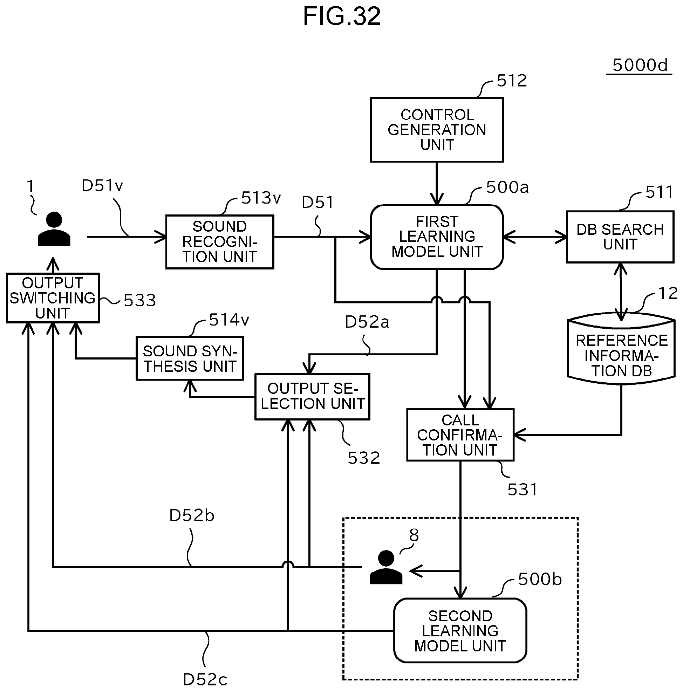

Next, a fourth modification of the control system 5000 will be described. FIG. 32 is a configuration diagram illustrating an example of a control system 5000d which is a modification of the control system 5000 according to the present embodiment. Note that the same elements as those of the control system 5000 to the control system 5000c are denoted by the same reference numerals, and description thereof is omitted.

The present modification has a function of switching to a response by the operator 8 or a response by another learning model on the basis of an inquiry content from the user 1 and/or an output result from the learning model.

As illustrated in FIG. 32, the control system 5000d can further include a call confirmation unit 531 and an output selection unit 532.

Here, it is assumed that the control system 5000d includes a learning model unit 500a as a first response function and includes a communication channel with the operator 8 and the operator 8 as a second response function. Furthermore, the control system 5000d may further include another learning model unit 500b having an algorithm or data to be used different from that of the learning model unit 500a as the third response function. Note that another learning model unit 500b having an algorithm or data to be used different from that of the learning model unit 500a may be provided as the second response function. In that case, as the third response function, the operator 8 and a communication channel with the operator 8 may be further provided. Note that the type and number of response functions are not particularly limited. For example, the response function of the switching destination may be a response system that does not use a learning model.

In the present example, a case where the learning model unit 500a serving as the first response function is the learning model unit 500 described above, the second response function is the operator 8 and a communication channel with the operator 8, and the third response function is another learning model unit 500b having an algorithm or data to be used different from that of the learning model unit 500a will be described as an example.

Here, the learning model unit 500a may be a local learning model that obtains an output result on the basis of local information such as limitation of a reference destination database, and the learning model unit 500b may be a global learning model that obtains an output result on the basis of global information such as being freely accessible to an external network.

The call confirmation unit 531 switches the processing destination to perform the response processing on the basis of the inquiry content from the user 1 and/or the output result from the learning model.

The call confirmation unit 531 may call the operator 8 as the second response function, for example, when it is determined that the accuracy of the output by the first response function cannot be expected on the basis of the inquiry content from the user 1 and/or the output result from the learning model. For example, the call confirmation unit 531 may call operator 8 by using a communication channel with operator 8, and input the input information D51 to the manipulation equipment of operator 8. Further, the call confirmation unit 531 may call the operator 8 using a communication channel with the operator 8 and input the input information D51 to an operation terminal (not illustrated) of the operator 8.

In addition, the call confirmation unit 531 may call the learning model unit 500b as the third response function when it is determined that the call to the second response function is not possible or the accuracy of the output cannot be expected. For example, the call confirmation unit 531 may call the learning model unit 400b by inputting the input information D51 to the learning model unit 500b using an interface with the learning model unit 400b.

Here, the determination of the output accuracy may be made using, for example, an evaluation value or likelihood output by the response function itself, or may be made using the reliability evaluation described above. Furthermore, in a case where the response function itself outputs a message indicating that it is unknown or that it requests calling of another function, it is also possible to make a determination based on the presence or absence of such a message.

The output selection unit 532 selects the response information D52 to be output toward the user 1 on the basis of the switching result of the response processing by the call confirmation unit 531. In a case where the execution subject of the response processing is set to the first response function as a result of switching of the response processing by the call confirmation unit 531, the output selection unit 532 outputs response information D52a, which is output from the first response function, to the user 1. In addition, as a result of switching the response processing by the call confirmation unit 531, in a case where the execution subject of the response processing is set to the second response function, the output selection unit 532 outputs response information D52b, which is output from the second response function, to the user 1. In addition, as a result of switching the response processing by the call confirmation unit 531, in a case where the execution subject of the response processing is set to the third response function, the output selection unit 532 outputs response information D52c, which is output from the third response function, to the user 1.

The output selection unit 532 may output an output from the selected response function toward the user 1 by controlling an output changeover switch (not illustrated) that switches a connection path (circuit, communication path, or the like) that connects the response function as the execution subject and the user 1 as the output destination.

Here, the connection path between the response function and the user 1 can include various conversion devices such as the sound synthesis unit, the image generation unit, and the program generation unit described above and a predetermined interface as necessary.

For example, when characters input by the operator 8 using the operation terminal are output as the response information D52b, the connection path between the response function and the user 1 may include a sound synthesis unit that converts text into sound. In addition, the output selection unit 532 can also receive, as an output of the second response function or the like, information obtained by correcting the response information D52a output by the first response function. In this case, the operation terminal of the operator 8 includes a text display unit and a text input unit, and the control system 5000d may receive, for example, response information D52b obtained by correcting a part of the response information D52a output from the operation terminal of the operator 8.

Other points may be similar to other control systems according to the present embodiment.

As described above, according to the present modification, in addition to generating the response using the learning model unit 500 described above, for example, it is possible to generate the response by the operator or generate the response using another learning model (for example, the model includes a tandem structure model in which a plurality of models is connected, a multimodal model, or a model learned specifically for a predetermined device or service), and thus, it is possible to further improve the performance of the response work to the user.

Note that, in each of the above-described embodiments, an example of the system configuration according to the work of interest has been described as an example, but the control system according to the present disclosure is not limited to the above-described example. For example, the control system according to the present disclosure can appropriately combine one or more of the above-described embodiments.

As an example, the control system according to the present disclosure can directly control the target device 2 by combining the configuration of the first embodiment and the configuration of the fourth embodiment and inputting information indicating a solution method obtained from sensor data using the function of the fourth embodiment to the control system of the first embodiment to convert the information into a program.

### Sixth Embodiment.

Next, the sixth embodiment will be described. In the present embodiment, an example of supporting the work related to the control of the target device 2 described in the second embodiment will be described in more detail. Note that the configuration and operation in the present embodiment may be applied to any of the first and third to fifth embodiments. Hereinafter, differences from the second embodiment will be mainly described, and the description overlapping with the second embodiment will be omitted.

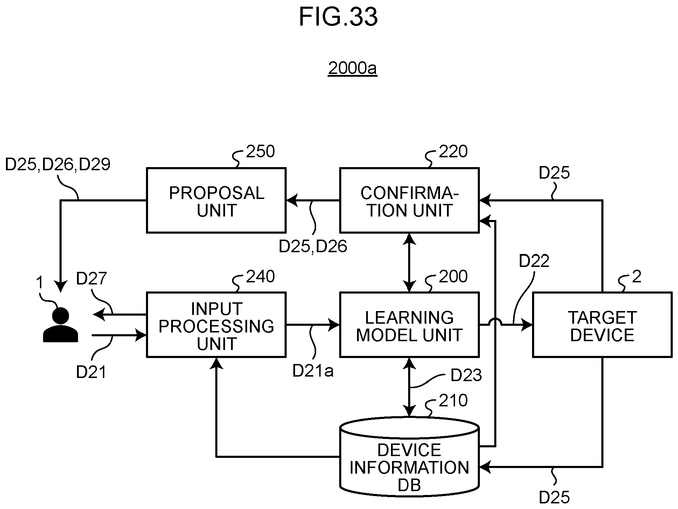

FIG. 33 is a configuration diagram illustrating an example of a control system 2000a according to the sixth embodiment. The target device 2 of the present embodiment is, for example, an industrial device used in a factory or the like as in the second embodiment. Specifically, the target device 2 is a PLC (also referred to as a sequencer), a servo system, a motion controller, a Numerical Control (NC) control device, a display, a sensor, a processing machine, a robot, a conveyance device, an assembly device, a control device of other machines, an inverter, or the like, but is not limited to the industrial device. In the example illustrated in FIG. 33, the control system 2000a includes a learning model unit 200, a device information storage unit 210, a confirmation unit 220, an input processing unit 240, and a proposal unit 250. The number of target devices 2 to be controlled by the control system 2000a may be one or plural. When a system including a plurality of target devices 2 is a control target, the system is hereinafter also referred to as a target system. The plurality of target devices 2 constituting the target system may be the same type of devices or different types of devices may be mixed. The target device 2 may include a sensor.

The input processing unit 240 receives the input information D21 from the user 1. In addition, the input processing unit 240 appropriately performs processing as preprocessing on the received input information D21 to the learning model unit 200 and outputs the processed input information as model input data D21a. As described in the first and second embodiments, the input information D21 may be input in sound data in which natural language is indicated by audio, text data indicated by natural language, text data in which codes of a predetermined format other than natural language are described, image data, a combination of text data and image data, or a data format (sound data, a moving image which is a combination of sound data and image data, and the like) that can be converted into the above. Furthermore, the text data may be input in a chat format, and in this case, an inquiry D27 to be described later may also be performed by chat.

As described in the second embodiment, the input information D21 of the present embodiment is an example of the first information indicating the request in the work environment, and more specifically, is information related to the request related to the operation of the target device 2. In addition, the control command D22 can be said to be information used for the operation (request regarding the operation of the target device 2) corresponding to such input information D21. Hereinafter, as in the second embodiment, the control command D22 may be referred to as second information.

Specifically, for example, the following instruction may be input as the input information D21.
(1) Instruction of movement of target workpiece that is an object of work of target device 2 (for example, "the workpiece X is cut at a position of 10 cm from the right", and the like.)
(2) Instruction of movement of target device 2 or target device system
(3) Instruction of target position of target device 2, component of target device 2, target device system, or target workpiece by absolute position or relative movement amount
(4) Instruction of operation speed of target device 2, component of target device 2, and target device system
(5) Instruction of task to be carried out (for example, "all parts are taken out from a box", "fried chicken is packed in a lunch box", and the like.)
(6) Instruct of on/off of target device 2, component of target device 2, target device system, sensor, and the like
(7) Instruction of which sensor to use
(8) Instruction of timing for capturing sensor information
(9) Designation of layout configuration, and instruction of operation based on designated layout (for example, after a layout indicating the position of the food tray on which the fried chicken is loaded, the position on which the lunch box is loaded, and the like is designated, an instruction such as "taking out the fried chicken from the two food trays and filling the chicken in the lunch box" is issued.)

In addition, the input information D21 may be input using a user interface of the device operation screen. For example, the input processing unit 240 may segment an operation that can be performed by the target device 2, display a device operation screen indicating a segmented phrase as an option, and complete a sentence indicating the operation by receiving an input of a selection result from the user 1. Furthermore, a portion selected by the choices and a portion freely input by the user may be combined.

The input processing unit 240 may be similar to or different from the input processing unit 201 described in the first embodiment. That is, the model input data D21a may be equivalent to or different from the model input data D101 of the first embodiment. For example, when the target device 2 is used in a factory, a production site, a building site, or the like, noise may be generated. Therefore, in a case where the input information D21 is sound data, it is possible to increase the possibility that the sound uttered by the user 1 can be correctly recognized by performing the noise removal processing for removing noise. Furthermore, the input processing unit 240 may perform the grounding process as described in the first embodiment.

Furthermore, in a case where there is an unclear point in the input information D21, the input processing unit 240 may make an inquiry D27 to the user 1 in order to compensate for the unclear point. For example, when an instruction word is included in the input information D21 and an object or an action indicated by the instruction word is unclear, an inquiry D27 for confirming the content may be performed by sound or screen display. In addition, the input processing unit 240 may perform the inquiry D27 of the information regarding the position in a case where the input information D21 is an instruction to move the entire target device 2 or the movable unit in the target device 2 and the information regarding the position such as where to move or how to move is insufficient.

For example, in a case where the input information D21 described above is an instruction of (1) or (2), the input processing unit 240 deletes or corrects a typical example in which the answer efficiency decreases when the input information is input to the learning model unit 200 so that the answer efficiency increases by learning. The answer efficiency is an index for reducing the number of repetitions when repeating the inquiry to generate the final operation command to the machine. Specifically, for example, the input processing unit 240 may inquire again about an ambiguous target workpiece and manufacturing tool. At this time, the input processing unit 240 may perform the inquiry D27 by proposing a target workpiece and a manufacturing tool that are highly likely to be used on the basis of past results and the like. In addition, a question about an ambiguous target position may be asked again. For example, the user 1 may select a target position from several candidates. In addition, the input processing unit 240 may inquire about the path again in a case where the path to be moved by the target workpiece and the manufacturing tool is ambiguous. For example, in a case where it is desirable to take a shortcut with a curve instead of a right angle or in a case where it is easier to move along the curve in consideration of constraints of acceleration and deceleration of the movement of the target workpiece and the manufacturing tool, the input processing unit 240 may indicate some correction amount candidates to ask again. Furthermore, in a case where the relative speed or the relative movement amount is designated, the input processing unit 240 may ask again to which relative speed or relative movement amount the relative speed or relative movement amount is for. Also in this case, the input processing unit 240 may ask again by indicating a candidate. Furthermore, the input processing unit 240 may indicate a correction candidate by using a result corrected in the past.

In addition, the input processing unit 240 may make an inquiry D27 of the portion determined to be omitted. For example, it is assumed that an object indicating the portion (A) of the target device 2 and an operation instruction are input as the input information D21 such as "move A". In a case where there are a plurality of candidates for the place where A is moved, the input processing unit 240 may perform an inquiry D27 such as "Where do you move A?", or may perform an inquiry D27 indicating an option such as "Move A to X or Y". Alternatively, for example, in a case where there are many instructions to move A to X from the past results, the input processing unit 240 may perform an inquiry D27 such that the answer can be made with a yes/no answer by indicating options in descending order of possibility, such as "Would you like to move A to X?".

Furthermore, in a case where the instruction of the above (5) is input, in a case where the task is unclear or the order of the task, the time interval of the task, the quantity, and the like are unclear, the input processing unit 240 may reinquire and confirm the unclear point. For example, the input processing unit 240 may make an inquiry D27 asking for a quantity in a case where a quantity such as "how many pieces of fried chicken are packed in a lunch box?" is required in response to an instruction of" packing fried chicken in a lunch box".

Furthermore, in a case where the instructions of (6), (7), and (8) described above are input, the input processing unit 240 may inquire again when designation of a target device or sensor is unclear. For example, the input processing unit 240 may ask again when the time for executing the instruction, the ON/OFF interval, and the ON/OFF condition are unclear.

Furthermore, in a case where a demonstrative word such as "that", "that", or "that" is used and it is determined that what the demonstrative word refers to is unclear, the input processing unit 240 may inquire again about the specific content of the instruction word. Further, if an instruction input in Japanese is automatically translated into English and the answer efficiency can be improved by adding "a", "the", or the like in English, the input processing unit 240 may execute such addition. Note that the format of the instruction for increasing the answer efficiency or the instruction for increasing the answer rate (constraints, rules, and the like regarding instructions for increasing the response rate) may be determined on the basis of past results. For example, the confirmation unit 220 may make a determination by using an evaluation result that is a result of evaluating the control command D22 obtained by inputting a command or the like to the learning model unit 200 in the past. Alternatively, the determination may be made by the user 1 based on experience using the control system 2000a in the past. Conversely, a form of an instruction to decrease the answer efficiency or an instruction to decrease the answer rate may be determined in advance, and in a case where the form of an instruction to decrease the answer efficiency or an instruction to increase the answer rate is input, the input processing unit 240 may determine that supplementation is necessary and inquire again about the instruction content. Note that, in a case where the correction is proposed to the user 1 using the evaluation result by the confirmation unit 220, the content corrected by the proposal unit 250 to the user 1 may be presented by sound, display, or the like, and the input processing unit 240 may receive an input of an answer from the user 1 regarding the content presented. Hereinafter, the information presented to the user 1 by the proposal unit 250 is also referred to as proposal information D29. In this case, when the user 1 inputs an answer indicating that there is no problem with the correction content proposed by the proposal unit 250, the correction content proposed by the proposal unit 250 is input to the input processing unit 240 as the input information D21.

Furthermore, in a case where an instruction other than language is input, such as a photograph or a moving image, the input processing unit 240 may prompt supplementation with language. For example, in a case where a moving image indicating work to be performed by the target device 2 is input, when it is difficult to distinguish the type of the target workpiece to be worked from the moving image, the type of the target workpiece may be asked again.

Note that the input processing unit 240 may present the input information D21 interpreted by the input processing unit 240 by sound, display, or the like, receive an input indicating that there is no problem with the presented content from the user 1, obtain permission of the user 1, and then output the model input data D21a to the learning model unit 200. Furthermore, in a case where the input processing unit 240 corrects the input information D21 by the reinquiry as exemplified above, the input processing unit may present a corrected instruction, that is, the model input data D21a (or information representing the content of the model input data D21a in a format that is easy for the user 1 to understand) to the user 1 by sound, display, or the like, and may obtain permission of the user 1 by receiving an input indicating that there is no problem with the presented content from the user 1, and then output the model input data D21a to the learning model unit 200. In addition, the input processing unit 240 may use information such as past records and restrictions on the device as described above at the time of the inquiry D27 for confirming an unclear point, and these may be included in the device information D23 stored in the device information storage unit 210. Alternatively, although not illustrated, an information storage unit that stores information used by the input processing unit 240 in the inquiry D27 may be provided separately from the device information storage unit 210.

As described in the second embodiment, even when an unskilled worker performs control or does not know a control command or the like of the target device 2 at the time of introduction of a new control device (including version upgrade), the use of the control system 2000 described in the second embodiment leads to improvement in work efficiency and performance. Furthermore, in trial run, operation at the time of start-up adjustment, teaching work of a robot or the like, and recovery when trouble occurs, an appropriate control command itself is not determined, and the worker may repeat trial and error regardless of whether or not the worker is a skilled worker. In addition, in a case where the target device 2 is a manufacturing device, a production system, or the like at the time of individual production, unique adjustment of the target device 2 is required. Even in such a case, by using the control system 2000 of the second embodiment, the worker only needs to input not the control command itself but the natural language, the image, and the text data as the input information D21, so that work efficiency and performance can be improved. In the present embodiment, similarly, the worker only needs to input not the control command itself but the natural language, the image, and the text data as the input information D21, so that work efficiency and performance can be improved.

The device information storage unit 210 stores the device information D23. As in the second embodiment, the device information D23 may include state information D25 indicating the state of the target device 2. Furthermore, in the present embodiment, the device information D23 may further include at least one of a manual (target device 2, devices constituting target device 2, a manual of a target system, and the like), specifications of the target device 2 or a device constituting the target device 2, computer aided design (CAD) information of the target device 2 or the target system, CAD information of a work object (target workpiece), layout information of a site where the target device 2 operates, qualification information of a user (operator), proficiency level (proficiency level) of the user (operator), native language information of the user (operator), recommendation prompts, and the like. The recommendation prompt can be used, for example, for processing of prompting an input according to the recommendation presented to the user, or converting the input of the user on the basis of information of the recommendation prompt, and causing the user to confirm whether there is a problem by displaying the converted result.

In response to input of the model input data D21a from the input processing unit 240, the learning model unit 200 outputs the control command D22 using the device information D23 stored in the device information storage unit 210. Also in the present embodiment, similarly to the second embodiment, the learning model unit 200 is a model and an operation environment thereof configured to output the control command D22 corresponding to the model input data D21a in response to input of the model input data D21a. The configuration of the learning model unit 200 may be basically similar to that of the learning model unit 100 in the first embodiment.

The learning model unit 200 outputs the control command D22 with the device information D23 as a constraint condition using, for example, a model generated by machine learning. For example, the learning model unit 200 may grasp the format of the control command D22 that can be received by the target device 2 using the manual, the target device 2, or the specification of the device constituting the target device 2, and generate and output the control command D22 according to the grasped format. In addition, in a case where the control command D22 output from the model (learning model) exceeds the allowable range or is an operation for which the route is to be corrected using the CAD information of the target device 2 or the target system, the CAD information of the object, and the layout information of the site where the target device 2 operates, the learning model unit 200 may notify the confirmation unit 220 of the fact.

Furthermore, the learning model unit 200 may determine whether or not the work corresponding to the control command D22 is the work permitted for the user 1 who has input the input information D21 on the basis of the user's credential, and in a case where the work is not permitted for the user 1, the learning model unit may notify the confirmation unit 220 that the work is not permitted without generating the corresponding control command D22. When notified of the work that is not permitted from the learning model unit 200, the confirmation unit 220 may notify the proposal unit 240 of the fact. As a result, the proposal unit 250 presents to the user 1 that the work is not permitted.

As described in the first embodiment, at least a part of the device information D23 may be used as an input in machine learning together with the model input data D21a. In this case, at least a part of the device information D23 is also used at the time of generating the model. That is, in this case, in response to input of the model input data D21a and the device information D23, the learning model unit 200 is a model and an operation environment thereof configured to output the control command D22 corresponding thereto. Note that information that does not change in the device information D23 may be incorporated into the model at the time of learning by machine learning, and may not be input to the learning model unit 200.

The confirmation unit 220 performs confirmation processing of verifying the state of the device corresponding to the input information D21. The state of the device includes a state of at least a part of the target device 2, the target system, and the target workpiece. The state of the device corresponding to the input information D21 is a state of the device related to the control command D22 generated on the basis of the input information D21, and includes a state of the device related to the control command D22 generated on the basis of the corrected information when the input information D21 is corrected. The information confirmation processing may be processing for causing the user 1 to confirm the state of at least a part of the target device 2, the target system, and the target workpiece.

When the confirmation unit 220 determines that it is necessary to correct the model input data D21a or the control command D22 on the basis of the confirmed result, it outputs the corrected model input data D21a or the control command D22 to the proposal unit 250. Furthermore, the proposal unit 250 may change the presentation method of the proposal information D29 on the basis of the proficiency level of the user in the device information D23 and the qualification information of the user. For example, the control command D22 itself may be presented to the user having a high proficiency level to request confirmation, or the information may be presented to the user having a low proficiency level in an easy-to-understand format such as a moving image or a natural language even if the user is not accustomed to the control of the target device 2.

In addition, the confirmation unit 220 may input the corrected model input data D21a or the control command D22 to the learning model unit 200. When receiving the model input data D21a corrected by the confirmation unit 220, the learning model unit 200 outputs the control command D22 with the corrected model input data D21a as an input. When receiving the corrected control command D22, the learning model unit 200 outputs the corrected control command D22 to the target device 2.

Specifically, the confirmation unit 220 performs, for example, the following verification processing. For example, the confirmation unit 220 receives the control command D22 from the learning model unit 200, performs a simulation that simulates the target device 2 or the target system on the basis of the received control command D22, and outputs a simulation result to the proposal unit 250 together with the control command D22. Note that, instead of the control command D22, the confirmation unit 220 may output information obtained by converting the control command D22 into a format that can be easily understood by the user 1 or the input information D21 (or the model input data D21a) together with the simulation result. When performing the simulation, the confirmation unit 220 may perform the simulation using the device information D23 stored in the device information storage unit 210. Furthermore, the confirmation unit 220 may generate data for displaying a simulation result in augmented reality (AR) and output the data to the proposal unit 250. The data for the AR display may be generated by the proposal unit 250. The confirmation unit 220 or the proposal unit 250 may generate a video using a learning model by machine learning that generates a video from information other than the image.

As a result of the simulation, the confirmation unit 220 may verify whether or not a defect such as occurrence of interference between the target device 2 and a surrounding object, occurrence of interference between the target device 2 and a target workpiece, or an operation in which the target device 2 deviates from an operation constraint occurs during the operation of the target device 2. When determining that a defect occurs, the confirmation unit 220 may perform correction by automatically generating an avoiding route for avoiding interference, and when performing correction, the confirmation unit may output the correction amount to the proposal unit 250 together with information indicating the operation of the target device 2 after correction. The proposal unit 250 may present the correction amount and the information indicating the operation of the target device 2 after the correction to the user 1. The user 1 may re-input the input information D21 on the basis of the correction amount, or may input to the effect that the correction amount is approved. When receiving the response indicating that the correction amount is approved, the input processing unit 240 transmits the fact that the correction amount is approved to the confirmation unit 220 via the learning model unit 200 or directly, and the confirmation unit 220 outputs the control command D22 reflecting the correction amount to the learning model unit 200. Note that the proposal unit 250 may receive an answer indicating that the correction amount is approved, and the proposal unit 250 may transmit the answer to the confirmation unit 220. Furthermore, the user 1 may correct the correction amount presented by the proposal unit 250, and in a case where the correction is made, the correction amount after the correction is transmitted to the confirmation unit 220.

Furthermore, the confirmation unit 220 may output the intermediate language to the proposal unit 250 to cause the proposal unit 250 to display the intermediate language and request the user 1 to confirm the intermediate language. For example, in a case where the control command D22 output from the learning model unit 200 is a robot language, a machine language, a ladder language, binary data, or the like, the intermediate language may be a natural language that specifically indicates the operation of the target device 2, may be a programming language that is easy for the user 1 to understand, such as Pyson or C language, or may be other languages. The confirmation unit 220 converts the control command D22 into an intermediate language and causes the proposal unit 250 to display a code described in the intermediate language. Similarly to the above, the input processing unit 240 or the proposal unit 250 receives the answer of the user 1 regarding the content proposed by the proposal unit 250 and transmits the answer to the confirmation unit 220. In a case where the user 1 has approved, the confirmation unit 220 notifies the learning model unit 200 that the control command D22 has been approved. Alternatively, the confirmation unit 220 may output the approved control command D22 to the learning model unit 200. When the code written in the intermediate language is corrected by the user 1, the confirmation unit 220 corrects the control command D22 based on the correction and outputs the corrected control command D22 to the learning model unit 200. Upon being notified of the approval by the confirmation unit 220, the learning model unit 200 outputs the control command D22 to the target device 2. When receiving the control command D22 (including the corrected control command D22) from the confirmation unit 220, the learning model unit 200 outputs the received control command D22 to the target device 2.

Note that the learning model unit 200 may have an intermediate language generation function. For example, the learning model unit 200 may operate using both the first learning model that outputs the intermediate command that is the command of the intermediate language from the model input data D21a and the second learning model that generates the control command D22 from the intermediate language. In this case, the learning model unit 200 outputs the intermediate command obtained by inputting the model input data D21a to the first learning model to the confirmation unit 220, and outputs the control command D22 to the target device 2 by inputting the intermediate language approved by the user 1 to the second learning model. Alternatively, the learning model unit 200 may output the intermediate language to the input processing unit 240, and the input processing unit 240 may present the intermediate language to the user 1. Then, in a case where an input indicating approval of the intermediate language is received from the user 1, the input processing unit 240 may notify the learning model unit 200 of the approval, and the learning model unit 200 may generate the control command D22 using the intermediate language when receiving the notification of the approval.

Furthermore, the confirmation unit 220 may generate a sound indicating the operation corresponding to the control command D22 or a sound indicating the operation corresponding to the simulation result, and output the generated sound to the proposal unit 250, thereby causing the proposal unit 250 to present the sound to the user 1. The suggestion unit 250 may generate a sound. Similarly to the above, the input processing unit 240 or the proposal unit 250 receives the answer of the user 1 regarding the content proposed by the proposal unit 250 and transmits the answer to the confirmation unit 220.

Furthermore, the confirmation unit 220 may cause the proposal unit 250 to present the work content for each step. For example, the confirmation unit 220 sets one command sentence unit or another determined operation unit of the control command D22 as a step, and outputs information indicating the operation corresponding to the control command D22 or a simulation result to the proposal unit 250 for each step. The information indicating the operation may be the control command D22 itself, may be described in the above-described intermediate language, may be a moving image or sound, or may be text data. The input processing unit 240 or the proposal unit 250 receives the answer of the user 1 regarding the content proposed by the proposal unit 250 and transmits the answer to the confirmation unit 220 for each step in the same manner as described above.

In addition, the confirmation unit 220 may generate a control command for idling the target device 2 on the basis of the control command D22 output by the learning model unit 200 and output the control command to the learning model unit 200 to idling the target device 2. Examples of the idle operation include, but are not limited to, operating the target device 2 in a state where there is no target workpiece, and operating the target device 2 using a dummy workpiece instead of the target workpiece. The confirmation unit 220 may cause the suggestion unit 250 to present the operation result to the user 1 by acquiring the operation result indicating the state of the target device 2 during the idle operation from the target device 2 and outputting the acquired operation result to the suggestion unit 250. As a result, the user 1 evaluates the operation of the target device 2, and if there is no problem, inputs that the operation is approved, and if correction is necessary, inputs the corrected input information D21. When the input processing unit 240 receives the corrected input information D21, the same operation as the operation described above is performed, and the idle operation is performed again. The user 1 may directly check the target device 2 during the idle operation to evaluate the operation of the target device 2.

In addition, the confirmation unit 220 may calculate the reliability index or information corresponding to the reliability index and cause the proposal unit 250 to present the calculated reliability index or information corresponding to the reliability index. Details of the reliability index will be described later. The user 1 refers to the reliability index or the information corresponding to the reliability index presented to the proposal unit 250, approves the execution of the operation if there is no problem, and inputs the corrected input information D21 if correction is necessary.

In addition, the confirmation unit 220 may perform a general error check at the language level on the control command D22 output from the learning model unit 200 on the basis of the language of the control command D22, and in a case where there is an error, may automatically correct the error and output the correction result to the learning model unit 200. Alternatively, in a case where there is an error, the confirmation unit 220 may cause the proposal unit 250 to present an error, and the input processing unit 240 or the proposal unit 250 may receive an input of a correction result of the error from the user 1, thereby transmitting the correction result to the confirmation unit 220. Alternatively, the confirmation unit 220 may cause the proposal unit 250 to present an error correction proposal and obtain approval from the user 1.

Furthermore, the confirmation unit 220 may cause the proposal unit 250 to present at least one of the information such as the simulation result, the correction amount, and the reliability index described above, so that the user 1 may perform evaluation on the basis of the presented information, correct the input information D21 on the basis of the evaluation result, and input the corrected input information D21. By receiving the corrected input information D21, the input processing unit 240 performs an operation similar to the operation described above, and confirmation corresponding to the corrected input information D21 is performed again, and the proposal unit 250 similarly presents information. The user 1 confirms the presented information again, evaluates the presented information, corrects the input information D21 when correction is necessary, and inputs the corrected input information D21. These processes may be repeated until the user 1 stops performing correction, that is, until the user 1 approves the correction. Furthermore, the confirmation unit 220 may calculate an evaluation function using at least one of the above-described information and perform feedback on the basis of the evaluation function. The evaluation function is, for example, but not limited to, at least one of an operation time of the target device 2, power consumption, a movement distance of the distal end portion of the target device 2, the number of commands used, and the like.

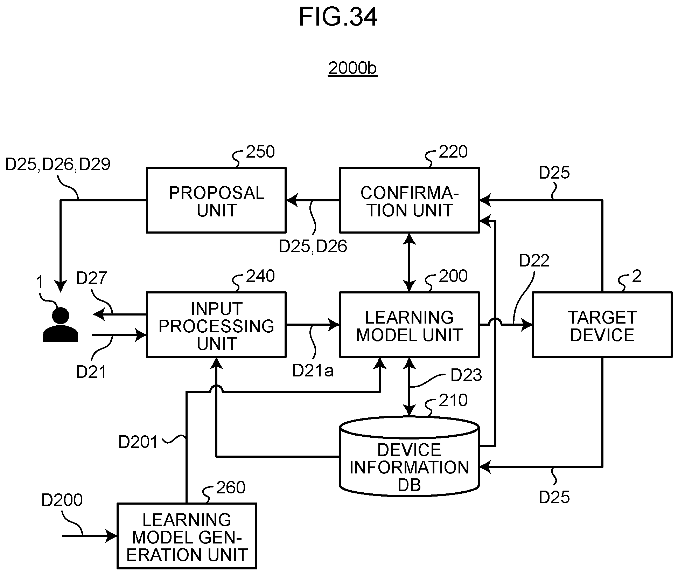

In addition, a function of generating a model may be added to the control system 2000a. FIG. 34 is a configuration diagram illustrating an example of a control system 2000b according to the sixth embodiment having a function of generating a model. A control system 2000b illustrated in FIG. 34 is similar to the control system 2000a illustrated in FIG. 33 except that a learning model generation unit 260 that generates a model is added. The learning model generation unit 260 is similar to the model generation unit 107 described in the first embodiment. The model learning data D200 input to the model generation unit 107 is similar to the model learning data D105 described in the first embodiment, and the model information D201 is similar to the model information D102 of the first embodiment.

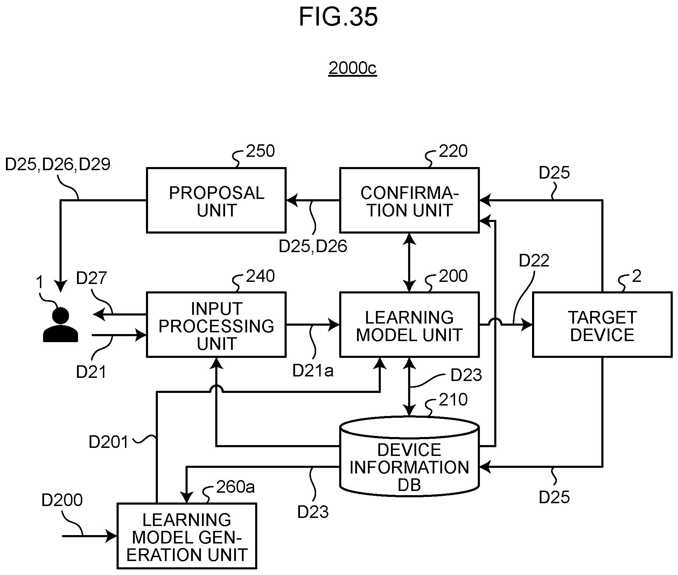

Furthermore, as described above, the device information D23 may be input at the time of learning. FIG. 35 is a configuration diagram illustrating an example of the control system 2000c according to the sixth embodiment in a case where the device information D23 is input at the time of learning. A control system 2000c illustrated in FIG. 35 is similar to the control system 2000a illustrated in FIG. 33 except that a learning model generation unit 260a that generates a model is added. The learning model generation unit 260a performs learning using the model learning data D200 and the device information D23 as inputs. Note that, in the example illustrated in FIG. 35, the device information D23 is also input as an input to the model when the learning model unit 200 is used.

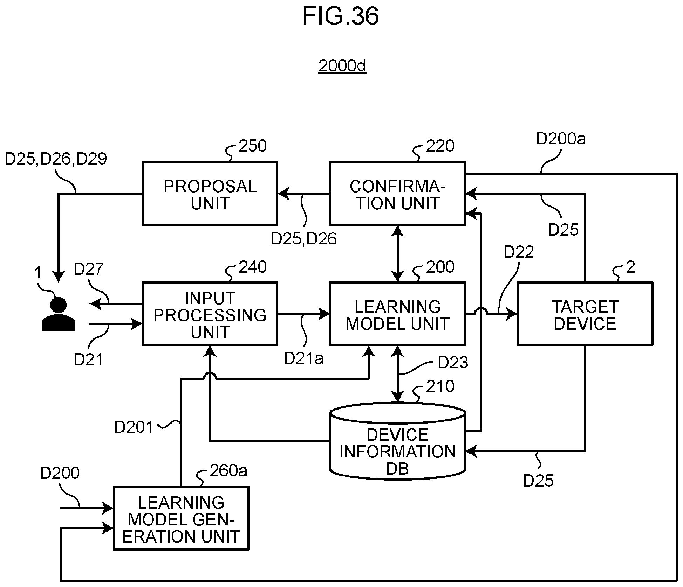

Furthermore, relearning may be performed using information obtained at the time of using the learning model unit 200. FIG. 36 is a configuration diagram illustrating an example of a control system 2000d according to the sixth embodiment in a case where relearning is performed. The control system 2000d illustrated in FIG. 36 is similar to the control system 2000a illustrated in FIG. 33 except that a learning model generation unit 260 that generates a model is added and model learning data D200a for relearning is input from the confirmation unit 220 to the learning model generation unit 260. The learning model generation unit 260 performs learning using the model learning data D200 as an input. Furthermore, the learning model generation unit 260 performs relearning using the model learning data D200a as an input. The model learning data D200a includes information input to the learning model unit 200and an output of the learning model unit 200 in a case where a result corresponding to the input is good.

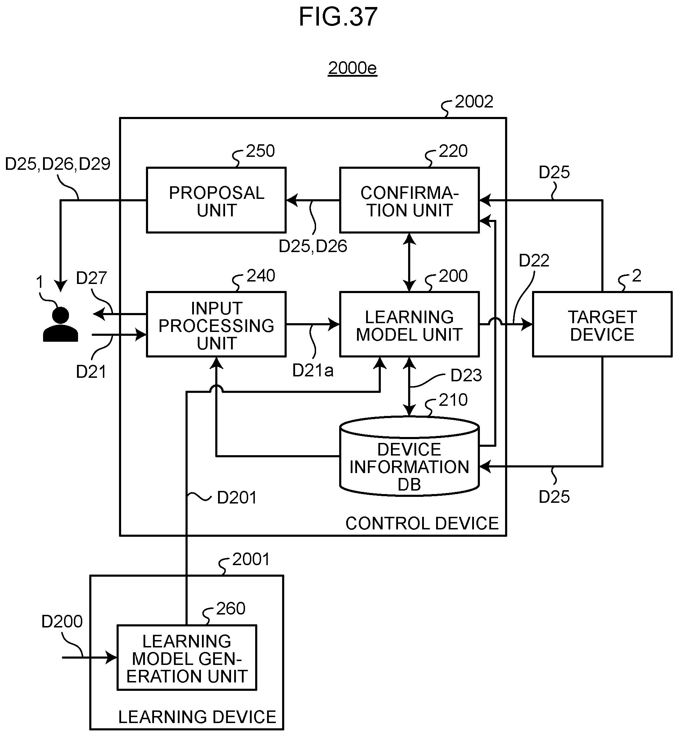

FIG. 37 is a configuration diagram illustrating an example of a control system 2000e according to the sixth embodiment including the learning device 2001. The example illustrated in FIG. 37 includes a learning device 2001 and a control device 2002. The control device 2002 includes a learning model unit 200 similar to that in the example illustrated in FIG. 34, a device information storage unit 210, a confirmation unit 220, a proposal unit 250, and an input processing unit 240, and the learning device 2001 includes a learning model generation unit 260 similar to that in the example illustrated in FIG. 34. As described above, the learning device 2001 and the control device 2002 may be different devices. Furthermore, the learning device 2001 may be provided separately from the control system 2000e. Also in the examples described in FIGS. 34 to 36, the learning device and the control device may be divided. Furthermore, the learning model unit 200 may be an independent device and may be provided in the control systems 2000a to 2000e or outside the control systems 2000a to 2000e.

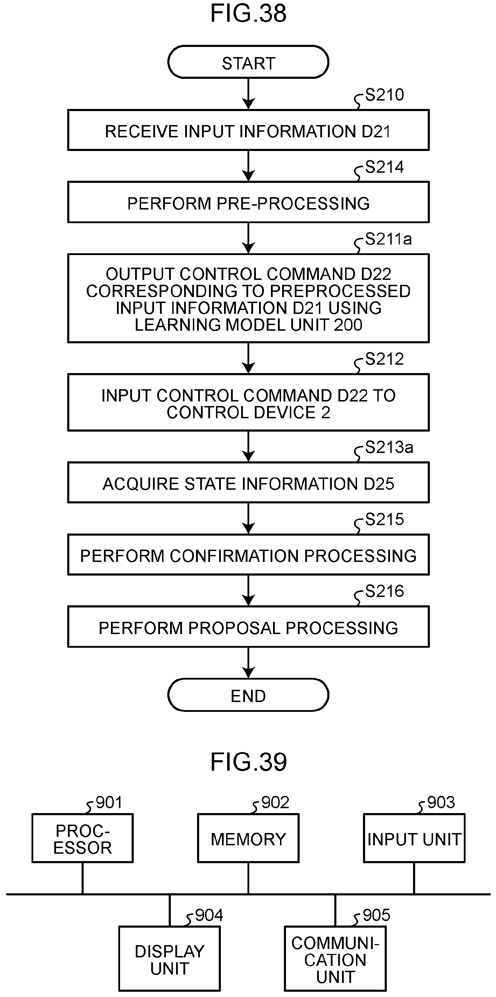

FIG. 38 is a flowchart illustrating an operation example of the control system 2000a according to the sixth embodiment. Although the control system 2000a will be described below as an example, the same operation is performed in the control systems 2000b to 2000e.

Step S210 is the same as that in the second embodiment. After step S210, the control system 2000a performs preprocessing (step S214). Specifically, the input processing unit 240 performs preprocessing on the input information D21, and outputs the preprocessed input information D21 (model input data D21a) to the learning model unit 200.

The control system 2000a generates the control command D22 corresponding to the preprocessed input information D21 using the learning model unit 200 (step S211a). Step S211a is similar to step S211 of the second embodiment except that the input information D21 is the preprocessed input information D21.

Step S212 is the same as that in the second embodiment. Note that FIG. 38 illustrates an example in which confirmation is performed by idle operation or the like. Therefore, although step S212 is performed after step S211a, in a case where the confirmation processing is performed without operating the target device 2, steps S212 and S213a are not performed after step S211a, and steps S212 and S213a are performed after the operation is approved by the user 1 after steps S215 and S216 to be described later.

In step S213a, the control system 2000a acquires the state information D25. The acquisition of the state information D25 in step S213a is similar to the acquisition of the state information D25 in the second embodiment. Note that, as in Embodiment 2, the processing in step S213a is not essential and may be omitted as appropriate. When the feedback information is obtained from the target device 2, the control system 2000a may also obtain the feedback information in step S213a.

The control system 2000a performs confirmation processing (step S215). Specifically, the confirmation unit 220 performs confirmation processing. The control system 2000a performs the suggestion processing (step S216). Specifically, the proposal unit 250 presents information to the user 1 on the basis of a result of the confirmation processing of the confirmation unit 220. After the information is presented in step S216, in a case where there is an input indicating that the user 1 approves the operation, the control system 2000a confirms the control command D22 output in step S211a, and outputs the control command D22 to the target device 2, whereby the formal operation by the target device 2 is performed. After the information is presented in step S216, when the user 1 corrects the input information D21 and the control system 2000a receives the corrected input information, the processing from step S210 is repeated again.

Through the above processing, when the user 1 inputs an instruction related to the operation of the target device 2 as the input information D21 in a natural language, an image, or the like, the control command D22 in a format that can be received by the target device 2 is generated and the target device 2 operates. As a result, the control command D22 can be efficiently generated even in a case where the knowledge of the creation of the control command D22 by the user 1 is not sufficient, in a trial run, in an operation at the time of start-up adjustment, in a teaching work of a robot or the like, and in recovery when a trouble occurs. Further, in the present embodiment, the target device 2 can be prevented from being operated by the inappropriate control command D22 by performing the checking process of checking whether the appropriate control command D22 is generated and performing the input again when the control command is inappropriate. In addition, by performing the preprocessing by the input processing unit 240, correction can be performed before the input to the learning model unit 200 in a case where the input is unclear, and thus, the control command D22 can be efficiently generated. Note that the input processing unit 240, the confirmation unit 220, and the proposal unit 250 are not essential, and at least some of them may not be provided. For example, the input processing unit 240 may not be provided.

Next, a hardware configuration of the control system 2000a will be described. In control system 2000a of the present exemplary embodiment, a program (computer program) in which processing in control system 2000a is described is executed on a computer system, so that the computer system functions as control system 2000a. FIG. 39 is a diagram illustrating an exemplary configuration of a computer system that implements the control system 2000a according to the present embodiment. As illustrated in FIG. 39, the computer system includes a processor 901, a memory 902, an input unit 903, a display unit 904, and a communication unit 905, which are connected via a system bus. The processor 901 and the memory 902 constitute processing circuitry.

In FIG. 39, the processor 901 is, for example, a processor such as a CPU or a graphics processing unit (GPU), and executes a program in which processing in the control system 2000a of the present embodiment is described. The input unit 903 includes, for example, a keyboard, a mouse, a microphone, and the like, and is used by a user of the computer system to input various types of information. The memory 902 includes various types of memories such as a random access memory (RAM) and a read only memory (ROM) and a storage device such as a hard disk, and stores programs to be executed by the processor 901 and necessary data obtained during processing. The memory 902 is also used as a temporary storage area for programs. The display unit 904 includes a display, a liquid crystal display (LCD), and the like, and displays various screens for a user of the computer system. Note that the input unit 903 and the display unit 904 may be integrated and implemented by a touch panel. The communication unit 905 is a receiver and a transmitter that perform communication processing. Note that FIG. 39 is an example, and the configuration of the computer system is not limited to the example illustrated in FIG. 39. For example, the computer system that implements the control system 2000a may not include the communication unit 905. Furthermore, the computer system may include a speaker (not illustrated).

Here, an example of how the computer system operates until the program according to the present embodiment becomes executable will be described. In the computer system having the above-mentioned configuration, for example, the program is installed on an auxiliary storage device that is a part of the memory 902 from a compact disc (CD)-ROM or digital versatile disc (DVD)-ROM set in a CD-ROM drive or DVD-ROM drive (not illustrated). Then, when the program is executed, the program read from the auxiliary storage device of the memory 902 is stored in the main storage area of the memory 902. In this state, the processor 901 executes the processing as the control system 2000a of the present embodiment according to the program stored in the memory 902.

In the above description, the program describing the processes in the control system 2000a provided using a CD-ROM or DVD-ROM as a recording medium. Alternatively, the program may be provided by a transmission medium such as the Internet via the communication unit 905 according to the configuration of the computer system, the capacity of the program, and the like.

The learning model unit 200 and the confirmation unit 220 illustrated in FIG. 33, the learning model unit 200 and the confirmation unit 220 illustrated in FIG. 33 are implemented by the processor 901 illustrated in FIG. 39 executing the program stored in the memory 902 illustrated in FIG. 39. The memory 902 is also used to implement the learning model unit 200 and the confirmation unit 220. The device information storage unit 210 illustrated in FIG. 33 is a part of the memory 902 illustrated in FIG. 39. The input processing unit 240 illustrated in FIG. 33 is implemented by the input unit 903 and the processor 901 illustrated in FIG. 39. In order to implement the input processing unit 240, the memory 902 may also be used, or a speaker (not illustrated) may be used. The proposal unit 250 illustrated in FIG. 33 is implemented by the display unit 904 and the processor 901 illustrated in FIG. 39. The memory 902 may also be used to implement the proposal unit 250. Furthermore, the input unit 903 may be used to implement the proposal unit 250, or a speaker (not illustrated) may be used. Note that, in a case where the input from the user 1 is performed via a device such as a user terminal, the communication unit 905 is used to implement the input processing unit 240. Furthermore, in a case where the proposal unit 250 presents information via the user terminal, the communication unit 905 is used to implement the proposal unit 250.

Similarly, the control systems 2000b to 2000e are implemented by the computer system illustrated in FIG. 39. Each of the control systems 2000a to 2000e may be implemented by a plurality of computer systems. At least a part of the control systems 2000a to 2000e may be implemented by a cloud computer system.

Next, a specific example of the reliability index calculated by the confirmation unit 220 will be described. The first to fourth methods described below are examples, and the reliability index calculated by the confirmation unit 220 is not limited thereto. Note that the time of preliminary learning in the first method to the fourth method may be the time of learning of the model used by the learning model unit 200, or may include a scene in which the learning model unit 200 uses the model, that is, a scene in which inference is performed by the learning model unit 200.

First, a first method will be described. For example, at the time of preliminary learning, every time learning data is input to the model, a person evaluates a result corresponding to the learning data. Specifically, at the time of evaluation before actual use, an output of a model is generated under a plurality of conditions, and an evaluation result evaluated by a person is recorded. As the evaluation result, for example, a definition can be used in which 1 is set when the operation of the target device 2 succeeds and 0 is set when the operation fails, but the definition is not limited thereto. At this time, the evaluation result may include correction information indicating which point should be corrected. The result corresponding to the learning data may be an operation result of the target device 2 or a simulation result. A plurality of data sets including model input data D101 in learning data at the time of learning in advance and an evaluation result (by a person) corresponding to the model input data D101 are accumulated, and a learning model for evaluation is generated by machine learning using the plurality of data sets. As the machine learning, for example, supervised learning by a neural network, a support vector machine, or the like can be used, but the machine learning is not limited thereto. Note that the learning model for evaluation may be subjected to additional learning not only at the time of preliminary learning but also by using, as an input, a data set including model input data D21a obtained by inputting the input information D21 from the user 1 and an evaluation result for the model input data D21a, which is obtained at the time of using the learning model unit 200. The evaluation result is obtained, for example, by a person evaluating the operation result of the target device 2 based on the control command D21 or the control command D22 obtained by inputting the model input data D22 a to the learning model unit 200.

The confirmation unit 220 obtains an evaluation result by inputting the model input data D21a to the learning model for evaluation. The confirmation unit 220 can use this evaluation result as a reliability index. The higher the evaluation result, the higher the reliability. The confirmation unit 220 outputs the evaluation result to the proposal unit 250, and the proposal unit 250 presents the evaluation result to the user 1 as the reliability index. In addition, the proposal unit 250 may present the correction required point on the basis of the correction information in the evaluation result and display a message prompting correction of the correction required point, or may prompt correction of the correction required point by sound. Note that the input processing unit 240 may also have a function as the confirmation unit 220, and the input processing unit 240 may obtain an evaluation result by inputting the input information D21 to the learning model for evaluation, and perform inquiry again according to the evaluation result. The evaluation model generation unit that generates the learning model for evaluation may be included in the confirmation unit 220, may be provided in the control system 2000a separately from the confirmation unit 220, or may be included in a learning device outside the control system 2000a.

Next, a second method will be described. The confirmation unit 220 uses a learning device that clusters the control command D22 (combination of the trajectory and the operation command of the target device 2) that is the output of the learning model unit 200. The learning device performs learning such as a threshold for performing clustering using the control command D22 obtained at the time of preliminary learning. When using the learning model unit 200, the confirmation unit 220 performs clustering by inputting the control command D22 output from the learning model unit 200 to the learning device. Examples of the clustering method include a k-means method and an x-means method, but are not limited thereto. When the learning model unit 200 is used, the confirmation unit 220 obtains a clustering result by inputting the control command D22 output from the learning model unit 200 to the learning device and outputs the clustering result to the proposal unit 250, and the proposal unit 250 presents the clustering result to the user 1 as information corresponding to the reliability index. The user 1 refers to the clustering result and checks whether or not the cluster is classified into a normal cluster. When the cluster is classified into a normal cluster, it is considered that the reliability is high. The normal cluster may be determined by, for example, a person based on the clustering result, or a cluster into which the normal control command D22 is input and the control command D22 is clustered may be determined as a normal cluster.

Next, a third method will be described. At the time of preliminary learning, every time learning data is input to the model, a person evaluates a result corresponding to the learning data, and learns a feature of an input having a high evaluation result (model input data D101 in the learning data). Specifically, at the time of evaluation before actual use, an output of a model is generated under a plurality of conditions, the generated output is evaluated by a person, and input data having a high (good) evaluation result is extracted. Then, for example, the feature extracted from the input data having a high evaluation result is accumulated, and the confirmation unit 220 extracts the feature from the model input data D 21a input to the learning model unit 200 at the time of using the learning model unit 200, and compares the extracted feature with the accumulated feature. The confirmation unit 220 calculates the reliability index according to the closeness between the extracted feature and the accumulated feature. For example, the confirmation unit 220 may calculate a distance between the extracted feature and the accumulated feature, and determine the reliability index according to the distance such that the reliability becomes high when the distance is short. The confirmation unit 220 outputs the reliability index to the proposal unit 250, and the proposal unit 250 presents the reliability index to the user 1.

Specifically, for example, the features extracted from the model input data D21a are clustered, an evaluation result corresponding to each cluster is obtained, and a normal cluster is determined. For example, the confirmation unit 220 may calculate an average value of the evaluation results corresponding to the inputs belonging to each cluster as the evaluation results corresponding to each cluster, or may calculate a minimum value (worst value) of the evaluation results. In a case where the evaluation result indicates that the larger the value, the better the result, the confirmation unit 220 may set a cluster of which the evaluation result is equal to or more than the threshold as a normal cluster and accumulate the feature belonging to the normal cluster as the feature extracted from the input data having a high evaluation result. In a case where the evaluation result indicates that the smaller the value, the better the result, the confirmation unit 220 sets a cluster whose evaluation result is equal to or less than the threshold as a normal cluster.

Next, a fourth method will be described. At the time of preliminary learning, every time learning data is input to a model, a person evaluates a result corresponding to the learning data, and a learning device that performs learning for clustering inputs (model input data D101 in the learning data) based on the evaluation result is used. For example, the learning device calculates a threshold value or the like of each cluster using the input of the learning data, and calculates an evaluation result of each cluster. For example, the learning device may calculate an average value of evaluation results corresponding to inputs belonging to each cluster, or may calculate a minimum value (worst value) of the evaluation results. Then, a normal cluster is determined on the basis of the evaluation result of each cluster. When the learning model unit 200 is used, the confirmation unit 220 may perform clustering by inputting the model input data D21a to the learning device, and may consider that the reliability is high when the model input data D21a is classified into a normal cluster. The confirmation unit 220 outputs a result of whether or not the cluster is classified into a normal cluster to the proposal unit 250, and the proposal unit 250 presents the result to the user 1 as information corresponding to the reliability index.

For the determination of the feature in the third method, for example, the following methods 1 and 2 can be used, but the method is not limited thereto. When the input information itself such as the model input data D21a is used as the feature, the information amount generally increases. Therefore, for example, when the feature obtained by reducing the dimension of the input information is used as in the following proposals 1 and 2, the calculation load can be reduced. In addition, the feature may be calculated by the method of the following proposal 3.

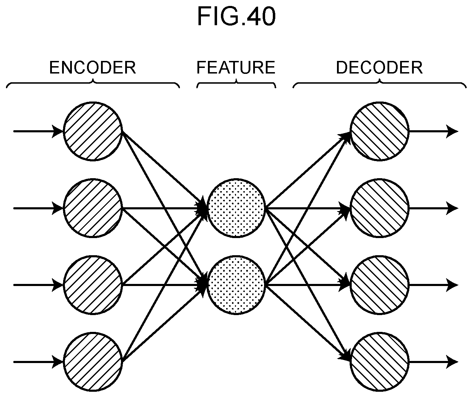

Proposed technique 1 is a method for determining a feature value using an autoencoder. For example, at the time of preliminary learning, a feature is learned by an autoencoder using an input of learning data to a model. FIG. 40 is a diagram illustrating an outline of an autoencoder according to the present embodiment. As an input to the encoder of the autoencoder and an output of the decoder, the autoencoder is caused to perform learning using input information input to the model. Then, the output of the intermediate layer of the autoencoder is determined as the feature. Then, at the time of preliminary learning, input information to the model is input to the autoencoder to acquire an output of the intermediate layer as a feature, and the feature belonging to a normal cluster is obtained and accumulated using the feature. When the learning model unit 200 is used, the confirmation unit 220 inputs the model input data D21a input to the learning model unit 200 to the audo encoder, and acquires the output of the intermediate layer as the feature. The confirmation unit 220 calculates the reliability index by comparing the acquired feature with the accumulated feature as described above.

Proposed technique 2 is a method of using, as a feature, information obtained by reducing the dimension of input information by using an input of learning data to a model during preliminary learning. Examples of the means for reducing the dimension include principal component analysis (PCA) and kernel PCA, but are not limited thereto. When the learning model unit 200 is used, the confirmation unit 220 calculates the feature by reducing the dimension of the model input data D21a input to the learning model unit 200 by the dimension reducing means.

Proposed technique 3 is a method in which the use frequency of the command in the control command D22 output from the model is used as the feature. For example, the confirmation unit 220 calculates the type of the operation command output as the control command D22 from the model and the number of times the command is used as the feature.

In the first method, the supervised learning may be performed using the feature extracted from the input information (input data) to the model and the evaluation result as a data set. The first method to the fourth method are examples, and the reliability index may be calculated by machine learning for evaluation as described above. The method of generating the reliability index using the machine learning for evaluation is not limited to the above example. For example, the reliability index may be calculated by supervised learning using a feature extracted from input data to the learning model unit 200 or a feature extracted from an output of the learning model unit 200 and an evaluation result that is correct data. The feature may be the input data itself or the output data itself. Furthermore, the reliability index may be calculated by unsupervised clustering or supervised clustering using the feature extracted from the input data to the learning model unit 200 or the feature extracted from the output of the learning model unit 200. Also in this case, the feature may be the input data itself or the output data itself. To summarize the above, for example, the reliability index can be calculated by performing clustering or learning of a supervised regression model using either input data to the model or a feature extracted from output data from the model. The feature may be the input data itself, may be the output data itself, may be calculated by any one of proposal 1, proposal 2, and proposal 3 described above, or may be calculated by a method other than these methods.

Since there is a possibility that the model used by the learning model unit 200 at the initial stage is a versatile model, additional learning based on the evaluation result by the confirmation unit 220 may be performed so that the appropriate control command D22 can be generated according to the object such as the target workpiece. As a result, update to the model according to the object and the target device 2 is implemented. In addition, additional learning may be performed after distilling the model.

In addition, as described above, the learning model unit 200 may use two learning models of the learning model that outputs the model input data D21a or the intermediate result described in the intermediate language and the learning model that outputs the control command D22 from the intermediate result. Furthermore, learning may be performed using a program database. In addition, the control systems 2000a to 2000e may include a module that supports prompt engineering. Furthermore, by performing trial and evaluation in advance, an optimal prompt may be determined by reinforcement learning or the like.

The exemplary embodiments and modifications are not limited to the examples described above, and can be modified as appropriate within the scope of the disclosure.

The control system and the control method according to the present disclosure include the control system and the control method described in the following supplementary notes.

### (Supplement 1)

A control system for supporting work by a person or an object using a device, the control system including:
an input interface configured to receive an input of first information indicating a situation or a demand in a work environment that is an environment in which the work is performed;
a model processing unit provided to be able to access a predetermined learning model; and
an output interface that outputs second information for supporting the work on the basis of an output from the learning model, wherein
the model processing unit inputs model input data based on the first information to the learning model and receives model output data corresponding to the model input data from the learning model,
the model output data includes information used for the work, and
the output interface outputs the second information based on the model output data.

### (Supplement 2)

The control system according to supplement 1, wherein
the first information includes information indicating a control content or an operation content requested to the device,
the model input data is data in which a control content or an operation content indicated by the first information is indicated in a format matching an input of the learning model,
the model output data includes information used for control or operation of the device, the information corresponding to a control content or an operation content indicated by the model input data, and
the second information includes information in which information to be used for controlling or operating the device included in the model output data is described in a predetermined format that is discriminable in an output destination of the output interface.

### (Supplement 3)

The control system according to supplement 2, wherein
an output destination of the output interface is the device or an interface that requests the device to perform control, and
the device is controlled as a result of outputting the second information to the device or an interface requesting control from the device.

### (Supplement 4)

The control system according to supplement 2, further including:
an execution code generation unit that generates and outputs an execution code that is a code executable by the device, wherein
an output destination of the output interface is the execution code generation unit, and
the device is controlled by an execution code generated as a result of outputting the second information to the execution code generation unit.

### (Supplement 5)

The control system according to supplement 2, wherein
an output destination of the output interface is a terminal operated by a user, and
the device is controlled as a result of outputting the second information to the terminal.

### (Supplement 6)

The control system according to supplement 1, wherein,
the first information includes information indicating a situation in the work environment,
the model input data is data in which a situation of the work environment indicated by the first information is indicated in a format that matches an input of the learning model,
the model output data includes an analysis result of a situation of the work environment indicated by the model input data and/or information on a method for improving the situation, and
the second information includes information in which an analysis result of a situation in the work environment and/or information regarding a method of improving the situation are described in a predetermined format that is discriminable at an output destination of the output interface.

### (Supplement 7)

The control system according to supplement 1, wherein
the model processing unit is provided to be accessible to a first learning model and a second learning model,
the model processing unit inputs first model input data based on the first information to the first learning model, and receives first model output data corresponding to the first model input data from the first learning model,
the model processing unit inputs second model input data based on the first model output data to the second learning model, and receives second model output data corresponding to the second model input data from the second learning model, and
the output interface outputs the second information based on the second model output data.

### (Supplement 8)

The control system according to supplement 7, wherein
the first information includes information indicating a control content or an operation content requested to the device,
the first model input data is data in which a control content or an operation content indicated by the first information is indicated in a format matching an input of the first learning model,
the first model output data includes information in which a control content or an operation content indicated by the first model input data is indicated by being more generalized or embodied,
the second model input data is data in which a control content or an operation content indicated by the first model output data is indicated in a format that matches an input of the second learning model,
the second model output data includes information used for control or operation of the device, the information corresponding to a control content or an operation content indicated by the second model input data, and
the second information includes information in which information used for controlling or operating the device included in the second model output data is described in a predetermined format that is discriminable in an output destination of the output interface.

### (Supplement 9)

The control system according to supplement 7, wherein
the first information includes information indicating a situation in the work environment,
the first model input data is data in which a situation of the work environment indicated by the first information is indicated in a format matching an input of the first learning model,
the first model output data includes an analysis result of a situation of the working environment indicated by the model input data,
the second model input data is data in which an analysis result of a situation of the work environment indicated by the first model output data is indicated in a format that matches an input of the second learning model,
the second model output data includes information related to a method of improving a situation in the working environment corresponding to an analysis result of the working environment indicated by the second model input data, and
the second information includes information in which at least information regarding a method for improving a situation in the work environment included in the second model output data is described in a predetermined format that is discriminable in an output destination of the output interface.

### (Supplement 10)

The control system according to supplement 1, wherein
the work is a response by a person or an object using a device,
the first information includes information indicating a reaction request content which is a content for which a reaction is requested in the working environment,
the model input data is data in which a reaction request content indicated by the first information is indicated in a format matching an input of the learning model,
the model output data includes information used for the response, the information corresponding to a reaction request content indicated by the model input data, and
the second information includes information in which information used for the response included in the model output data is described in a predetermined format that is discriminable in an output destination of the output interface.

### (Supplement 11)

The control system according to supplement 3, wherein
an output destination of the output interface is a screen operation interface that requests the device to perform control via an operation screen, and
the model output data is an operation screen for actually performing an operation corresponding to a control content or an operation content indicated by the model input data on the device, and includes information of an operation screen described in a predetermined format discriminable at an output destination of the output interface.

### (Supplement 12)

The control system according to any one of supplements 1 to 11, wherein
the input interface receives an input of the first information indicating a request in the work environment from a plurality of users, and
the model processing unit inputs the model input data including the first information input from the plurality of users to the learning model and receives the model output data corresponding to the model input data from the learning model.

### (Supplement 13)

The control system according to any one of supplements 1 to 12, wherein
the learning model is a language learning model that inputs a natural language and obtains an output result, an image learning model that inputs an image and obtains an output result, and a multimodal model that inputs a natural language and an image and obtains an output result.

### (Supplement 14)

The control system according to any one of supplements 1 to 13, wherein
the model processing unit is provided to be accessible to a first learning model and a second learning model,
one of the first learning model and the second learning model is a local learning model in which a reference destination database is limited to internal information, and
the other of the first learning model and the second learning model is a global learning model in which a reference destination database is not limited to internal information.

### (Supplement 15)

The control system according to any one of supplements 1 to 13, wherein
the model processing unit is provided to be accessible to a first learning model and a second learning model,
one of the first learning model and the second learning model is a learning model that can refer to information particularly determined in the work environment, and
the other of the first learning model and the second learning model is a learning model to which information particularly determined in the work environment cannot be referred.

### (Supplement 16)

The control system according to any one of supplements 1 to 15, including:
an output confirmation unit that performs a simulation that simulates control and a state of the device on the basis of model output data output from the learning model.

### (Supplement 17)

The control system according to any one of supplements 1 to 16, wherein
additional learning of the learning model, correct/incorrect determination of output information, and flow control of output information are performed on the basis of information collected from an output destination of the output interface.

### (Supplement 18)

The control system according to any one of supplements 1 to 17, including:
an input processing unit that inquires an input source when the first information includes unclear or uncertain information.

### (Supplement 19)

The control system according to any one of supplements 1 to 18, wherein
the inquiry includes information indicating correction, addition, and cancellation of contents with respect to input/output data of the learning model.

### (Supplement 20)

The control system according to any one of supplements 1 to 19, wherein
the first information is time-series data indicating a situation or a demand in a work environment that is an environment in which the work is performed together with time information.

### (Supplement 21)

The control system according to any one of supplements 1 to 19, including:
a model information storage unit that stores information on a model as an execution environment of the learning model; and a model control unit that receives the model input data and outputs the model output data on the basis of the model input data and the information stored in the model information storage unit.

### (Supplement 22)

A control method for supporting work by a person or an object using a device, the control method including:
by an input interface, receiving an input of first information indicating a situation or a demand in a working environment that is an environment in which the work is performed;
by a model processing unit provided to be accessible to a predetermined learning model, inputting model input data based on the first information to the learning model, and receiving model output data corresponding to the model input data from the learning model, the model output data including information used for the work; and
by an output interface, outputting second information based on the model output data and configured to support the work, based on an output from the learning model.

### Industrial Applicability

The control system according to the present disclosure is suitably applicable as a part of a work support system that supports work by a person or an object. In addition, the control system according to the present disclosure can be suitably applied as a control system that controls a device in a case where some control or work is performed using the device. Here, the control system can also be suitably applied as a control system that controls an FA device, a control system in a home or a building, or a control system that controls an information processing device such as a server device that performs information processing on a network.

### Reference Signs List

1000, 1000a, 1000b, 1000c, 2000, 2000a, 2000b, 2000c, 2000d, 2000e, 3000, 3000a, 3000b, 3000c, 3000d, 3000e, 4000, 4000a, 5000, 5000a, 5000b, 5000c, 5000d control system; 100, 200, 300, 300a, 300b, 400, 400a, 400b, 500, 500a, 500b learning model unit; 10, 20 Information processing device; 11 model information storage unit; 12 reference information storage unit; 101 model control unit; 102 input unit; 103 output unit; 105 pre-processing unit; 106 post-processing unit; 107 model generation unit; 104, 104a control unit; 201 input processing unit; 202 output confirmation unit; 203 correction confirmation unit; 1 user; 1a input source; 2 target device; 2a output destination; 3 operation screen user interface; 4 controller; 31 input determination unit; 41-1, 41-2 analysis unit; 42 switching unit; 43 output changeover switch; 5 sensor; 6 model interface; 7 display; 8 operator; 110, 210, 310, 410 device information storage unit; 120 execution code generation unit; 130, 230, 330, 430, 530 state acquisition unit; 220 confirmation unit; 240 input processing unit; 250 proposal unit; 260, 260a learning model generation unit; 311 input interface; 312 output interface; 313 environment information storage unit; 511 database search unit; 512 control generation unit; 513v sound recognition unit; 513i image analysis unit; 514i image generation unit; 514v sound synthesis unit; 514p program generation unit; 515 correct/incorrect determination unit; 516 emotion determination unit; 517 evaluation acquisition unit; 518 registration determination unit; 519 additional learning unit; 520 control determination unit; 531 call confirmation unit; 532 output selection unit; 533 output switching unit; 2001 learning device; 2002 control device; D101, D21a model input data; D102, D201 model information; D103 model output data; D104 model reference information; D105, D200, D200a model learning data; D11, D21, D31, D41, D51, D51v, D51i input information; D12 control description; D22, D34 control command; D29 proposal information; D42a, D42b analysis result; D52, D52v, D52i, D52p, D52a, D52b, D52c response information; D32, D32a, D32b operation command; D320 operation information; D13, D23, D33, D43 device information; D33a environment information; D14 execution code; D44a, D44b result information; D15, D25, D35, D45 state information; D16, D26, D36, D46 feedback information; D17, D27, D37, D47, D57 inquiry; D18, D28, D38, D48 supplementary information; D59 evaluation information.

## Claims

1. A control system for supporting work using a device, the control system comprising:
a learning model unit to output second information that is information for operating the device, based on output data obtained by inputting input data based on first information indicating a demand regarding operation of the device to a learned learning model.

2. The control system according to claim 1, comprising:
a confirmation unit to perform confirmation processing for confirming an operation of the device corresponding to the first information.

3. The control system according to claim 2, comprising:
a proposal unit to present proposal information that is information for a user to determine necessity of correction of the first information on the basis of the confirmation processing.

4. The control system according to claim 3, wherein
the confirmation unit performs a simulation of an operation of the device using the second information, and
the proposal unit presents a result of the simulation.

5. The control system according to claim 4, wherein the proposal unit presents the result of the simulation by displaying the result of the simulation as augmented reality.

6. The control system according to any one of claims 2 to 5, wherein the confirmation unit outputs a reliability index corresponding to the first information or the second information.

7. The control system according to claim 6, wherein the confirmation unit outputs the reliability index by inputting the feature extracted from the input data based on the first information to an evaluation learning model generated by supervised machine learning using the feature extracted from the input data to the learning model and the reliability index of the operation of the device that is correct data corresponding to the input data.

8. The control system according to claim 6, wherein the confirmation unit outputs the reliability index by inputting the feature extracted from the second information corresponding to the first information to an evaluation learning model generated by supervised machine learning using the feature extracted from the second information based on the output data from the learning model and the reliability index of the operation of the device that is correct data corresponding to the second information.

9. The control system according to claim 6, wherein the confirmation unit outputs the reliability index on a basis of a clustering result obtained by inputting the feature extracted from the input data based on the first information to a learned learning device that clusters the feature extracted from the input data to the learning model.

10. The control system according to claim 6, wherein the confirmation unit outputs the reliability index based on a clustering result obtained by inputting the feature extracted from the output data based on the first information to a learned learning device that clusters the feature extracted from the second information based on the output data from the learning model.

11. The control system according to any one of claims 7 to 9, wherein the feature is extracted using an autoencoder.

12. The control system according to any one of claims 7 to 9, wherein the feature is extracted using a dimension reducing means.

13. The control system according to any one of claims 1 to 12, wherein the first information is information representing an operation or the work of the device in a natural language or an image.

14. The control system according to any one of claims 1 to 13, wherein the second information is a control command for controlling an operation of the device, and is information in a format interpretable by the device.

15. The control system according to any one of claims 1 to 14, wherein the learning model includes a first learning model that outputs an intermediate result using the first information as an input and a second learning model that outputs the second information using the intermediate result as an input.

16. The control system according to any one of claims 1 to 15, comprising: an input processing unit that inquires an input source when the first information includes unclear or uncertain information.

17. The control system according to any one of claims 1 to 16, wherein the learning model unit outputs the second information by using the output data and device information that is information regarding the device.

18. The control system according to claim 17, wherein the device information includes at least one of computer-aided design information of the device and computer-aided design information of an object to be worked.

19. The control system according to claim 17 or 18, wherein the device information includes at least one of a user's credential and a user's proficiency level.

20. The control system according to any one of claims 1 to 19, wherein the device includes an industrial device.

21. The control system according to claim 2, comprising:
a learning model generation unit to generate the learning model, wherein
the learning model generation unit performs relearning on a basis of model learning data generated by the confirmation unit by using the learning model.

22. A control method for supporting work using a device, the control method comprising:
by a learning model unit, outputting second information that is information for operating the device based on output data obtained by inputting input data based on first information indicating a demand regarding operation of the device to a learned learning model.
